(19) Europäisches Patentamt
European Patent Office
Office européen des brevets

(11) EP 4 694 637 A1

(12) **EUROPEAN PATENT APPLICATION**
published in accordance with Art. 153(4) EPC

(43) Date of publication:
**11.02.2026 Bulletin 2026/07**

(21) Application number: **24781089.8**

(22) Date of filing: **18.03.2024**

(51) International Patent Classification (IPC):
***H10K 50/17*** (2023.01) ***H10K 50/18*** (2023.01)
***H10K 50/81*** (2023.01) ***H10K 50/82*** (2023.01)
***H10K 50/16*** (2023.01) ***H10K 50/12*** (2023.01)
***H10K 50/115*** (2023.01) ***H10K 50/15*** (2023.01)
***H10K 50/844*** (2023.01) ***H10K 50/13*** (2023.01)

(52) Cooperative Patent Classification (CPC):
**H10K 50/171; H10K 50/19; H10K 59/80524;**
H10K 2102/351

(86) International application number:
**PCT/KR2024/003384**

(87) International publication number:
**WO 2024/205098 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.03.2023 KR 20230039181**
**11.08.2023 KR 20230105632**

(71) Applicant: **Samsung Display Co., Ltd.**
**Yongin-si, Gyeonggi-do 17113 (KR)**

(72) Inventors:
- **CHOI, Jung Ho**
**Yongin-si Gyeonggi-do 17113 (KR)**
- **KANG, Pil Gu**
**Yongin-si Gyeonggi-do 17113 (KR)**
- **KIM, Dae Hyeon**
**Yongin-si Gyeonggi-do 17113 (KR)**
- **KIM, Dong Chan**
**Yongin-si Gyeonggi-do 17113 (KR)**
- **MOON, Ji Young**
**Yongin-si Gyeonggi-do 17113 (KR)**
- **LEE, Hak Choong**
**Yongin-si Gyeonggi-do 17113 (KR)**
- **HWANG, Jae Hoon**
**Yongin-si Gyeonggi-do 17113 (KR)**

(74) Representative: **Dr. Weitzel & Partner**
**Patent- und Rechtsanwälte mbB**
**Friedenstrasse 10**
**89522 Heidenheim (DE)**

# (54) LIGHT-EMITTING ELEMENT, AND ELECTRONIC APPARATUS AND ELECTRONIC DEVICE EACH COMPRISING SAME

(57) Embodiments provide a light-emitting device, and an electronic apparatus and electronic equipment that each include the light-emitting device. The light-emitting device includes an anode, a cathode facing the anode, and an interlayer between the anode and the cathode, wherein the interlayer includes an emission layer and an electron transport region between the emission layer and the cathode. The electron transport region includes an electron injection layer adjacent to the cathode, the electron injection layer includes an alkali metal, and the cathode includes silver (Ag).

FIG. 1

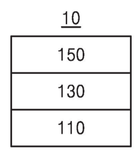


EP 4 694 637 A1

## Description

### Technical Field

The disclosure relates to a light-emitting device, and an electronic apparatus and electron equipment, each including the light-emitting device.

### Background Art

From among light-emitting devices, self-emissive devices have wide viewing angles, high contrast ratios, short response times, and excellent characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state to thereby generate light.

### Disclosure of Invention

### Technical Problem

Technical problem to be solved is to provide a light-emitting device that prevents pixel shrinkage and has improved luminous efficiency, and electronic apparatus and electronic equipment including the light-emitting device.

### Solution to Problem

According to embodiments, a light-emitting device may include:

an anode;
a cathode facing the anode; and
an interlayer between the anode and the cathode, wherein
the interlayer may include: an emission layer; and an electron transport region between the emission layer and the cathode,
the electron transport region may include an electron injection layer adjacent to the cathode,
the electron injection layer may include an alkali metal, and
the cathode may include silver (Ag).

An embodiment provides an electronic apparatus which includes the light-emitting device.

An embodiment provides electronic equipment which includes the light-emitting device.

### Advantageous Effects of Invention

According to an embodiment, a light-emitting device having an electron injection layer including an alkali metal and a cathode including Ag to prevent or reduce a pixel shrinkage phenomenon due to Ag agglomeration and to reduce light absorption in the electron injection layer and the cathode, and thus may have improved luminescence efficiency.

### Brief Description of Drawings

FIGS. 1 to 3 are each a schematic cross-sectional view of a light-emitting device according to an embodiment.
FIGS. 4 and 5 are each a schematic cross-sectional view of an electronic apparatus according to an embodiment.
FIGS. 6 and 7 are each a schematic perspective view of an electronic equipment according to an embodiment.
FIGS. 8A, 8B, and 8C are each a schematic diagram of the interior of a vehicle, according to an embodiment.
FIG. 9 is a graph of light absorption ratio (%) of thin-films according to Examples 1 to 5.
FIG. 10 is a graph of luminance (%) of light-emitting devices over time in Comparative Example 1 and Examples 12 to 14 as relative values to Comparative Example 1.

FIG. 11 is a graph of luminance (%) of light-emitting devices over time in Comparative Example 2 and Examples 15 to 17 as relative values to Comparative Example 2.

FIGS. 12 and 13 are each a photo of pixels (1 cm x 1 cm), immediately after operation (0 HR) and after 200 hours of operation (200 HR), of light-emitting devices in Example 13 and Comparative Example 1, respectively.

## Best Mode for Carrying out the Invention

Hereinafter, embodiments will be described in detail with reference to the accompanying drawings. In the following drawings, the same reference numerals denote the same components, and redundant descriptions thereof will be omitted. The sizes of the elements in the drawings may be exaggerated for clarity and convenience of explanation. Meanwhile, the embodiments described below are merely examples and various changes in form and details may be made therein based on the embodiments.

Hereinafter, the terms "on" or "on the top of" may refer not only to elements that are directly above, below, to the left, or to the right in contact, but also to those that are positioned above, below, to the left, or to the right without direct contact. An expression used in the singular encompasses the expression of the plural, unless it has a clearly different meaning in the context. Throughout the specification, when a portion "includes" an element, another element may be further included, rather than excluding the existence of the other element, unless otherwise described.

The use of the terms "a" and "an" and "the" and similar referents in the context of describing embodiments (especially in the context of the following claims) are to be construed to cover both the singular and the plural.

The use of any and all examples, or exemplary language provided herein, is intended merely to better illuminate embodiments and does not pose a limitation on the scope of embodiments unless otherwise claimed.

In the specification, the term "interlayer" may refer to a single layer and/or all layers between a first electrode and a second electrode of a light-emitting device. For example, the first electrode may be an anode, and the second electrode may be a cathode.

According to embodiments, a light-emitting device may include:

an anode;
a cathode facing the anode; and
an interlayer between the anode and the cathode, wherein
the interlayer may include: an emission layer; and an electron transport region between the emission layer and the cathode, and
the electron transport region may include an electron injection layer adjacent to the cathode.

In an embodiment, the electron injection layer may include an alkali metal, and
the cathode may include silver (Ag).

A light absorption ratio of the alkali metal in the electron injection layer may be smaller than a light absorption ratio of Yb used in an electron injection layer of the related art, and the luminous efficiency of the light-emitting device may be improved by reducing the absorption of light emitted from the emission layer by the electron injection layer. In an embodiment, a light absorption ratio of the electron injection layer including the alkali metal may be in a range of about 8 % to about 10 % in a blue region, may be in a range of about 10 % to about 12 % in a green region, and may be in a range of about 12 % to about 14 % in a red region.

When external air containing moisture or oxygen penetrates into the light-emitting device, Ag in the cathode may react with the external air, resulting in agglomeration of Ag. The cathode may not perform its role properly, and thus the brightness may decrease. Because external air mainly penetrates from the outside of a pixel, a pixel shrinkage phenomenon in which brightness decreases from the outside of the emission region may occur. The external air may be, for example, an outgas coming from an organic layer of a thin-film transistor substrate within an electronic apparatus.

The alkali metal in the electron injection layer has a lower work function and stronger reactivity than those of Ag in the cathode and thus reacts with moisture or oxygen penetrated from the outside before Ag in the cathode, thereby reducing or preventing agglomeration of Ag. As deterioration of the electron injection layer that has reacted with moisture or oxygen is not as severe as deterioration of the cathode caused by agglomeration of Ag, a portion of the electron injection layer, which is not deteriorated, has a thickness sufficient to perform the electron injection role. Therefore, pixel shrinkage caused by cathode deterioration may be reduced or prevented by using an alkali metal as a material for the electron injection layer.

In an embodiment, a thickness of the electron injection layer may be in a range of about 5 Å to about 20 Å. For example, a thickness of the electron injection layer may be in a range of about 7 Å to about 15 Å. For example, a thickness of the electron injection layer may be in a range of about 10 Å to about 15 Å. In an embodiment, the alkali metal may be lithium (Li). For example, the electron injection layer may consist of Li.

In an embodiment, a light absorption ratio of Ag in the cathode may be smaller than a light absorption ratio of

AgMg used in cathodes of the related art, and compared to AgMg, the absorption of light emitted from the emission layer by the cathode is reduced, which may improve the luminous efficiency of the light-emitting device. In the related art, AgMg has been applied to cathodes to prevent deterioration of the cathodes caused by agglomeration of Ag, but light loss has occurred in cathodes due to a large light absorption ratio of Mg. In an embodiment, an alkali metal may be applied to the electron injection layer to prevent deterioration of Ag without including Mg in the cathode, thereby reducing the light absorption ratio of the cathode and improving luminous efficiency.

In an embodiment, a light absorption ratio of the cathode including Ag may be in a range of about 7 % to about 8 % in a blue region, may be in a range of about 8 % to about 9 % in a green region, and may be in a range of about 9 % to about 11 % in a red region. In an embodiment, a thickness of the cathode may be in a range of about 80 Å to about 150 Å. For example, a thickness of the cathode may be in a range of about 100 Å to about 130 Å.

In an embodiment, a sheet resistance of a structure of the electron injection layer including the alkali metal and the cathode including Ag may be in a range of about 10 $\Omega/cm^2$ to about 13 $\Omega/cm^2$.

In an embodiment, the electron injection layer may further include an electron transport compound, in addition to the alkali metal. For example, the electron transport compound may be a phenanthroline-based compound. For example, the phenanthroline-based compound may be bathocuproine (BCP). In an embodiment, when the electron injection layer includes the electron transport compound and the alkali metal, an amount of the alkali metal may be in a range of about 1 wt% to about 10 wt%, based on a total weight of the electron injection layer. For example, an amount of the alkali metal may be in a range of about 2 wt% to about 5 wt%, based on a total weight of the electron injection layer. In an embodiment, the alkali metal may be Li. In an embodiment, when the electron injection layer includes the electron transport compound and the alkali metal, the cathode may further include the alkali metal, in addition to Ag. When the cathode further includes the alkali metal, an amount of the alkali metal in the cathode may be in a range of about 1 wt% to about 10 wt%, based on a total weight of the cathode. For example, an amount of the alkali metal in the cathode may be in a range of about 2 wt% to about 5 wt%, based on a total weight of the cathode. In an embodiment, when the electron injection layer includes a phenanthroline-based compound and Li, the cathode may include AgLi. When the cathode includes AgLi, an amount of Li in the electron injection layer and an amount of Li in the cathode may be respectively within the above-described range.

[Description of FIG. 1]

FIG. 1 is a schematic cross-sectional view of a light-emitting device 10 according to an embodiment. The light-emitting device 10 includes a first electrode 110, an interlayer 130, and a second electrode 150. In an embodiment, the first electrode 110 may be an anode, and the second electrode 150 may be a cathode.

Hereinafter, a structure of the light-emitting device 10 according to an embodiment and a method of manufacturing the light-emitting device 10 are described with reference to FIG. 1.

[First electrode 110]

In FIG. 1, a substrate may be further included under the first electrode 110 or above the second electrode 150. The substrate may be a glass substrate or a plastic substrate. In an embodiment, the substrate may be a flexible substrate and may include plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates the injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or any combination thereof. In an embodiment, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a structure consisting of a single layer or a structure including multiple layers. For example, the first electrode 110 may have a three-layer structure of ITO/Ag/ITO.

[Interlayer 130]

The interlayer 130 is arranged on the first electrode 110. The interlayer 130 may include the emission layer.

The interlayer 130 may further include a hole transport region arranged between the first electrode 110 and the emission layer, and an electron transport region arranged between the emission layer and the second electrode 150.

The interlayer 130 may further include, in addition to various organic materials, a metal-containing compound

such as an organometallic compound, an inorganic material such as quantum dots, or the like.

In an embodiment, the interlayer 130 may include two or more emitting units stacked between the first electrode 110 and the second electrode 150 and one or more charge generation layers, each between adjacent ones among the two or more emitting units. When the interlayer 130 includes the two or more emitting units and the at least one charge generation layers as described above, the light-emitting device 10 may be a tandem light-emitting device.

[Hole transport region in interlayer 130]

The hole transport region may have: a structure consisting of a layer consisting of a single material, a structure consisting of a single layer including different materials, or a structure including multiple layers including different materials.

The hole transport region may include a hole injection layer, a hole transport layer, an emission auxiliary layer, an electron blocking layer, or any combination thereof.

In an embodiment, the hole transport region may have a multilayer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein the layers of each structure may be stacked from the first electrode 110 in its respective stated order, but the structure of the hole transport region is not limited thereto.

The hole transport region may include a compound represented by Formula 201, a compound represented by Formula 202, or any combination thereof:

[Formula 201]

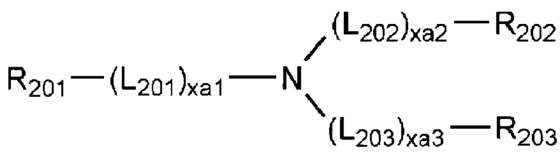

[Formula 202]

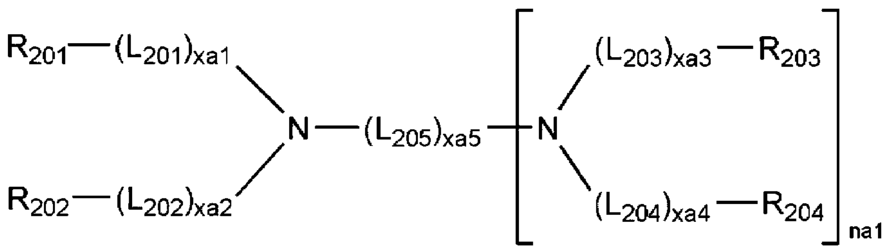

In Formulae 201 and 202,

$L_{201}$ to $L_{204}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$L_{205}$ may be *-O-*', *-S-*', *-N($Q_{201}$)-*', a $C_1$-$C_{20}$ alkylene group that is unsubstituted or substituted with at least one $R_{10a}$, a $C_2$-$C_{20}$ alkenylene group that is unsubstituted or substituted with at least one $R_{10a}$, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$,

xa1 to xa4 may each independently be an integer from 0 to 5,

xa5 may be an integer from 1 to 10,

$R_{201}$ to $R_{204}$ and $Q_{201}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$R_{201}$ and $R_{202}$ may optionally be linked to each other via a single bond, a $C_1$-$C_5$ alkylene group that is unsubstituted or substituted with at least one $R_{10a}$, or a $C_2$-$C_5$ alkenylene group that is unsubstituted or substituted with at least one $R_{10a}$ to form a $C_8$-$C_{60}$ polycyclic group (e.g., a carbazole group or the like) unsubstituted or substituted with at least one $R_{10a}$ (e.g., see Compound HT16),

$R_{203}$ and $R_{204}$ may optionally be linked to each other via a single bond, a $C_1$-$C_5$ alkylene group that is unsubstituted or substituted with at least one $R_{10a}$, or a $C_2$-$C_5$ alkenylene group that is unsubstituted or substituted with at least one

$R_{10a}$ to form a $C_8$-$C_{60}$ polycyclic group that is unsubstituted or substituted with at least one $R_{10a}$, and na1 may be an integer from 1 to 4.

In an embodiment, the compound represented by Formula 201 and the compound represented by Formula 202 may each independently include at least one of groups represented by Formulae CY201 to CY217:

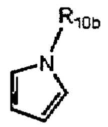
CY201
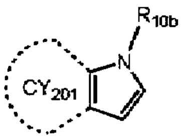
CY202
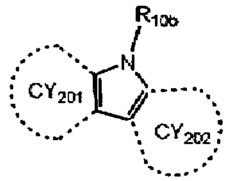
CY203
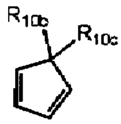
CY204
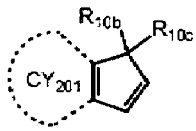
CY205
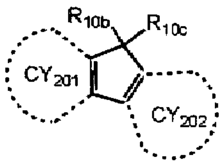
CY206

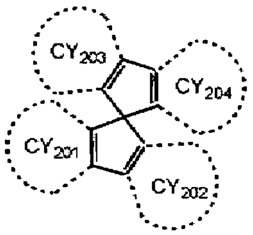
CY207
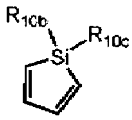
CY208
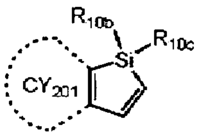
CY209
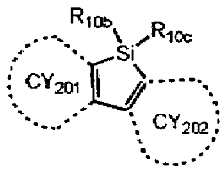
CY210
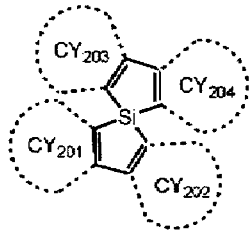
CY211

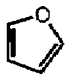
CY212
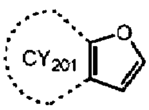
CY213
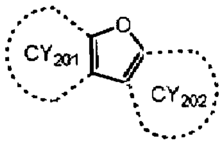
CY214
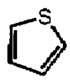
CY215
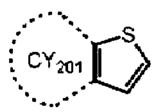
CY216
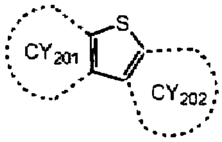
CY217

In Formulae CY201 to CY217, $R_{10b}$, and $R_{10c}$ may each independently be the same as described in connection with $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$.

In an embodiment, ring $CY_{201}$ to ring $CY_{204}$ in Formulae CY201 to CY217 may each independently be a benzene group, a naphthalene group, a phenanthrene group, or an anthracene group.

In an embodiment, the compound represented by Formula 201 and the compound represented by Formula 202 may each independently include at least one of groups represented by Formulae CY201 to CY203.

In an embodiment, the compound represented by Formula 201 may include at least one of groups represented by Formulae CY201 to CY203 and at least one of groups represented by Formulae CY204 to CY217.

In an embodiment, in Formula 201, xa1 may be 1, $R_{201}$ may be a group represented by one of Formulae CY201 to CY203, xa2 may be 0, and $R_{202}$ may be a group represented by one of Formulae CY204 to CY207.

In an embodiment, the compound represented by Formula 201 and the compound represented by Formula 202 may each not include groups represented by Formulae CY201 to CY203.

In an embodiment, the compound represented by Formula 201 and the compound represented by Formula 202 may each not include groups represented by Formulae CY201 to CY203 and may each independently include at least one of groups represented by Formulae CY204 to CY217.

In an embodiment, the compound represented by Formula 201 and the compound represented by Formula 202 may each not include groups represented by Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl) triphenylamine (TCTA), polyaniline/dodecylbenzenesulfonic acid (PANI/DBSA), poly(3,4-ethylenedioxythiophene)/-poly(4-styrenesulfonate) (PEDOT/PSS), polyaniline/camphor sulfonic acid (PANI/CSA), polyaniline/poly(4-styrenesulfonate) (PANI/PSS), or any combination thereof:

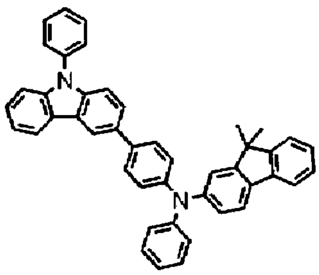

HT1

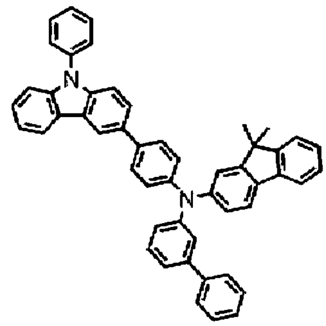

HT2

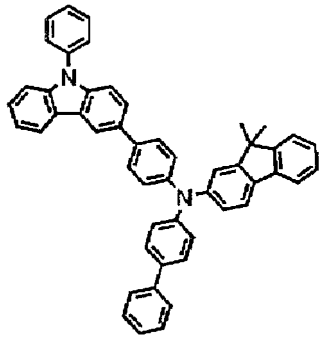

HT3

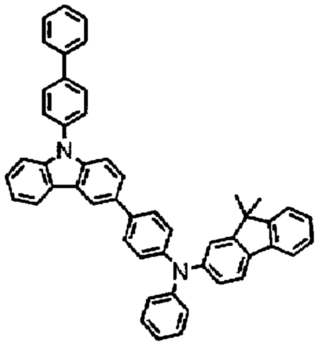

HT4

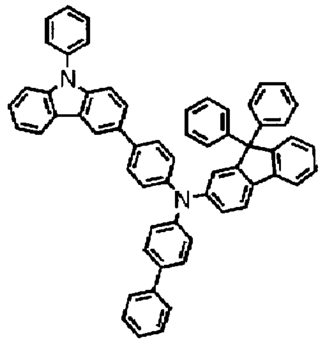

HT5

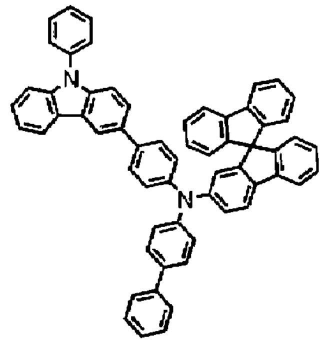

HT6

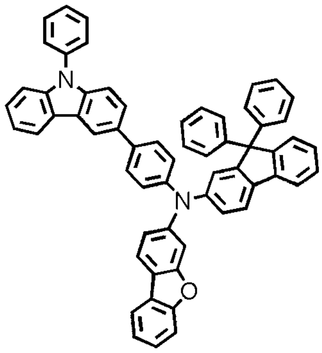

HT7

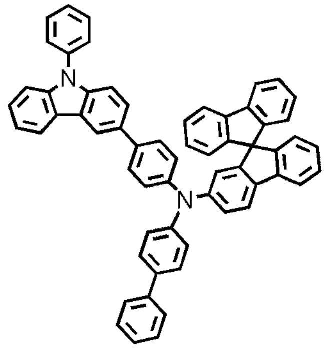

HT8

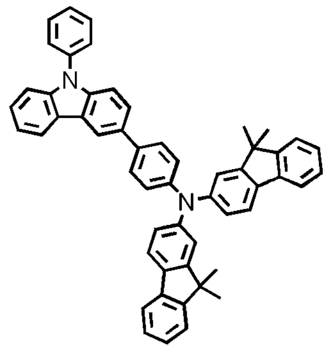

HT9

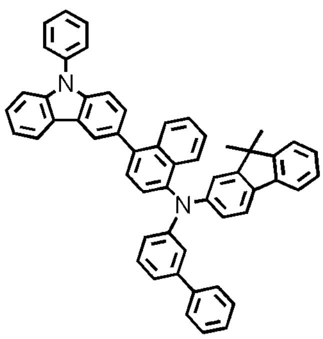

HT10

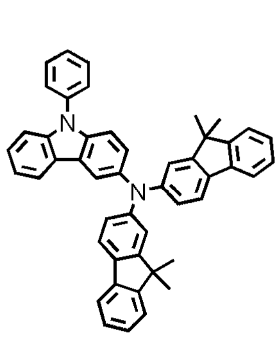

HT11

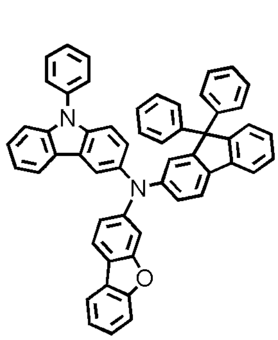

HT12

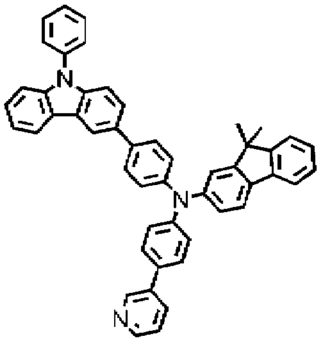

HT13

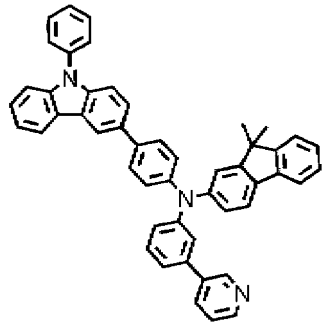

HT14

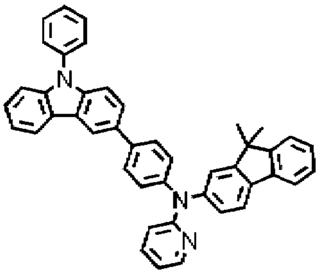

HT15

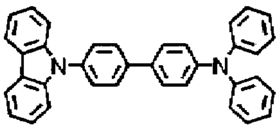

HT16

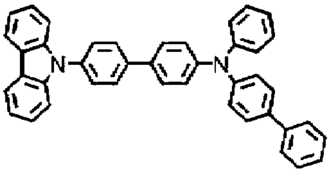

HT17

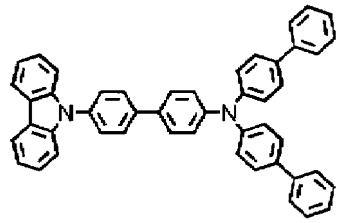

HT18

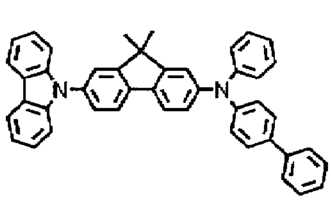

HT19

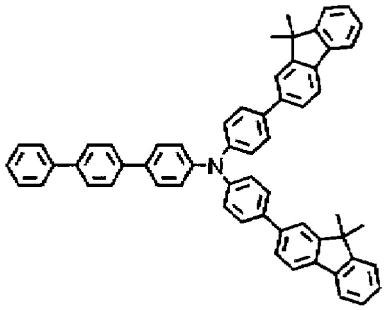

HT20

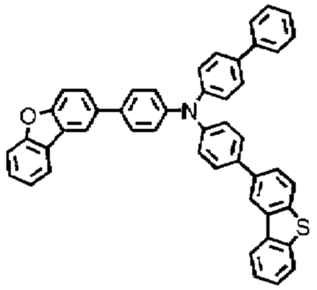

HT21

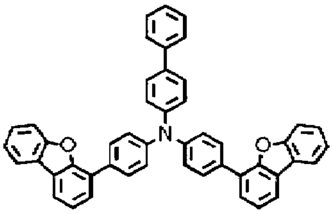

HT22

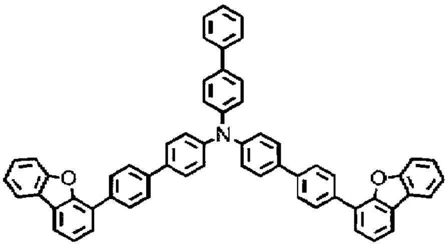

HT23

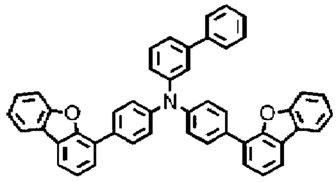

HT24

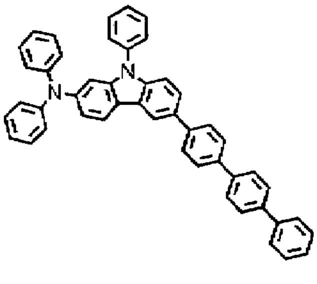

HT25

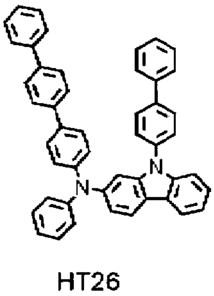

HT26

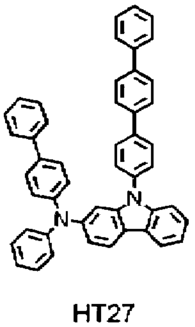

HT27

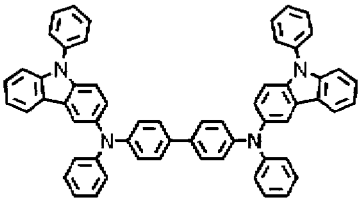

HT28

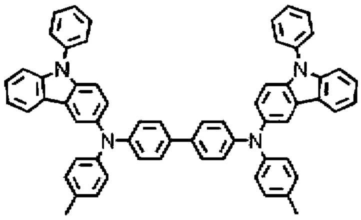

HT29

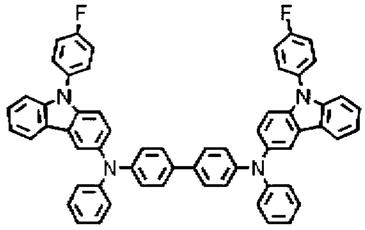

HT30

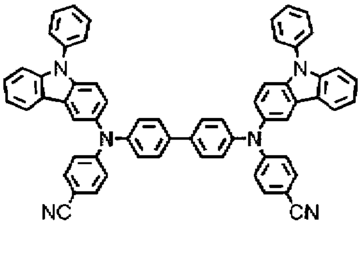

HT31

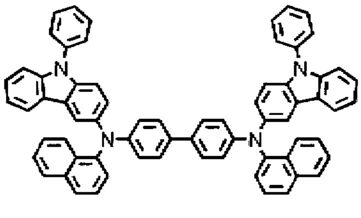

HT32

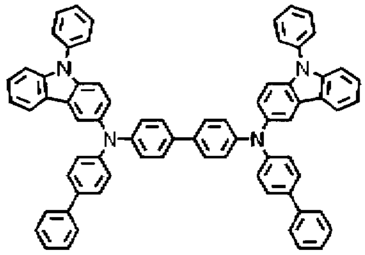

HT33

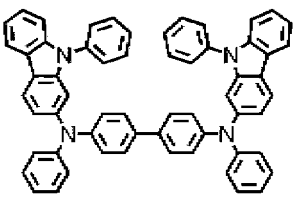

HT34

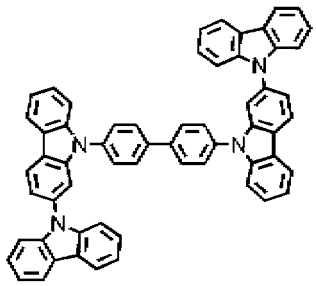

HT35

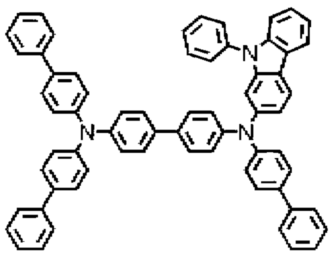

HT36

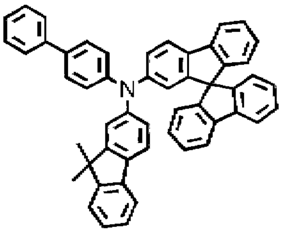

HT40

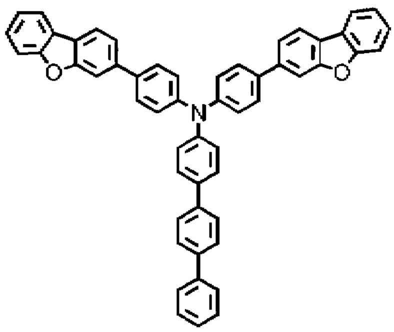

HT41

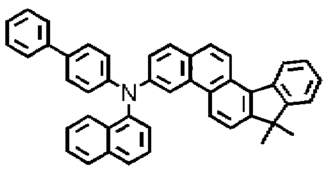

HT42

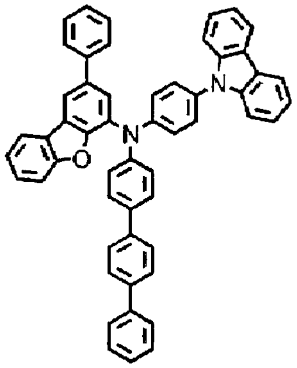

HT43

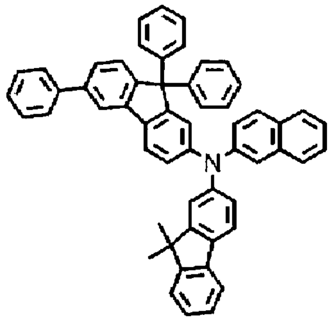

HT44

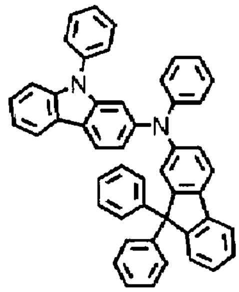

HT45

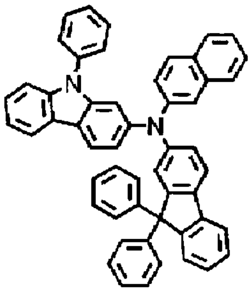

HT46

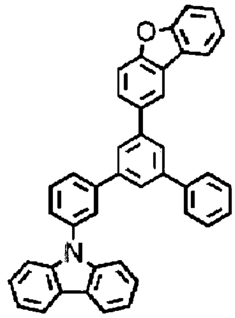

HT47

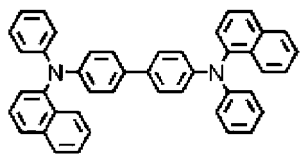

NPB

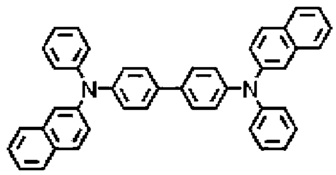

β-NPB

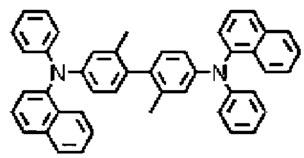

methylated-NPB

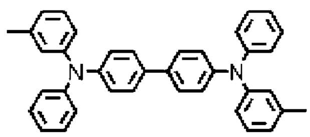

TPD

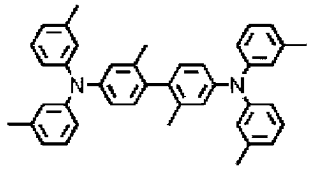

HMTPD

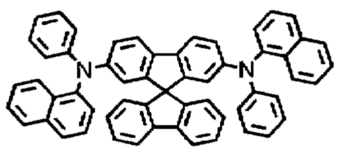

spiro-NPB

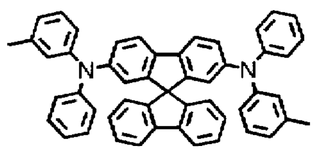

spiro-TPD

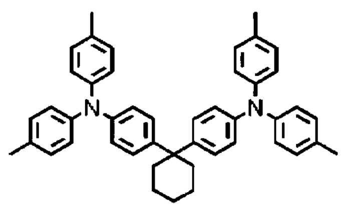

TAPC

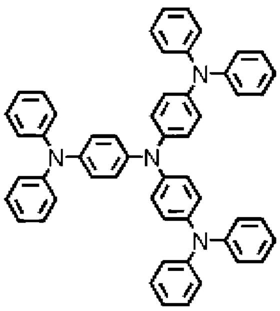

TDATA

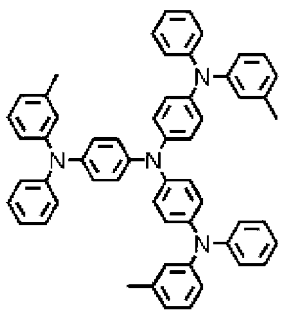

m-TDATA

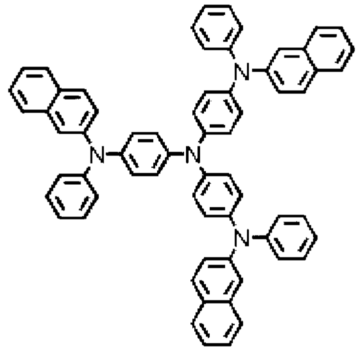

2-TNATA

A thickness of the hole transport region may be in a range of about 50 Å to about 10,000 Å. For example, a thickness of the hole transport region may be in a range of about 100 Å to about 4,000 Å. When the hole transport region includes a hole injection layer, a hole transport layer, or any combination thereof, a thickness of the hole injection layer may be in a range of about 100 Å to about 9,000 Å, and a thickness of the hole transport layer may be in a range of about 50 Å to about 2,000 Å. For example, a thickness of the hole injection layer may be in a range of about 100 Å to about 1,000 Å. For example, a thickness of the hole transport layer may be in a range of about 100 Å to about 1,500 Å. When the thicknesses of the hole transport region, the hole injection layer, and the hole transport layer are within the ranges described above, satisfactory hole transporting characteristics may be obtained without a substantial increase in driving voltage.

The emission auxiliary layer may increase light-emission efficiency by compensating for an optical resonance distance according to a wavelength of light emitted by the emission layer, and the electron blocking layer may block the leakage of electrons from an emission layer to a hole transport region. Materials that may be included in the hole transport region may be included in the emission auxiliary layer and the electron blocking layer.

[p-dopant]

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

In an embodiment, a lowest unoccupied molecular orbital (LUMO) energy of the p-dopant may be less than or equal to about -3.5 eV.

In an embodiment, the p-dopant may include a quinone derivative, a cyano group-containing compound, a compound including an element EL1 and an element EL2, or any combination thereof.

Examples of a quinone derivative may include TCNQ and F4-TCNQ.

Examples of a cyano group-containing compound may include HAT-CN and a compound represented by Formula 221:

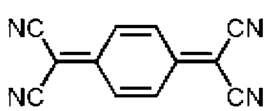

TCNQ

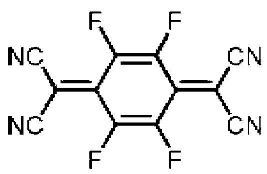

F4-TCNQ

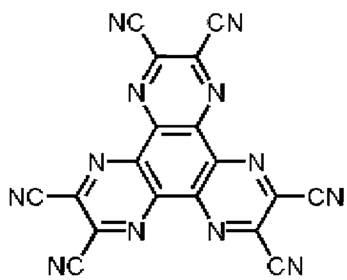

HAT-CN

[Formula 221]

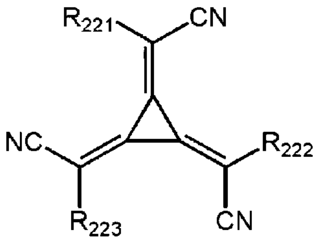

In Formula 221,

$R_{221}$ to $R_{223}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, and

at least one of $R_{221}$ to $R_{223}$ may each independently be a $C_3$-$C_{60}$ carbocyclic group or a $C_1$-$C_{60}$ heterocyclic group, each substituted with: a cyano group; -F; -Cl; -Br; -I; a $C_1$-$C_{20}$ alkyl group substituted with a cyano group, -F, -Cl, -Br, -I, or any combination thereof; or any combination thereof.

In the compound including the element EL1 and the element EL2, the element EL1 may be a metal, a metalloid, or a combination thereof, and the element EL2 may be a non-metal, a metalloid, or a combination thereof.

Examples of a metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of a metalloid may include silicon (Si), antimony (Sb), and tellurium (Te).

Examples of a non-metal may include oxygen (O) and a halogen (for example, F, Cl, Br, I, etc.).

Examples of a compound including the element EL1 and the element EL2 may include a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, or any combination thereof.

Examples of a metal oxide may include a tungsten oxide (for example, WO, $W_2O_3$, $WO_2$, $WO_3$, $W_2O_5$, etc.), a vanadium oxide (for example, VO, $V_2O_3$, $VO_2$, $V_2O_5$, etc.), a molybdenum oxide (MoO, $Mo_2O_3$, $MoO_2$, $MoO_3$, $Mo_2O_5$, etc.), and a rhenium oxide (for example, $ReO_3$, etc.).

Examples of a metal halide may include an alkali metal halide, an alkaline earth metal halide, a transition metal halide, a post-transition metal halide, and a lanthanide metal halide.

Examples of an alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of an alkaline earth metal halide may include $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, and $BaI_2$.

Examples of a transition metal halide may include a titanium halide (for example, $TiF_4$, $TiCl_4$, $TiBr_4$, $TiI_4$, etc.), a zirconium halide (for example, $ZrF_4$, $ZrCl_4$, $ZrBr_4$, $ZrI_4$, etc.), a hafnium halide (for example, $HfF_4$, $HfCl_4$, $HfBr_4$, $HfI_4$, etc.), a vanadium halide (for example, $VF_3$, $VCl_3$, $VBr_3$, $VI_3$, etc.), a niobium halide (for example, $NbF_3$, $NbCl_3$, $NbBr_3$, $NbI_3$, etc.), a tantalum halide (for example, $TaF_3$, $TaCl_3$, $TaBr_3$, $TaI_3$, etc.), a chromium halide (for example, $CrF_3$, $CrCl_3$, $CrBr_3$, $CrI_3$, etc.), a molybdenum halide (for example, $MoF_3$, $MoCl_3$, $MoBr_3$, $MoI_3$, etc.), a tungsten halide (for example, $WF_3$, $WCl_3$, $WBr_3$, $WI_3$, etc.), a manganese halide (for example, $MnF_2$, $MnCl_2$, $MnBr_2$, $MnI_2$, etc.), a technetium halide (for example, $TcF_2$, $TcCl_2$, $TcBr_2$, $TcI_2$, etc.), a rhenium halide (for example, $ReF_2$, $ReCl_2$, $ReBr_2$, $ReI_2$, etc.), an iron halide (for example, $FeF_2$, $FeCl_2$, $FeBr_2$, $FeI_2$, etc.), a ruthenium halide (for example, $RuF_2$, $RuCl_2$, $RuBr_2$, $RuI_2$, etc.), an osmium halide (for example, $OsF_2$, $OsCl_2$, $OsBr_2$, $OsI_2$, etc.), a cobalt halide (for example, $CoF_2$, $CoCl_2$, $CoBr_2$, $CoI_2$, etc.), a rhodium halide (for example, $RhF_2$, $RhCl_2$, $RhBr_2$, $RhI_2$, etc.), an iridium halide (for example, $IrF_2$, $IrCl_2$, $IrBr_2$, $IrI_2$, etc.), a nickel halide (for example, $NiF_2$, $NiCl_2$, $NiBr_2$, $NiI_2$, etc.), a palladium halide (for example, $PdF_2$, $PdCl_2$, $PdBr_2$, $PdI_2$, etc.), a platinum halide (for example, $PtF_2$, $PtCl_2$, $PtBr_2$, $PtI_2$, etc.), a copper halide (for example, CuF, CuCl, CuBr, CuI, etc.), a silver halide (for example, AgF, AgCl, AgBr, AgI, etc.), and a gold halide (for example, AuF, AuCl, AuBr, AuI, etc.).

Examples of a post-transition metal halide may include a zinc halide (for example, $ZnF_2$, $ZnCl_2$, $ZnBr_2$, $ZnI_2$, etc.), an indium halide (for example, $InI_3$, etc.), and a tin halide (for example, $SnI_2$, etc.).

Examples of a lanthanide metal halide may include YbF, $YbF_2$, $YbF_3$, $SmF_3$, YbCl, $YbCl_2$, $YbCl_3$ $SmCl_3$, YbBr, $YbBr_2$, $YbBr_3$, $SmBr_3$, YbI, $YbI_2$, $YbI_3$, and $SmI_3$.

Examples of a metalloid halide may include an antimony halide (for example, $SbCl_5$, etc.).

Examples of a metal telluride may include an alkali metal telluride (for example, $Li_2Te$, $Na_2Te$, $K_2Te$, $Rb_2Te$, $Cs_2Te$, etc.), an alkaline earth metal telluride (for example, BeTe, MgTe, CaTe, SrTe, BaTe, etc.), a transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

[Emission layer in interlayer 130]

When the light-emitting device 10 is a full-color light-emitting device, the emission layer may be patterned into a red emission layer, a green emission layer, and/or a blue emission layer, according to a subpixel. In an embodiment, the emission layer may have a stacked structure of two or more layers of a red emission layer, a green emission layer, and a blue emission layer, in which the two or more layers may contact each other or may be separated from each other, to emit white light. In an embodiment, the emission layer may include two or more materials of a red light-emitting material, a green light-emitting material, and a blue light-emitting material, in which the two or more materials may be mixed with each other in a single layer, to emit white light.

In an embodiment, the emission layer may include a host and a dopant (or an emitter). In an embodiment, the emission layer may further include an auxiliary dopant that promotes energy transfer to a dopant (or to an emitter), in addition to the host and the dopant (or emitter). When the emission layer includes a dopant (or emitter) and the auxiliary dopant, the dopant (or emitter) and the auxiliary dopant may be different from each other.

An amount (weight) of the dopant (or emitter) in the emission layer may be in a range of about 0.01 parts by weight to about 15 parts by weight, based on 100 parts by weight of the host.

In an embodiment, the emission layer may include a quantum dot.

In embodiments, the emission layer may include a delayed fluorescence material. The delayed fluorescence material may serve as a host or as a dopant in the emission layer.

A thickness of the emission layer may be in a range of about 100 Å to about 1,000 Å. For example, a thickness of the emission layer may be in a range of about 200 Å to about 600 Å. When the thickness of the emission layer is within any of the ranges described above, excellent luminescence characteristics may be obtained without a substantial increase in driving voltage.

[Host]

In an embodiment, the host may include a compound represented by Formula 301:

[Formula 301] $[Ar_{301}]_{xb11}\text{-}[(L_{301})_{xb1}\text{-}R_{301}]_{xb21}$

In Formula 301,

$Ar_{301}$ and $L_{301}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$,-$Si(Q_{301})(Q_{302})(Q_{303})$, -$N(Q_{301})(Q_{302})$, -$B(Q_{301})(Q_{302})$, -$C(=O)(Q_{301})$, -$S(=O)_2(Q_{301})$, or -$P(=O)(Q_{301})(Q_{302})$,
xb21 may be an integer from 1 to 5, and
$Q_{301}$ to $Q_{303}$ may each independently be the same as described in connection with $Q_1$ herein.

In an embodiment, in Formula 301, when xb11 is 2 or more, two or more of $Ar_{301}$ may be linked together via a single bond.

In an embodiment, the host may include a compound represented by Formula 301-1, a compound represented

by Formula 301-2, or any combination thereof:

[Formula 301-1]

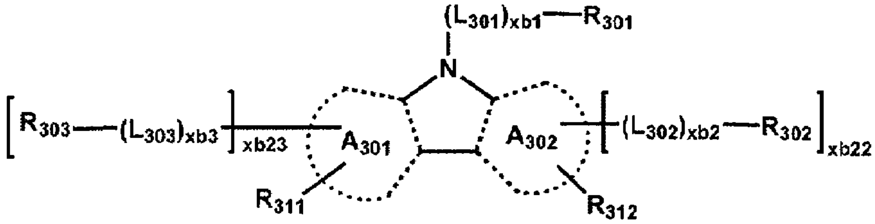

[Formula 301-2]

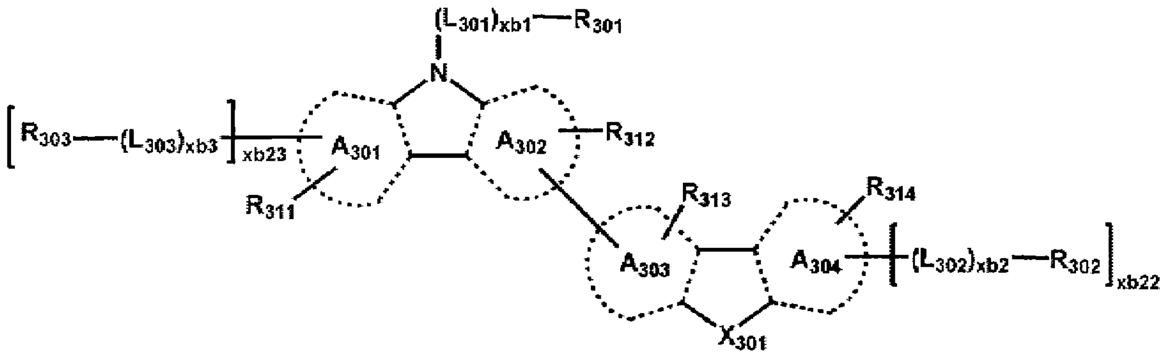

In Formulae 301-1 and 301-2,

ring $A_{301}$ to ring $A_{304}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
$X_{301}$ may be O, S, N-[$(L_{304})_{xb4}$-$R_{304}$], C($R_{304}$)($R_{305}$), or Si($R_{304}$)($R_{305}$),
xb22 and xb23 may each independently be 0, 1, or 2,
$L_{301}$, xb1, and $R_{301}$ may each be the same as described herein,
$L_{302}$ to $L_{304}$ may each independently be the same as described in connection with $L_{301}$,
xb2 to xb4 may each independently be the same as described in connection with xb1, and
$R_{302}$ to $R_{305}$ and $R_{311}$ to $R_{314}$ may each independently be the same as described in connection with $R_{301}$.

In an embodiment, the host may include an alkali earth metal complex, a post-transition metal complex, or any combination thereof. In an embodiment, the host may include a Be complex (for example, Compound H55), an Mg complex, a Zn complex, or any combination thereof.

In an embodiment, the host may include one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

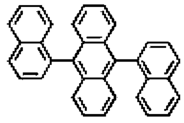

H1

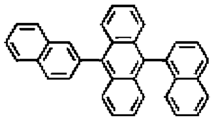

H2

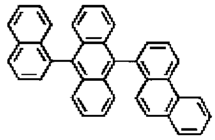

H3

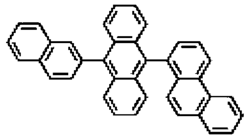

H4

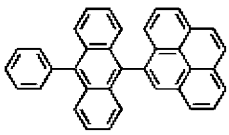
H5

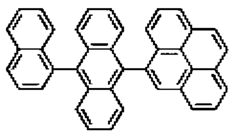
H6

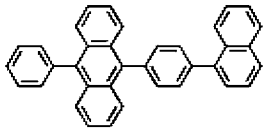
H7

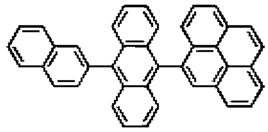
H8

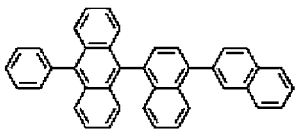
H9

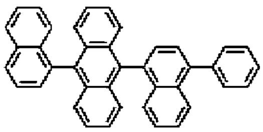
H10

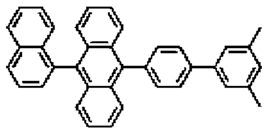
H11

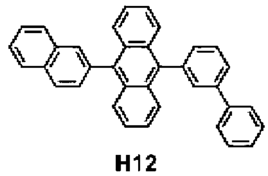
H12

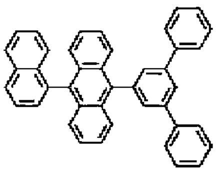
H13

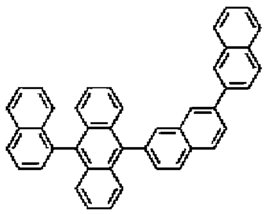
H14

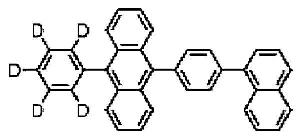
H15

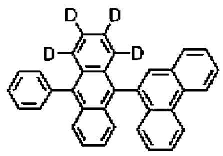
H16

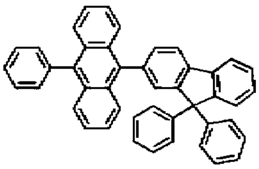
H17

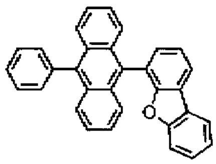
H18

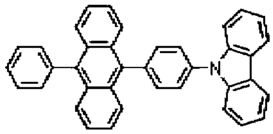
H19

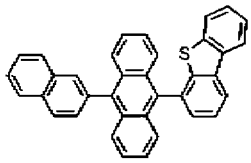
H20

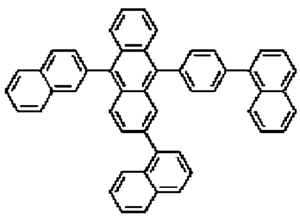
H21

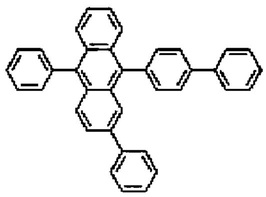
H22

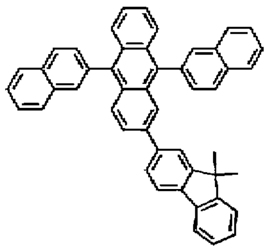
H23

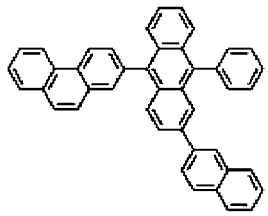
H24

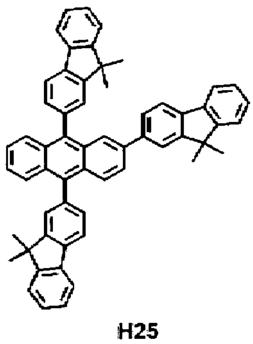
H25

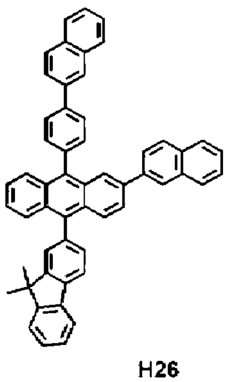
H26

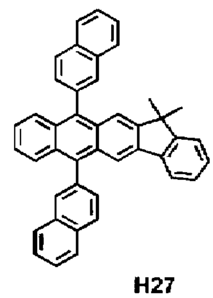
H27

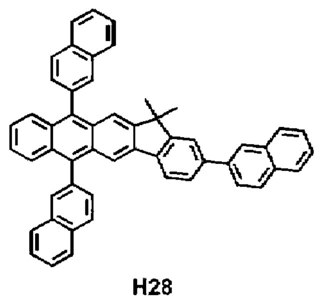
H28

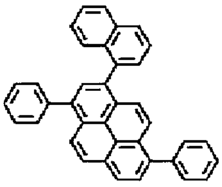

H29

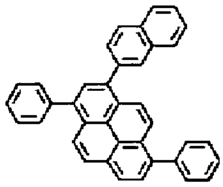

H30

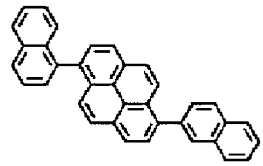

H31

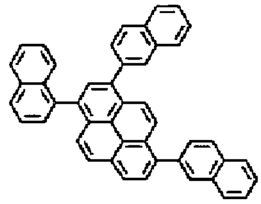

H32

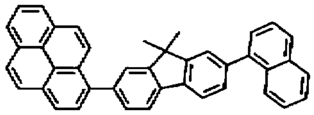

H33

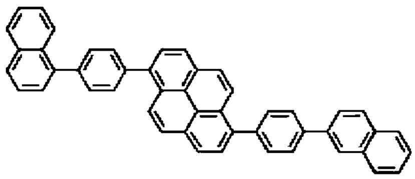

H34

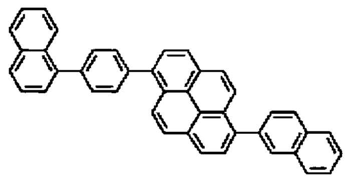

H35

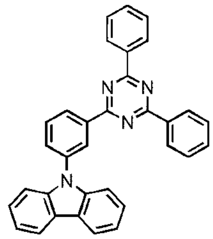

H36

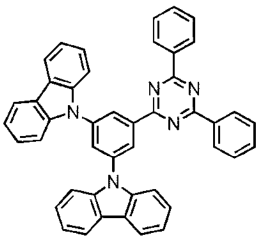

H37

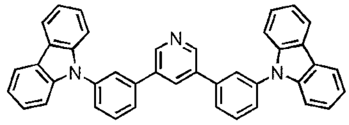

H38

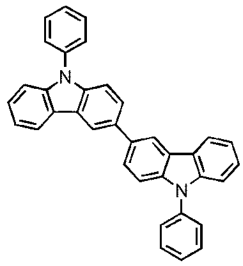

H39

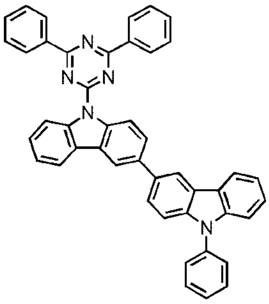

H40

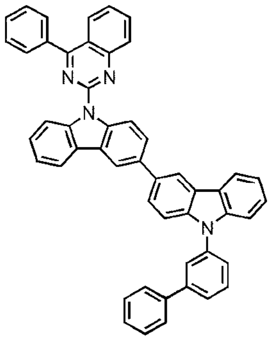

H41

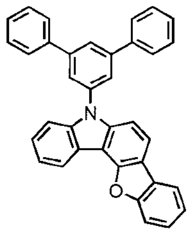

H42

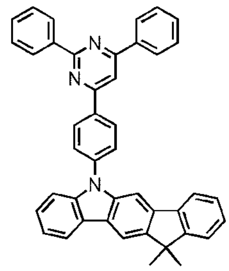

H43

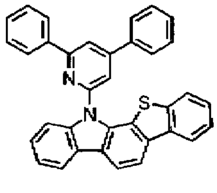

H44

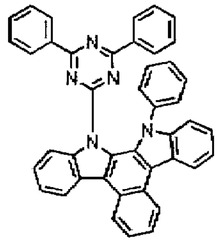

H45

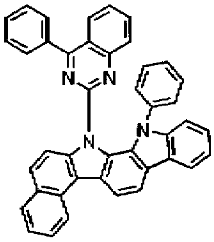

H46

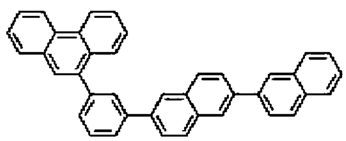

H47

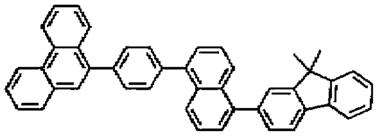
H48

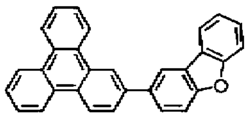
H49

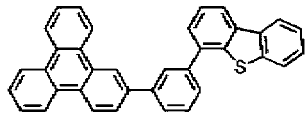
H50

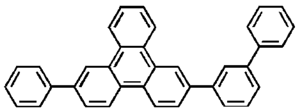
H51

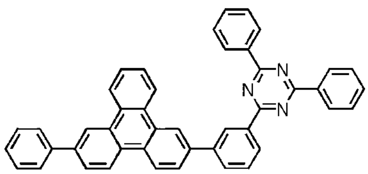
H52

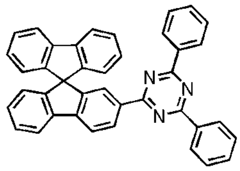
H53

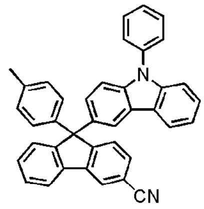
H54

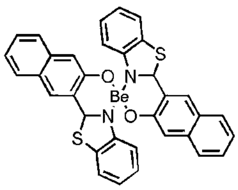
H55

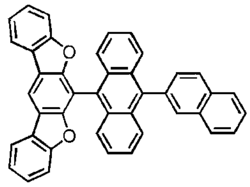
H56

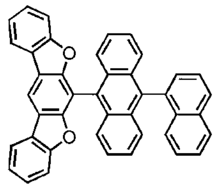
H57

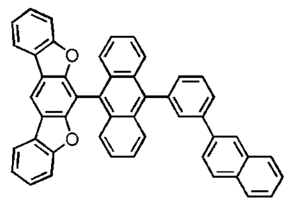
H58

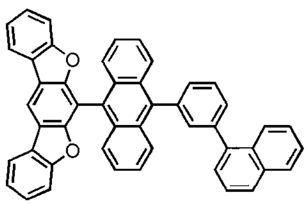
H59

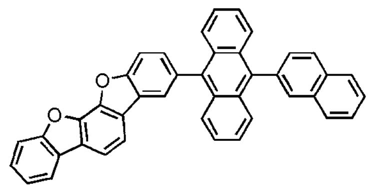
H60

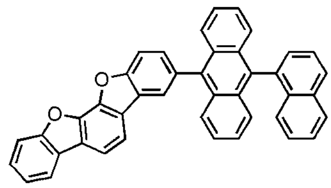
H61

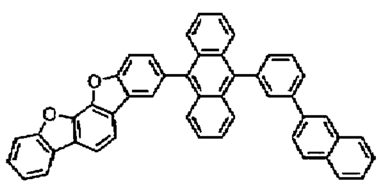
H62

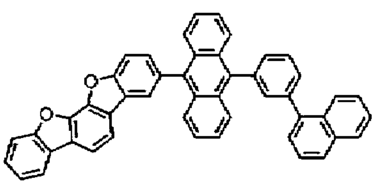
H63

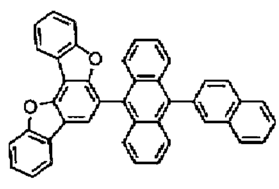
H64

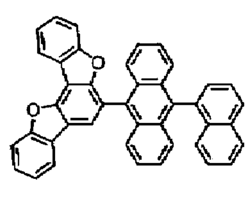
H65

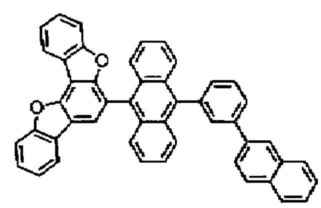
H66

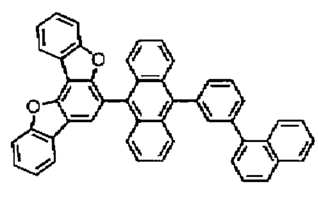
H67

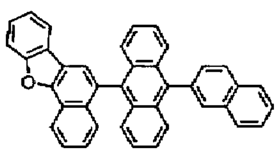
H68

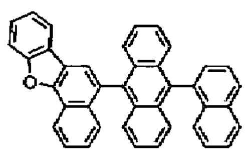
H69

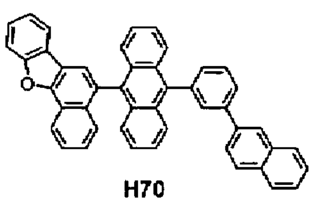
H70

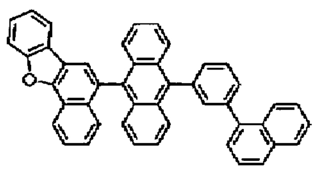
H71

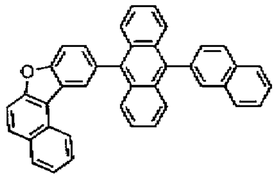
H72

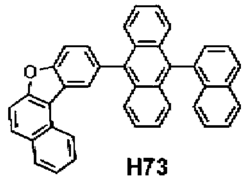
H73

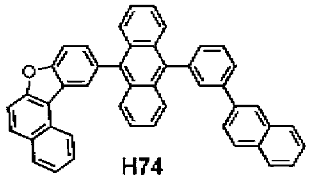
H74

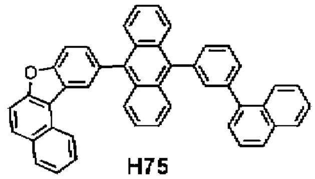
H75

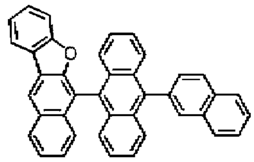
H76

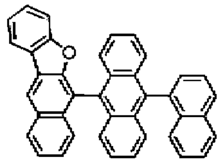
H77

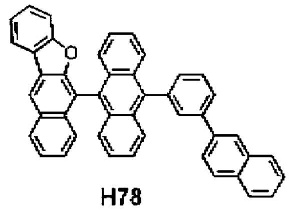
H78

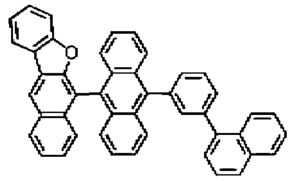
H79

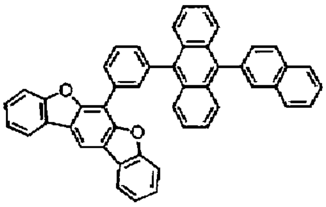
H80

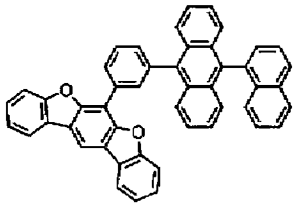
H81

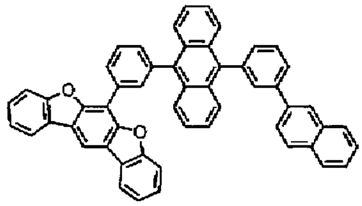
H82

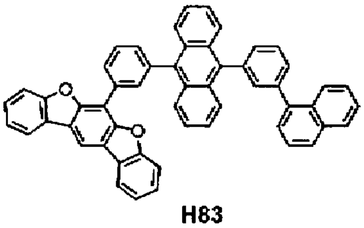
H83

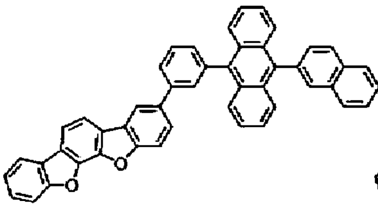
H84

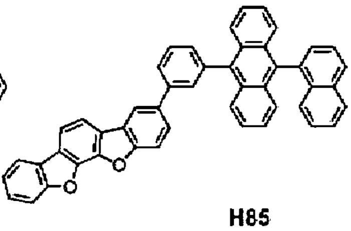
H85

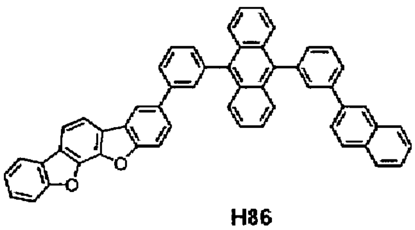
H86

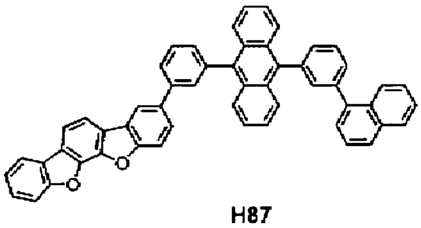
H87

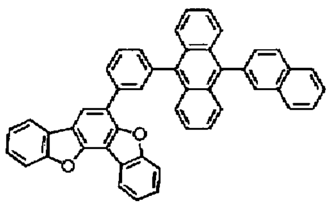
H88

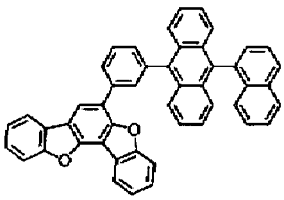
H89

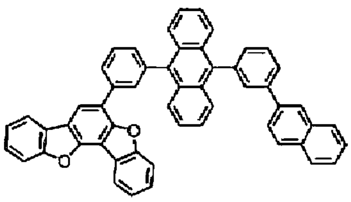
H90

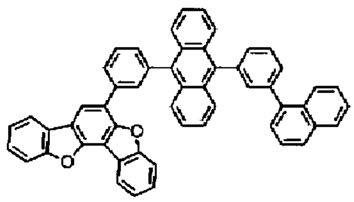
H91

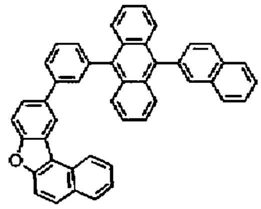

H92

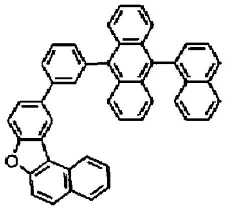

H93

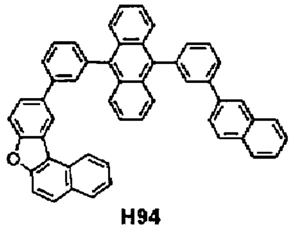

H94

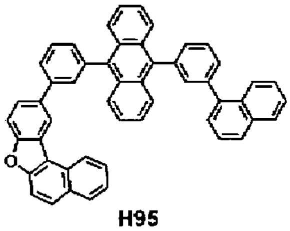

H95

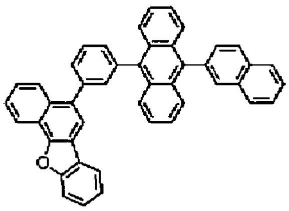

H96

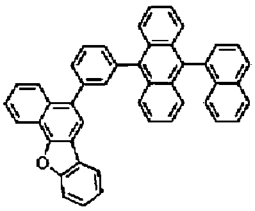

H97

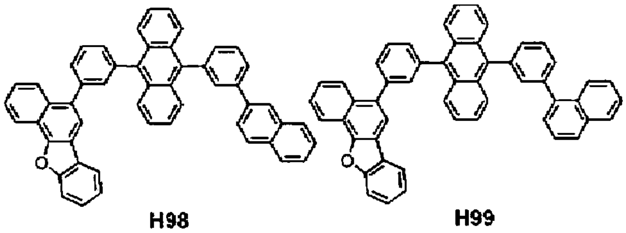

H98

H99

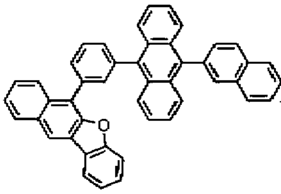

H100

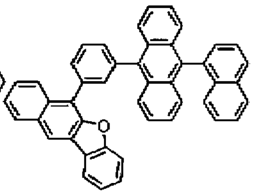

H101

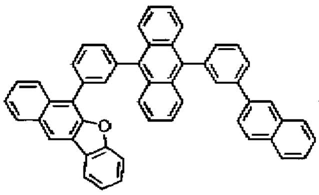

H102

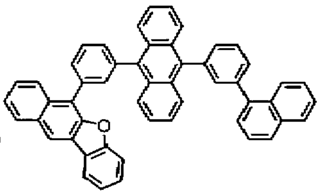

H103

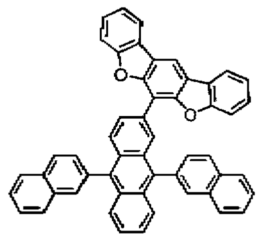

H104

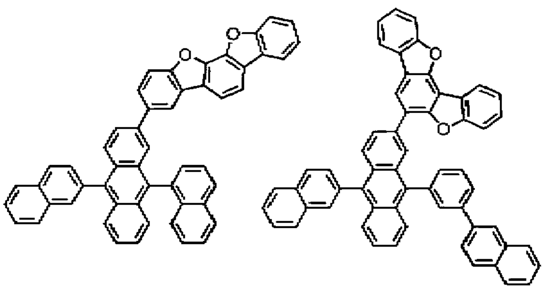

H105

H106

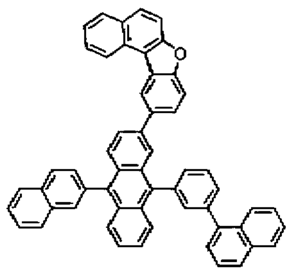

H107

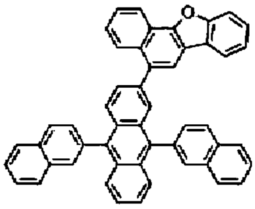

H108

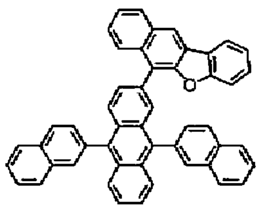

H109

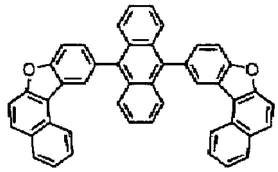

H110

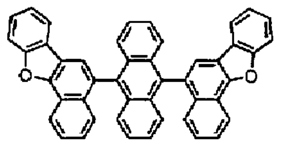

H111

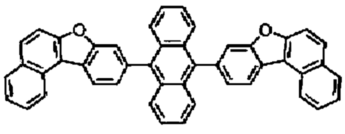

H112

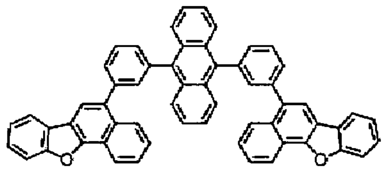

H113

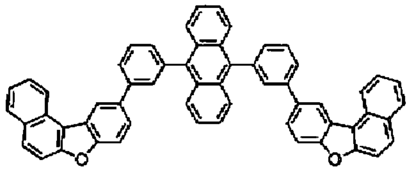

H114

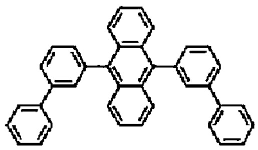

H115

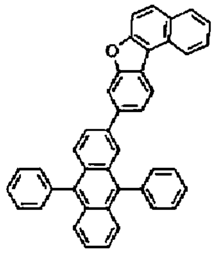

H116

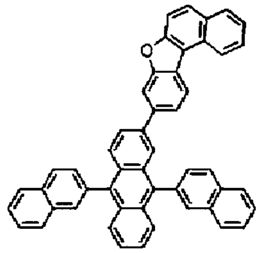

H117

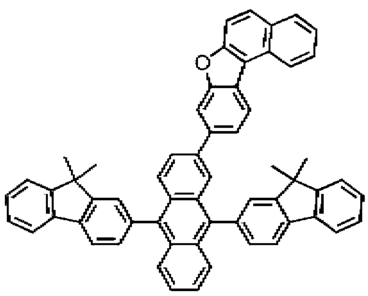

H118

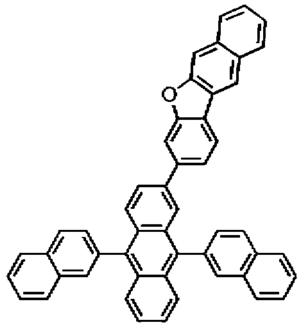

H119

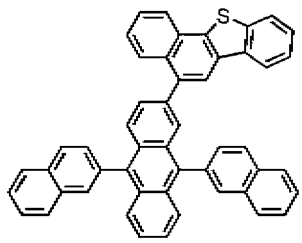

H120

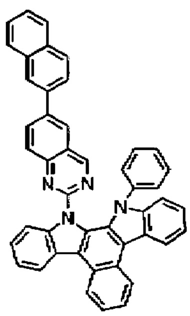

H121

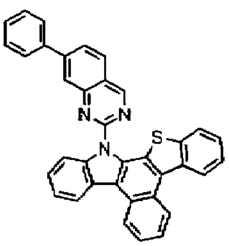

H122

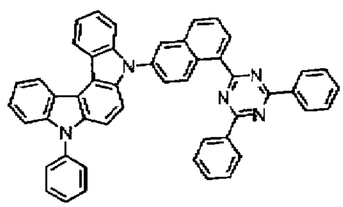

H123

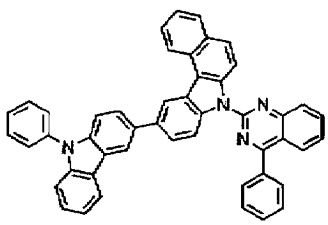

H124

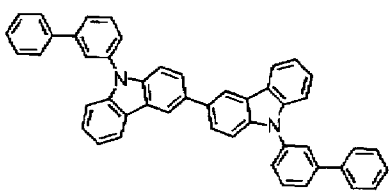

H125

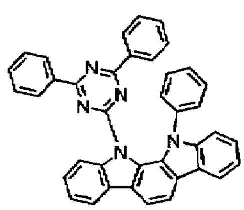

H126

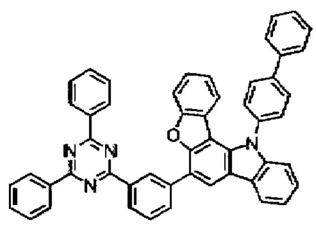

H127

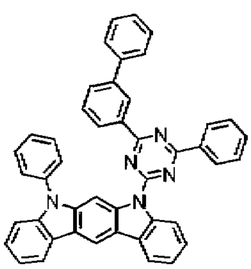

H128

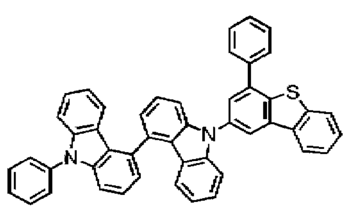

H129

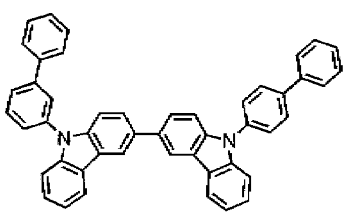

H130

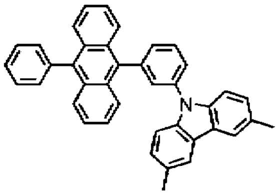

H131

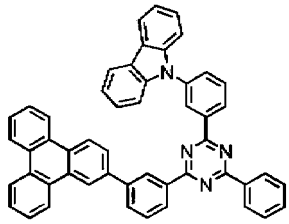

H132

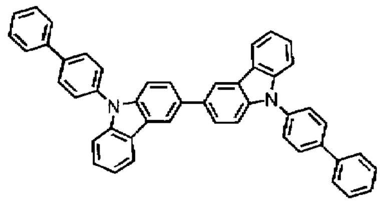

H133

The host may have various modifications. The host may include only one kind of compound or may include two or more kinds of different compounds. For example, the host may include a silicon-containing compound, a phosphine oxide-containing compound, or any combination thereof.

[Phosphorescent dopant]

The phosphorescent dopant may include at least one transition metal as a central metal.
The phosphorescent dopant may include a monodentate ligand, a bidentate ligand, a tridentate ligand, a tetradentate ligand, a pentadentate ligand, a hexadentate ligand, or any combination thereof.
The phosphorescent dopant may be electrically neutral.
In an embodiment, the phosphorescent dopant may include an organometallic compound represented by Formula 401:

[Formula 401] $M(L_{401})_{xc1}(L_{402})_{xc2}$

[Formula 402]

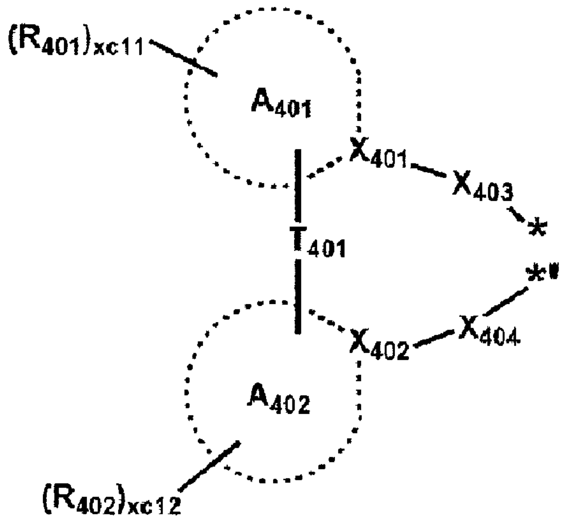

In Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
$L_{401}$ may be a ligand represented by Formula 402, and xc1 may be 1, 2, or 3, wherein when xc1 is 2 or more, two or more of $L_{401}$ may be identical to or different from each other,
$L_{402}$ may be an organic ligand, and xc2 may be 0, 1, 2, 3, or 4, wherein when xc2 is 2 or more, two or more of $L_{402}$ may be identical to or different from each other,
$X_{401}$ and $X_{402}$ may each independently be nitrogen or carbon,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)

=*', or *=C=*',

$X_{403}$ and $X_{404}$ may each independently be a chemical bond (for example, a covalent bond or a coordinate bond), O, S, $N(Q_{413})$, $B(Q_{413})$, $P(Q_{413})$, $C(Q_{413})(Q_{414})$, or $Si(Q_{413})(Q_{414})$,

$Q_{411}$ to $Q_{414}$ may each independently the same as described in connection with $Q_1$ herein,

$R_{401}$ and $R_{402}$ may each independently be hydrogen, deuterium, -F, -Cl, -Br, -I, a hydroxyl group, a cyano group, a nitro group, a $C_1$-$C_{20}$ alkyl group that is unsubstituted or substituted with at least one $R_{10a}$, a $C_1$-$C_{20}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, $-Si(Q_{401})(Q_{402})(Q_{403})$, $-N(Q_{401})(Q_{402})$, $-B(Q_{401})(Q_{402})$, $-C(=O)(Q_{401})$, $-S(=O)_2(Q_{401})$, or $-P(=O)(Q_{401})(Q_{402})$,

$Q_{401}$ to $Q_{403}$ may each independently the same as described in connection with $Q_1$ herein,

xc11 and xc12 may each independently be an integer from 0 to 10, and

* and *' in Formula 402 each indicate a binding site to M in Formula 401.

In an embodiment, in Formula 402, $X_{401}$ may be nitrogen and $X_{402}$ may be carbon, or $X_{401}$ and $X_{402}$ may each be nitrogen.

In an embodiment, in Formula 402, when xc1 is 2 or more, two ring $A_{401}$(s) of two or more of $L_{401}$(s) may be optionally linked to each other via $T_{402}$, which is a linking group, or two ring $A_{402}$(s) of two or more of $L_{401}$(s) may be optionally linked to each other via $T_{403}$, which is a linking group (see Compounds PD1 to PD4 and PD7). $T_{402}$ and $T_{403}$ may each independently be the same as described in connection with $T_{401}$ herein.

In Formula 401, $L_{402}$ may be an organic ligand. In an embodiment, $L_{402}$ may include a halogen group, a diketone group (for example, an acetylacetonate group), a carboxylic acid group (for example, a picolinate group), -C(=O), an isonitrile group, a - CN group, a phosphorus group (for example, a phosphine group, a phosphite group, etc.), or any combination thereof.

In an embodiment, the phosphorescent dopant may include, for example, one of Compounds PD1 to PD39, or any combination thereof:

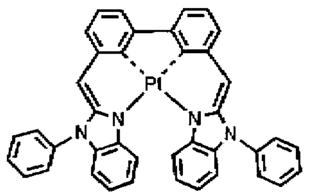

PD1

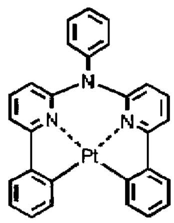

PD2

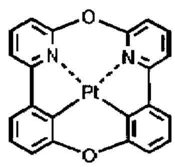

PD3

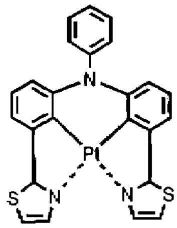

PD4

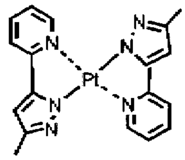

PD5

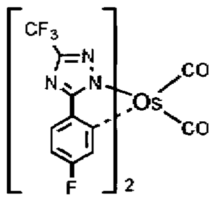

PD6

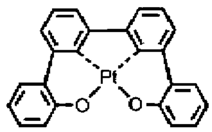

PD7

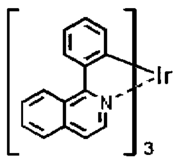

PD8

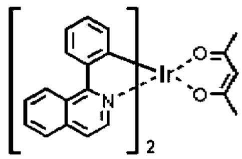

PD9

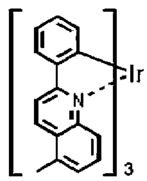

PD10

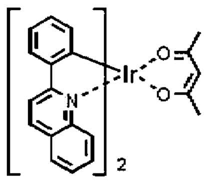

PD11

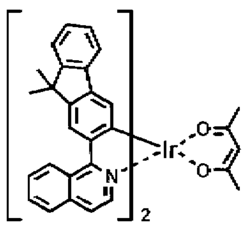

PD12

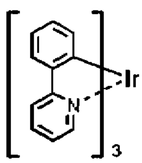

PD13

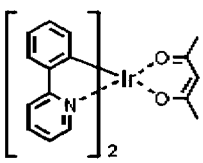

PD14

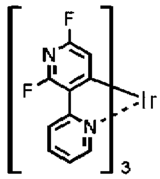

PD15

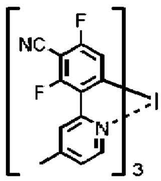
PD16

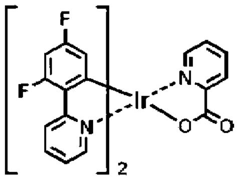
PD17

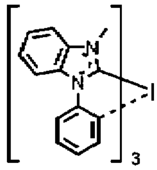
PD18

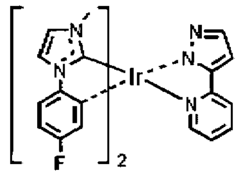
PD19

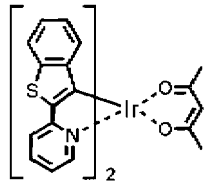
PD20

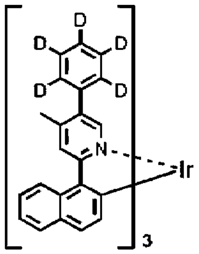
PD21

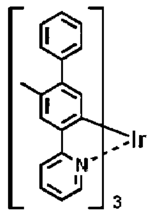
PD22

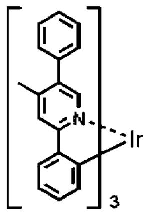
PD23

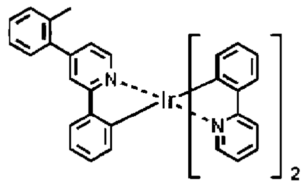
PD24

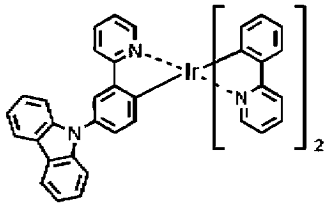
PD25

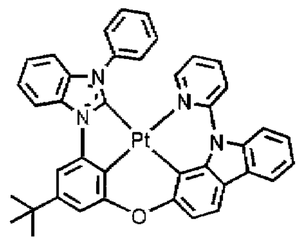
PD26

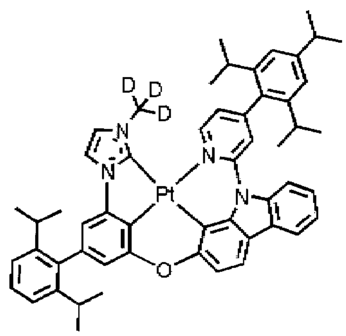
PD27

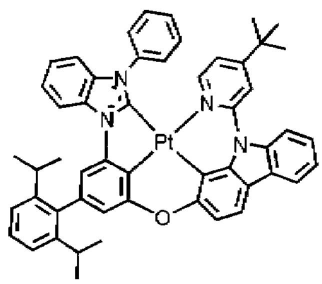
PD28

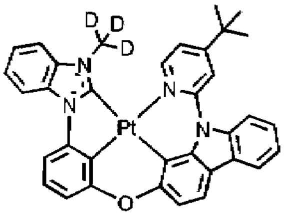
PD29

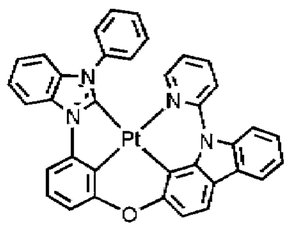
PD30

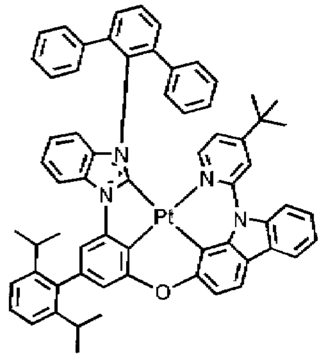
PD31

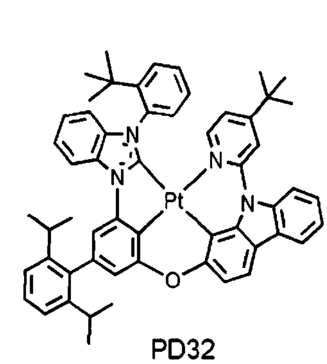

PD32

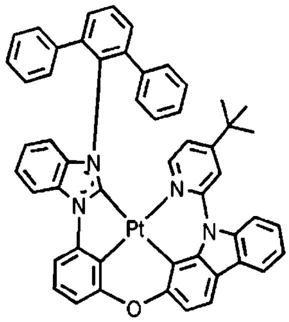

PD33

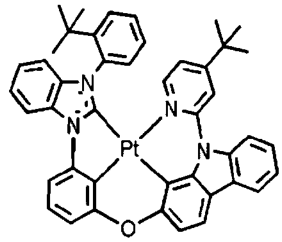

PD34

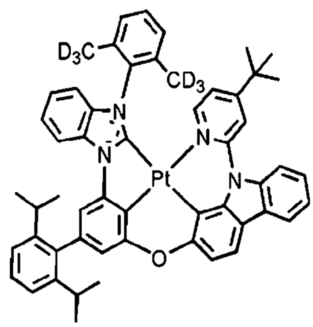

PD35

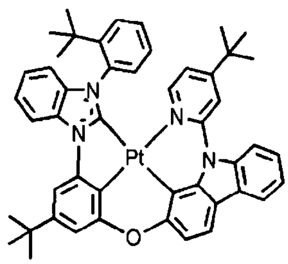

PD36

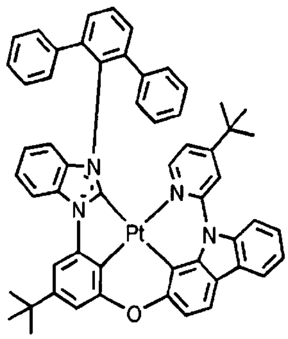

PD37

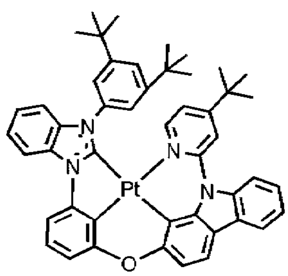

PD38

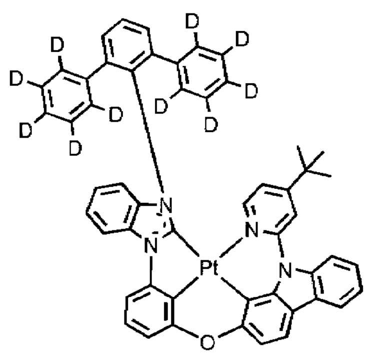

PD39

.

[Fluorescent dopant]

The fluorescent dopant may include an amine group-containing compound, a styryl group-containing compound, or any combination thereof.

In an embodiment, the fluorescent dopant may include a compound represented by Formula 501:

[Formula 501]

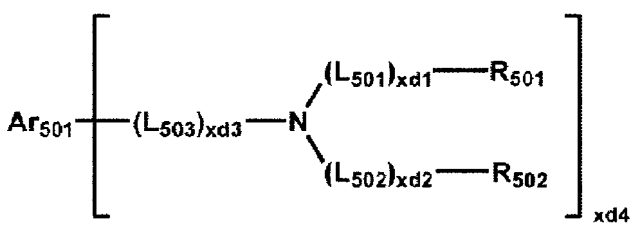

In Formula 501,

$Ar_{501}$, $L_{501}$ to $L_{503}$, $R_{501}$, and $R_{502}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
xd1 to xd3 may each independently be 0, 1, 2, or 3, and
xd4 may be 1, 2, 3, 4, 5, or 6.

In an embodiment, in Formula 501, $Ar_{501}$ may be a condensed cyclic group (for example, an anthracene group, a chrysene group, a pyrene group, etc.) in which three or more monocyclic groups are condensed together.
In an embodiment, in Formula 501, xd4 may be 2.
In an embodiment, the fluorescent dopant may include one of Compounds FD1 to FD37, DPVBi, DPAVBi, or any combination thereof:

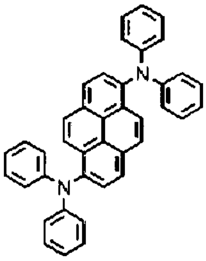

FD1

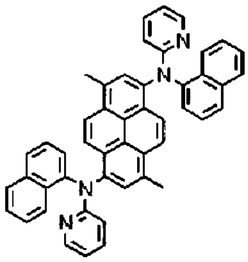

FD2

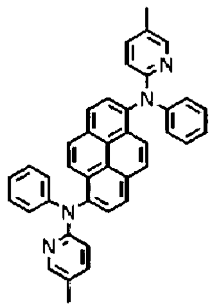

FD3

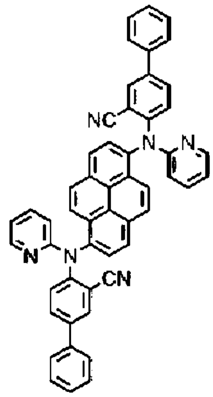

FD4

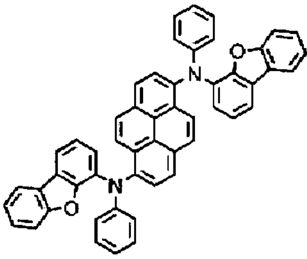

FD5

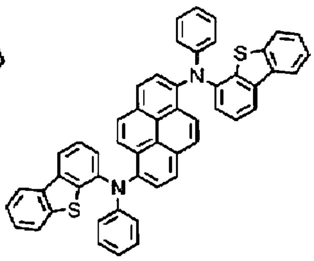

FD6

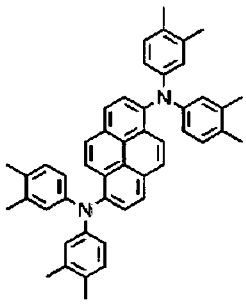

FD7

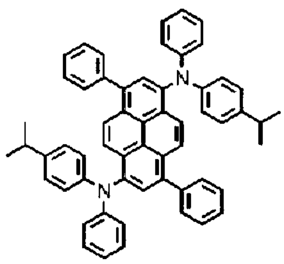

FD8

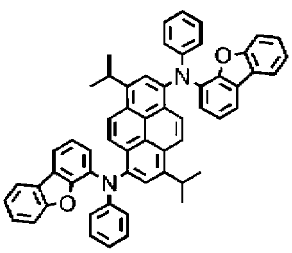

FD9

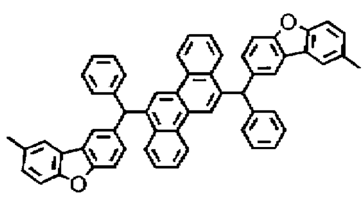

FD10

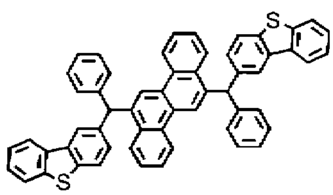

FD11

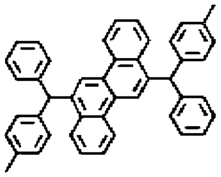

FD12

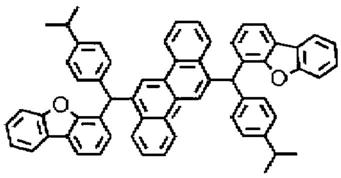

FD13

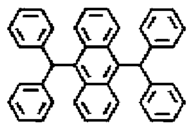

FD14

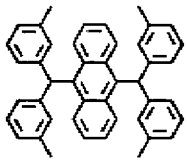

FD15

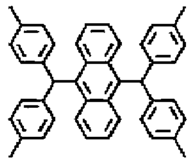

FD16

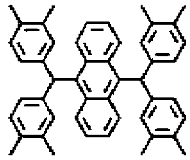

FD17

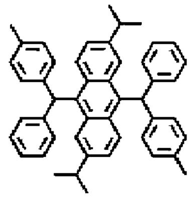

FD18

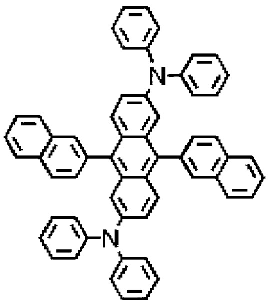

FD19

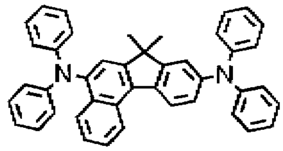

FD20

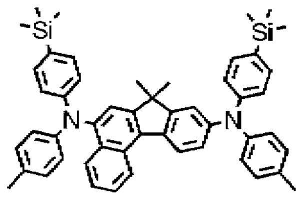

FD21

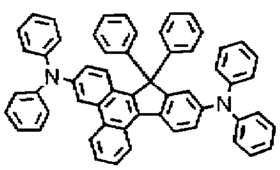

FD22

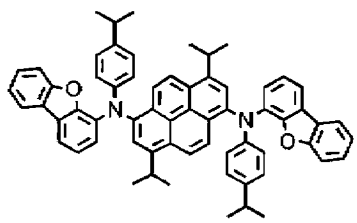

FD23

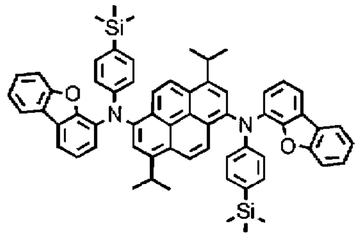

FD24

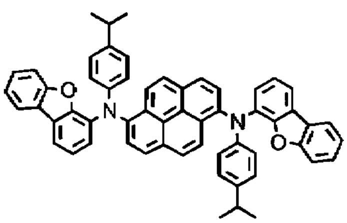

FD25

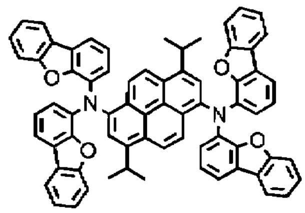

FD26

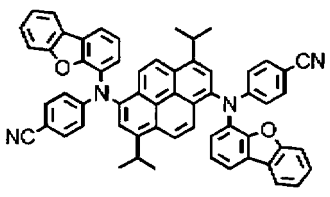

FD27

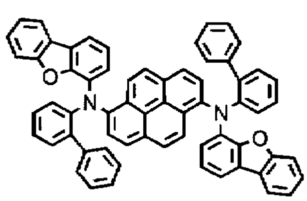

FD28

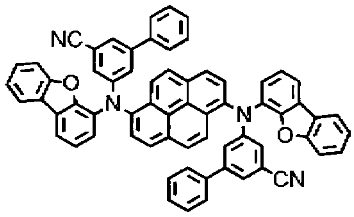

FD29

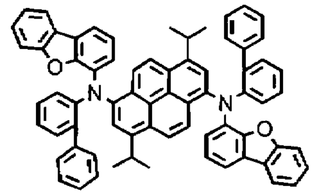

FD30

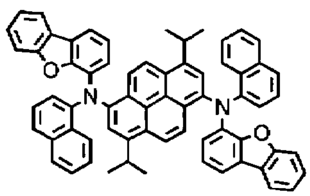

FD31

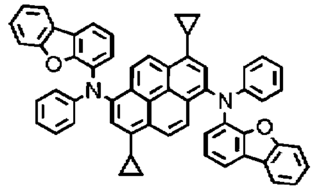

FD32

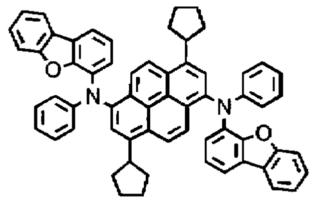

FD33

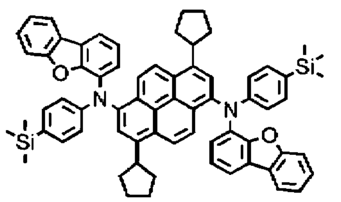

FD34

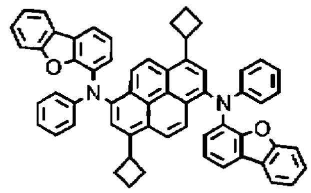

FD35

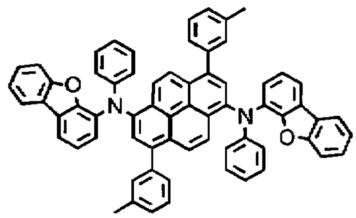

FD36

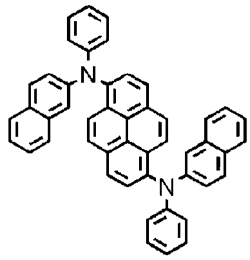

FD9

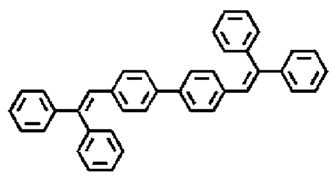

DPVBi

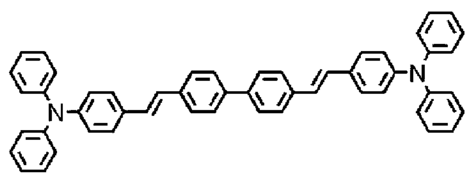

DPVBi .

[Delayed fluorescence material]

An emission layer may include a delayed fluorescence material.

In the specification, a delayed fluorescence material may be selected from compounds capable of emitting delayed fluorescence based on a delayed fluorescence emission mechanism.

The delayed fluorescence material included in an emission layer may serve as a host or as a dopant, depending on the types of other materials included in the emission layer.

In an embodiment, a difference between a triplet energy level (eV) of the delayed fluorescence material and a singlet energy level (eV) of the delayed fluorescence material may be at least about 0 eV and not more than about 0.5 eV.

When the difference between a triplet energy level (eV) of the delayed fluorescence material and a singlet energy level (eV) of the delayed fluorescence material is satisfied within the range above, up-conversion from the triplet state to the singlet state of the delayed fluorescence material may effectively occur, and thus, the light-emitting device 10 may have improved luminescence efficiency.

In an embodiment, the delayed fluorescence material may include: a material including at least one electron donor (for example, a π electron-rich $C_3$-$C_{60}$ cyclic group and the like, such as a carbazole group) and at least one electron acceptor (for example, a sulfoxide group, a cyano group, a π electron-deficient nitrogen-containing $C_1$-$C_{60}$ cyclic group, and the like); or a material including a $C_8$-$C_{60}$ polycyclic group including at least two cyclic groups condensed to each other while sharing boron (B); or the like.

Examples of a delayed fluorescence material may include at least one of Compounds DF1 to DF14:

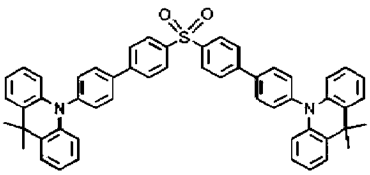
DF1(DMAC-DPS)

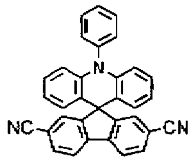
DF2(ACRFLCN)

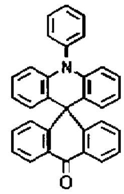
DF3(ACRSA)

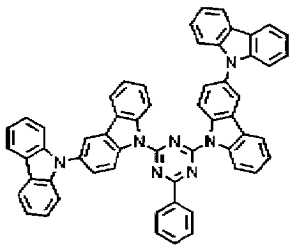
DF4(CC2TA)

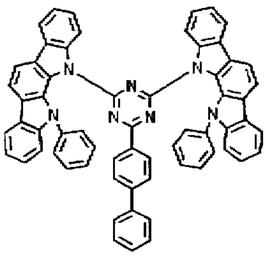
DF5(PIC-TRZ)

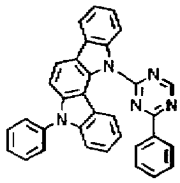
DF6(PIC-TRZ2)

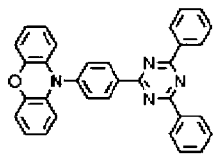
DF7(PXZ-TRZ)

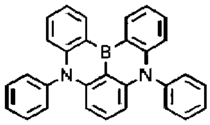
DF8(DABNA-1)

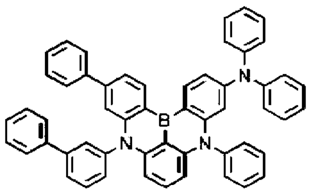
DF9(DABNA-2)

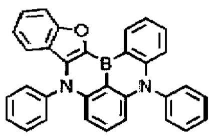
DF10

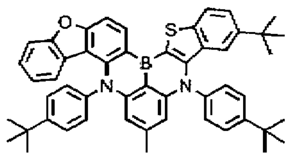
DF11

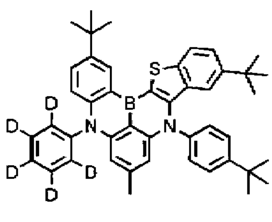
DF12

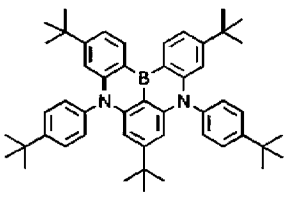
DF13

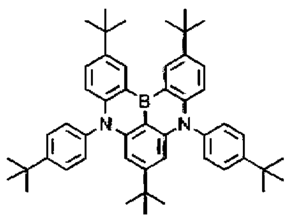
DF14

[Quantum dot]

The emission layer may include quantum dots.

In the specification, a quantum dot may be a crystal of a semiconductor compound and may include any material capable of emitting light of various emission wavelengths according to a size of the crystal. Quantum dots may emit light of various emission wavelengths by adjusting a ratio of elements within the quantum dots.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process is a method that includes mixing a precursor material with an organic solvent and growing quantum dot particle crystals. When the crystal grows, the organic solvent naturally serves as a dispersant coordinated on the surface of the quantum dot crystal and controls the growth of the crystal, so that the growth of quantum dot particles can be controlled through a process which costs less, and may be more readily performed than vapor deposition methods, such as metal organic chemical vapor deposition (MOCVD) or molecular beam epitaxy (MBE).

A quantum dot may include a Group II-VI semiconductor compound, a Group III-V semiconductor compound, a Group III-VI semiconductor compound, a Group I-III-VI semiconductor compound, a Group IV-VI semiconductor compound, a Group IV element or compound, or any combination thereof.

Examples of a Group II-VI semiconductor compound may include: a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or any combination thereof.

Examples of a Group III-V semiconductor compound may include: a binary compound, such as GaN, GaP, GaAs, GaSb, AlN, AlP, AlAs, AlSb, InN, InP, InAs, or InSb, a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, or InPSb, a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, or InAlPSb; or any combination thereof. In an embodiment, a Group III-V semiconductor compound may further include a Group II element. Examples of a Group III-V semiconductor compound further including a Group II element may include InZnP, InGaZnP, and InAlZnP.

Examples of a Group III-VI semiconductor compound may include: a binary compound, such as GaS, GaSe, $Ga_2Se_3$, GaTe, InS, InSe, $In_2S_3$, $In_2Se_3$, or InTe; a ternary compound, such as $InGaS_3$ or $InGaSe_3$; or any combination thereof.

Examples of a Group I-III-VI semiconductor compound may include: a ternary compound, such as AgInS, $AgInS_2$, $AgInSe_2$, AgGaS, $AgGaS_2$, $AgGaSe_2$, CuInS, $CuInS_2$, $CuInSe_2$, $CuGaS_2$, $CuGaSe_2$, $CuGaO_2$, $AgGaO_2$, $AgAlO_2$, etc.; a quaternary compound, such as $AgInGaS_2$, $AgInGaSe_2$, etc.; or any combination thereof.

Examples of a Group IV-VI semiconductor compound may include: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or any combination thereof.

Examples of a Group IV element or compound may include: a single element material, such as Si or Ge; a binary compound, such as SiC or SiGe; or any combination thereof.

Each element included in a multi-element compound, such as a binary compound, a ternary compound, or a quaternary compound, may be present in a particle at a uniform concentration distribution or at a non-uniform concentration distribution. For example, a formula may indicate the elements included in a compound, wherein the ratios of elements in the compound may vary. For example, $AgInGaS_2$ may refer to $AgIn_xGa_{1-x}S_2$ (where x is a real number between 0 and 1).

In an embodiment, a quantum dot may have a single structure, in which the concentration of each element in the quantum dot is uniform, or a quantum dot may have a core-shell structure in which a quantum dot surrounds another quantum dot. For example, a material included in the core and a material included in the shell may be different from each other.

The shell of the quantum dot may serve as a protective layer which prevents chemical denaturation of the core to maintain semiconductor characteristics, and/or may serve as a charging layer which imparts electrophoretic characteristics to the quantum dot. The shell may be a single layer or a multilayer. An interface between the core and the shell may have a concentration gradient in which the concentration of an element that is present in the shell decreases toward the core.

Examples of a shell of a quantum dot may include a metal oxide, a metalloid oxide, a non-metal oxide, a semiconductor compound, or a combination thereof. Examples of a metal oxide, a metalloid oxide, or a non-metal oxide may include: a binary compound, such as $SiO_2$, $Al_2O_3$, $TiO_2$, ZnO, MnO, $Mn_2O_3$, $Mn_3O_4$, CuO, FeO, $Fe_2O_3$, $Fe_3O_4$, CoO, $Co_3O_4$, or NiO; a ternary compound, such as $MgAl_2O_4$, $CoFe_2O_4$, $NiFe_2O_4$, or $CoMn_2O_4$; or any combination thereof. Examples of a semiconductor compound may include, as described herein: a Group II-VI semiconductor compound; a Group III-V semiconductor compound; a Group III-VI semiconductor compound; a Group I-III-VI semiconductor compound; a Group IV-VI semiconductor compound; or any combination thereof. In an embodiment, a semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width at half maximum (FWHM) of an emission wavelength spectrum equal to or less than about 45 nm. For example, the quantum dot may have a FWHM of an emission wavelength spectrum equal to or

less than about 40 nm. For example, the quantum dot may have a FWHM of an emission wavelength spectrum equal to or less than about 30 nm. Color purity or color reproducibility may be increased in any of the above ranges. Since light emitted through the quantum dot may be emitted in all directions, a wide viewing angle may be improved.

The form of a quantum dot is not particularly limited and may be any form used in the related art. For example, the quantum dot may have a spherical shape, a pyramidal shape, a multi-arm shape, or a cubic shape, or the quantum dot may be in the form of nanoparticles, nanotubes, nanowires, nanofibers, or nanoplate particles.

Since the energy band gap may be controlled by adjusting a size of a quantum dot or a ratio of elements in a quantum dot compound, light in various wavelengths may be obtained from a quantum dot-containing emission layer. Therefore, by using the aforementioned quantum dots (using different sizes of quantum dots of or different elemental ratios in a quantum dot compound), a light-emitting device may emit light of various wavelengths. For example, a size of a quantum dot or an elemental ratio of a quantum dot compound may each independently be adjusted to emit red light, green light, and/or blue light. For example, the size of the quantum dots may be configured to emit white light by combination of light of various colors.

[Electron transport region in interlayer 130]

The electron transport region may have a structure consisting of a layer consisting of a single material, a structure consisting of a layer including different materials, or a structure including multiple layers including different materials.

An electron transport region may include a buffer layer, a hole blocking layer, an electron control layer, an electron transport layer, an electron injection layer, or any combination thereof.

In an embodiment, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the layers of each structure may be stacked from the emission layer in its respective stated order, but the structure of an electron transport region is not limited thereto.

In an embodiment, the electron transport region (for example, a buffer layer, a hole blocking layer, an electron control layer, or an electron transport layer in the electron transport region) may include a metal-free compound including at least one $\pi$ electron-deficient nitrogen-containing $C_1$-$C_{60}$ cyclic group.

In an embodiment, an electron transport region may include a compound represented by Formula 601:

[Formula 601] $$[Ar_{601}]_{xe11}\text{-}[(L_{601})_{xe1}\text{-}R_{601}]_{xe21}.$$

In Formula 601,

$Ar_{601}$ and $L_{601}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, $-Si(Q_{601})(Q_{602})(Q_{603})$, $-C(=O)(Q_{601})$, $-S(=O)_2(Q_{601})$, or - $P(=O)(Q_{601})(Q_{602})$,
$Q_{601}$ to $Q_{603}$ may each independently be the same as described in connection with $Q_1$ herein,
xe21 may be 1, 2, 3, 4, or 5, and
at least one of $Ar_{601}$, $L_{601}$, and $R_{601}$ may each independently be a $\pi$ electron-deficient nitrogen-containing $C_1$-$C_{60}$ cyclic group that is unsubstituted or substituted with at least one $R_{10a}$.

In an embodiment, in Formula 601, when xe11 is 2 or more, two or more of $Ar_{601}$ may be linked together via a single bond.

In an embodiment, in Formula 601, $Ar_{601}$ may be an anthracene group that is unsubstituted or substituted with at least one $R_{10a}$

In an embodiment, an electron transport region may include a compound represented by Formula 601-1:

[Formula 601-1]

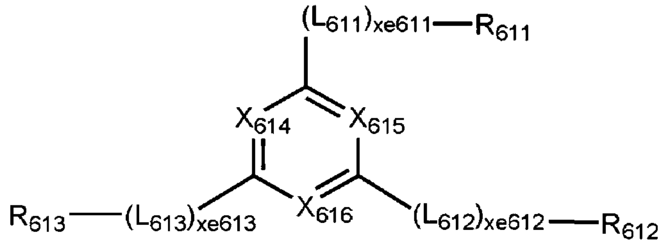

In Formula 601-1,

$X_{614}$ may be N or $C(R_{614})$, $X_{615}$ may be N or $C(R_{615})$, $X_{616}$ may be N or $C(R_{616})$, and at least one of $X_{614}$ to $X_{616}$ may each be N,
$L_{611}$ to $L_{613}$ may each independently be the same as described in connection with $L_{601}$,
xe611 to xe613 may each independently be the same as described in connection with xe1,
$R_{611}$ to $R_{613}$ may each independently be the same as described in connection with $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$.

In an embodiment, in Formulae 601 and 601-1, xe1 and xe611 to xe613 may each independently be 0, 1, or 2.

In an embodiment, the electron transport region may include one of Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, or any combination thereof:

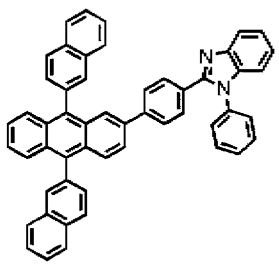

ET1

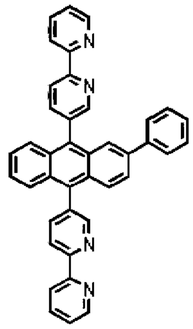

ET2

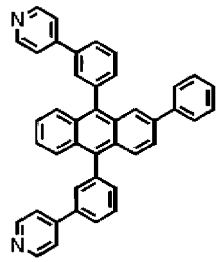

ET3

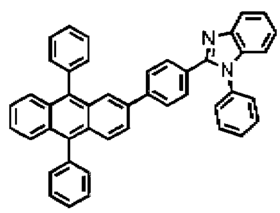

ET4

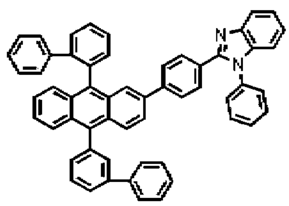

ET5

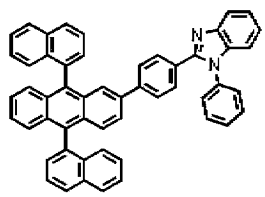

ET6

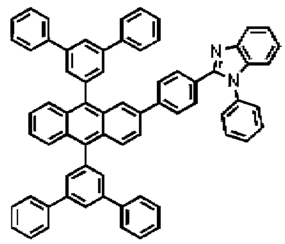

ET7

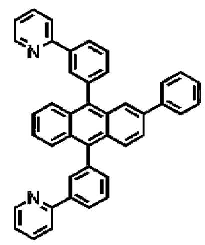

ET8

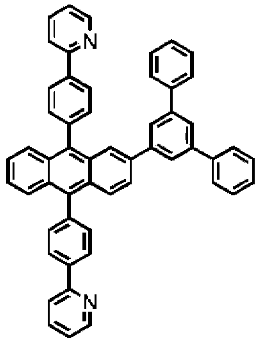
ET9

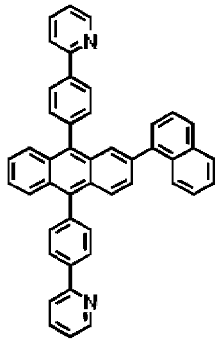
ET10

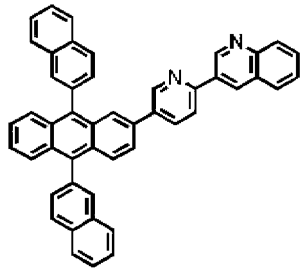
ET11

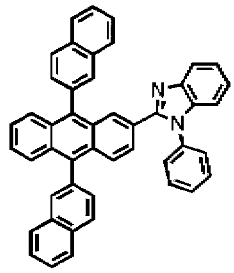
ET12

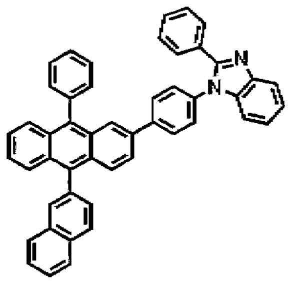
ET13

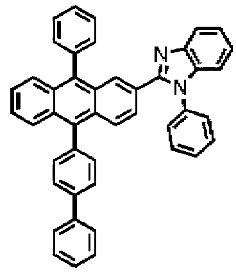
ET14

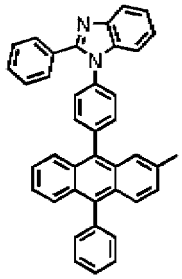
ET15

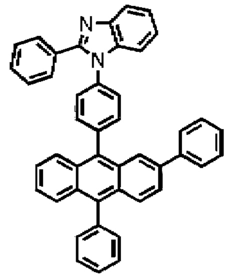
ET16

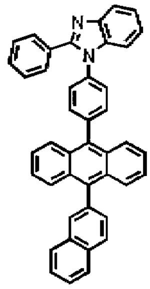
ET17

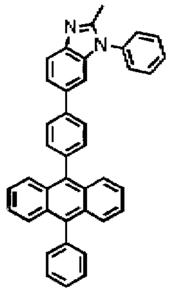
ET18

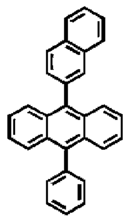
ET19

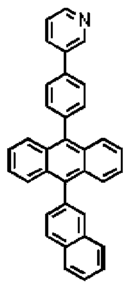
ET20

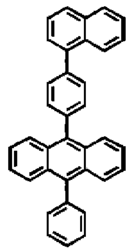
ET21

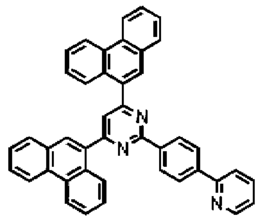
ET22

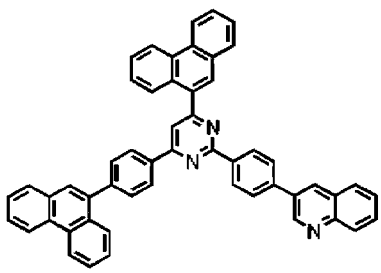
ET23

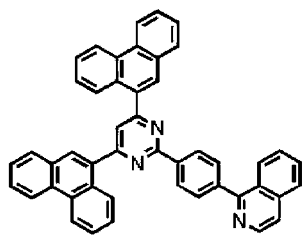
ET24

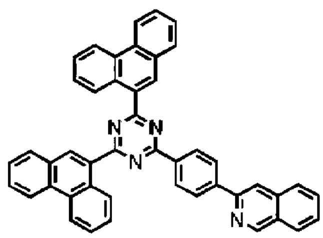
ET25

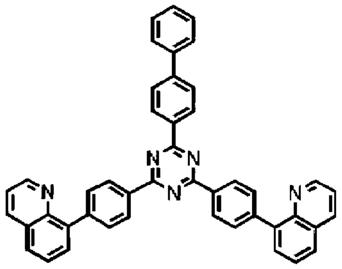

ET26

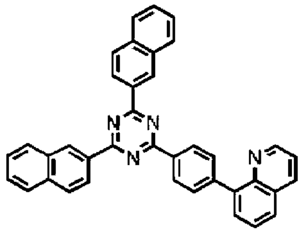

ET27

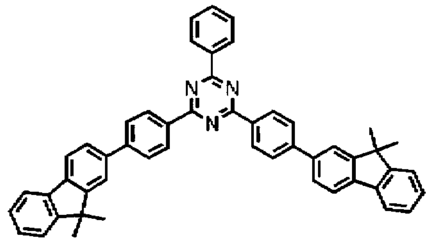

ET28

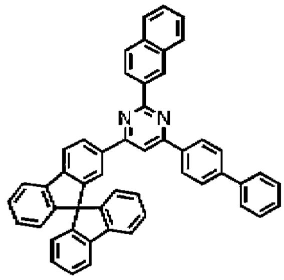

ET29

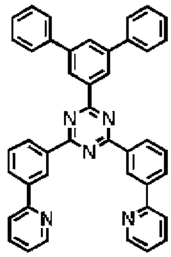

ET30

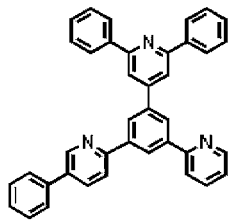

ET31

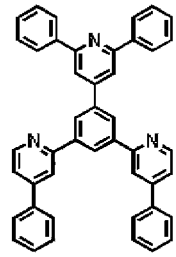

ET32

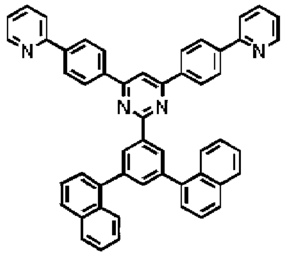

ET33

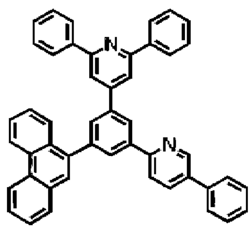

ET34

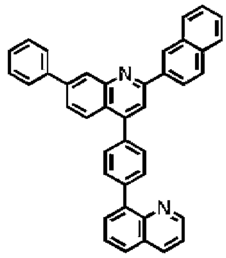

ET35

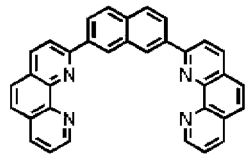

ET36

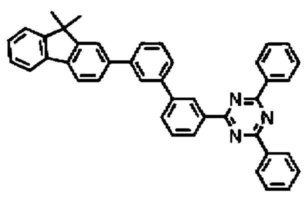

ET37

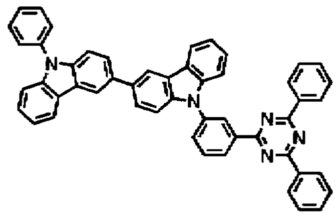

ET38

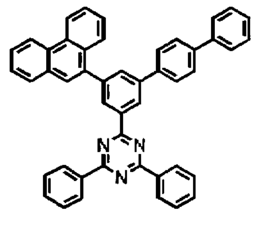

ET39

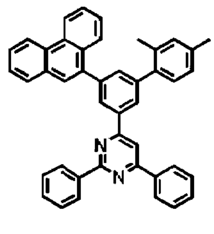

ET40

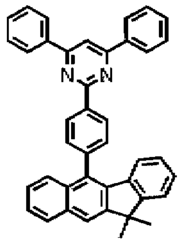

ET41

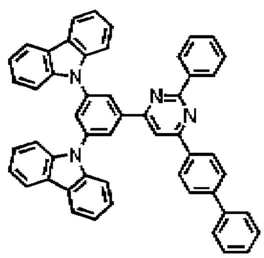

ET42

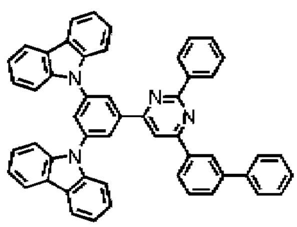

ET43

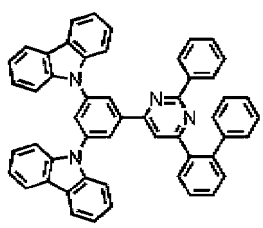

ET44

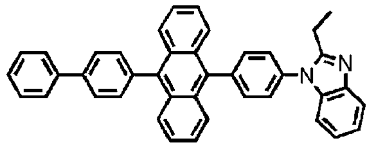

ET45

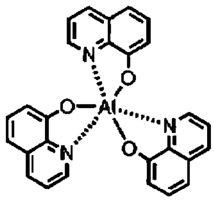

Alq3

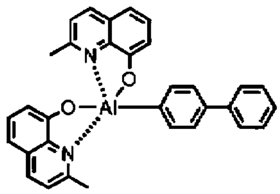

BAlq

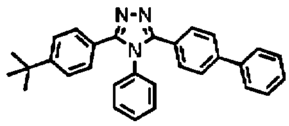

TAZ

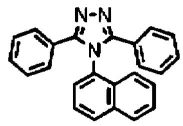

NTAZ

A thickness of an electron transport region may be in a range of about 100 Å to about 5,000 Å. For example, a thickness of an electron transport region may be in a range of about 160 Å to about 4,000 Å. When an electron transport region includes a buffer layer, a hole blocking layer, an electron control layer, an electron transport layer, or any combination thereof, a thickness of a buffer layer, a hole blocking layer, or an electron control layer may each independently be in a range of about 20 Å to about 1,000 Å, and a thickness of an electron transport layer may be in a range of about 100 Å to about 1,000 Å. For example, a thickness of a buffer layer, a hole blocking layer, or an electron control layer may each independently be in a range of about 30 Å to about 300 Å. For example, a thickness of an electron transport layer may be in a range of about 150 Å to about 500 Å. When the thickness of the buffer layer, the hole blocking layer, the electron control layer, the electron transport layer, and/or the electron transport region are within these ranges, satisfactory electron transporting characteristics may be obtained without a substantial increase in driving voltage.

An electron transport region (for example, an electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion.

A ligand coordinated with a metal ion of an alkali metal complex or an alkaline earth-metal complex may each independently include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or Compound ET-D2:

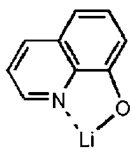

ET-D1

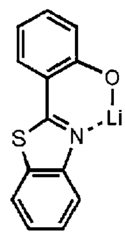

ET-D2 .

An electron transport region may include an electron injection layer to facilitate the injection of electrons from the second electrode 150.

The electron injection layer may be the same as described above.

[Second electrode 150]

The second electrode 150 is arranged on the interlayer 130. In an embodiment, the second electrode 150 may be

a cathode, which is an electron injection electrode. The cathode may be the same as described above.

In an embodiment, by applying the electron injection layer and the cathode as described above, a pixel shrinkage phenomenon, in which the photoluminescence area of a pixel decreases, may be reduced, and light loss due to light absorption may be reduced to improve the current efficiency of the light-emitting device.

[Capping layer]

The light-emitting device 10 may include a first capping layer outside the first electrode 110, and/or a second capping layer outside the second electrode 150. In embodiments, the light-emitting device 10 may have a structure in which the first capping layer, the first electrode 110, the interlayer 130, and the second electrode 150 are stacked in this stated order, a structure in which the first electrode 110, the interlayer 130, the second electrode 150, and the second capping layer are stacked in this stated order, or a structure in which the first capping layer, the first electrode 110, the interlayer 130, the second electrode 150, and the second capping layer are stacked in this stated order.

Light generated in an emission layer in the interlayer 130 of the light-emitting device 10 may be extracted toward the outside through the first electrode 110, which may be a semi-transmissive electrode or a transmissive electrode, and through the first capping layer. Light generated in an emission layer in the interlayer 130 of the light-emitting device 10 may be extracted toward the outside through the second electrode 150, which may be a semi-transmissive electrode or a transmissive electrode, and through the second capping layer.

The first capping layer and the second capping layer may each increase external emission efficiency according to the principle of constructive interference. Accordingly, the light extraction efficiency of the light-emitting device 10 may be increased, such that the luminescence efficiency of the light-emitting device 10 may be increased.

The first capping layer and the second capping layer may each include a material having a refractive index greater than or equal to about 1.6 (with respect to a wavelength of about 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may each be optionally substituted with a substituent including O, N, S, Se, Si, F, Cl, Br, I, or any combination thereof.

In an embodiment, at least one of the first capping layer and the second capping layer may each independently include an amine group-containing compound.

In an embodiment, at least one of the first capping layer and the second capping layer may each independently include a compound represented by Formula 201, a compound represented by Formula 202, or any combination thereof.

In an embodiment, at least one of the first capping layer and the second capping layer may each independently include one of Compounds HT28 to HT33, one of Compounds CP1 to CP6, β-NPB, or any combination thereof:

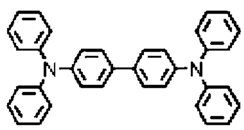

CP1

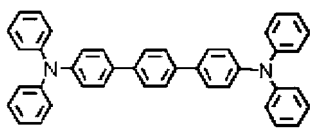

CP2

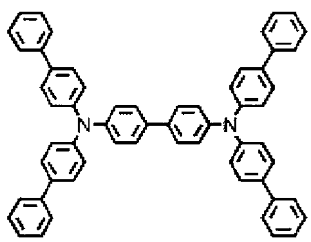

CP3

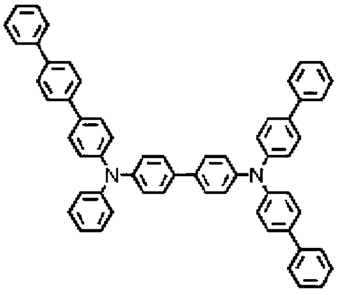

CP4

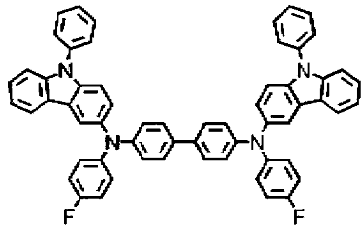

CP5

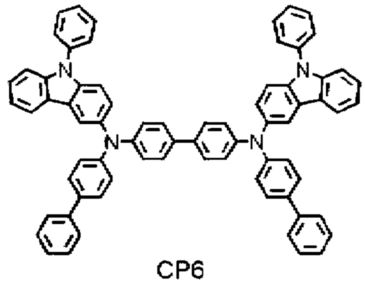

CP6

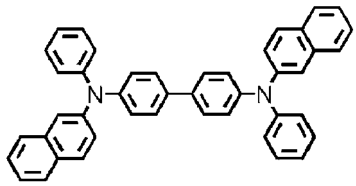

β-NPB .

[Electronic apparatus]

The light-emitting device may be included in various electronic apparatuses. For example, the electronic apparatus including the light-emitting device may be a light-emitting apparatus, an authentication apparatus, or the like.

The electronic apparatus (for example, a light-emitting apparatus) may further include, in addition to the light-emitting device, a color filter, a color conversion layer, or a color filter and a color conversion layer. The color filter and/or the color conversion layer may be arranged in at least one traveling direction of light emitted from the light-emitting device. In embodiments, the light emitted from the light-emitting device may be blue light or white light. The light-emitting device may be the same as described herein. In an embodiment, the color conversion layer may include quantum dots. The quantum dot may be, for example, a quantum dot as described herein.

The electronic apparatus may include a first substrate. The first substrate may include a subpixels, the color filter may include color filter areas respectively corresponding to the subpixels, and the color conversion layer may include color conversion areas respectively corresponding to the subpixels.

A pixel-defining film may be arranged between the subpixels to define each subpixel.

The color filter may further include color filter areas and light-shielding patterns arranged between the color filter areas, and the color conversion layer may further include color conversion areas and light-shielding patterns arranged between the color conversion areas.

The color filter areas (or the color conversion areas) may include a first area emitting first color light, a second area emitting second color light, and/or a third area emitting third color light, wherein the first color light, the second color light, and/or the third color light may have different maximum emission wavelengths. In an embodiment, the first color light may be red light, the second color light may be green light, and the third color light may be blue light. In an embodiment, the color filter areas (or the color conversion areas) may include quantum dots. For example, the first area may include red quantum dots, the second area may include green quantum dots, and the third area may not include quantum dots. The quantum dots may be quantum dots as described herein. The first area, the second area, and/or the third area may each further include a scatterer.

In an embodiment, the light-emitting device may emit first light, the first area may absorb the first light to emit first-first color light, the second area may absorb the first light to emit second-first color light, and the third area may absorb the first light to emit third-first color light. In this regard, the first-first color light, the second-first color light, and the third-first color light may have different maximum emission wavelengths from one another. For example, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an active layer, wherein any one of the source electrode and the drain electrode may be electrically connected to any one of the first electrode and the second electrode of the light-emitting device.

The thin-film transistor may further include a gate electrode, a gate insulating film, and the like.

The active layer may include crystalline silicon, amorphous silicon, an organic semiconductor, an oxide semiconductor, or the like.

The electronic apparatus may further include a sealing portion for sealing the light-emitting device. The sealing portion may be arranged between the color filter and/or the color conversion layer and the light-emitting device. The sealing portion may allow light from the light-emitting device to be extracted to the outside and may prevent ambient air and moisture from penetrating into the light-emitting device. The sealing portion may be a sealing substrate including a transparent glass substrate or a plastic substrate. The sealing portion may be a thin-film encapsulation layer including an organic layer and/or an inorganic layer. When the sealing portion is a thin-film encapsulation layer, the electronic apparatus may be flexible.

Various functional layers may be further included on the sealing portion, in addition to the color filter and/or the color conversion layer, according to a use of the electronic apparatus. Examples of a functional layer may include a touch screen layer and a polarizing layer. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, or the like.

[Electronic equipment]

The light-emitting device may be included in various electronic equipment.

In an embodiment, the electronic equipment including the light-emitting device may be a flat panel display, a curved display, a computer monitor, a medical monitor, a television (TV), an advertisement board, an indoor light, an outdoor light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a three-dimensional 3D display, a virtual reality display, an augmented reality display, a vehicle, a video wall including multiple displays tiled together, a theater screen, a stadium screen, a phototherapy device, or a sign.

Since the light-emitting device has excellent effects in terms of luminescence efficiency and a long lifespan, the electronic equipment including the light-emitting device may have characteristics such as high luminance, high resolution, and low power consumption.

[Description of FIGS. 2 and 3]

FIGS. 2 and 3 are respectively a schematic cross-sectional view of tandem light-emitting devices 20 and 30 according to an embodiment. The light-emitting devices 20 and 30 each include the first electrode 110, the interlayer 130, and the second electrode 150.

Referring to FIG. 2, the interlayer 130 of the light-emitting device 20 includes m emitting units (145(1), ..., and 145(m)) and m-1 charge generation units (144(1), ..., and 144(m-1)) between neighboring emitting units among the m emitting units. For example, m may be an integer of 2 or more. For example, m may be an integer of 2 to 10. For example, m may be an integer of 2 to 6. For example, m may be an integer of 2 to 4.

Among the m emitting units, an emitting unit which is $m^{th}$ closest to the first electrode 110 may be referred to as an $m^{th}$ emitting unit 145(m). For example, among the m emitting units, an emitting unit closest to the first electrode 110 is referred to as a first emitting unit 145(1), an emitting unit farthest from the first electrode 110 (for example, an emitting unit adjacent to the second electrode 150) is referred to as the $m^{th}$ emitting unit 145(m), and the first emitting unit 145(1) to the $m^{th}$ emitting unit 145(m) are sequentially arranged. For example, an $m\text{-}1^{th}$ emitting unit 144(m-1) is arranged between the first electrode 110 and the $m^{th}$ emitting unit 145(m).

In an embodiment, at least one of the m emitting units may emit blue light having a maximum emission wavelength in a range of about 410 nm to about 490 nm. In an embodiment, at least one of the m emitting units may emit green light having a maximum emission wavelength in a range of about 490 nm to about 580 nm.

In an embodiment, the m emitting units may each independently include an emission layer, a hole transport region, and an electron transport region. The hole transport region may include at least one of a hole injection layer, a hole transport layer, a buffer layer, an emission auxiliary layer, and an electron blocking layer. The electron transport region may include at least one of a hole blocking layer, an electron transport layer, and an electron injection layer. The emission layer,

the hole transport region, and the electron transport region in each of the m emitting units of the light-emitting device 20 of FIG. 20 are the same as the emission layer, the hole transport region, and the electron transport region of the light-emitting device 10 of FIG. 1.

An electron transport region of the $m^{th}$ emitting unit 145(m) in the light-emitting device 20 of FIG. 2 may include an electron transport layer between an emission layer and the second electrode 150 and an electron injection layer between the electron transport layer and the second electrode 150. The electron injection layer may be adjacent to the second electrode 150. The electron injection layer of the $m^{th}$ emitting unit 145(m) is the same as the electron injection layer according to the above-described embodiment, and the second electrode 150 is the same as the cathode according to the above-described embodiment.

In an embodiment, the m-1 charge generation units may each independently include a p-type charge generation layer and an n-type charge generation layer.

In an embodiment, when m is 2, the first electrode, a first emitting unit, a first charge generation unit, and a second emitting unit may be sequentially arranged. The first emitting unit may emit first-color light, the second light emitting unit may emit second-color light, and the maximum emission wavelength of first-color light and the maximum emission wavelength of second-color light may be identical to or different from each other.

In an embodiment, when m is 3, the first electrode, a first emitting unit, a first charge generation unit, a second emitting unit, a second charge generation unit, and a third emitting unit may be sequentially arranged. The first emitting unit may emit first-color light, the second emitting unit may emit second-color light, the third emitting unit may emit third-color light, and the maximum emission wavelength of first-color light, the maximum emission wavelength of second-color light, and the maximum emission wavelength of third-color light may be identical to or different from each other.

In an embodiment, when m is 4, the first electrode, a first emitting unit, a first charge generation unit, a second emitting unit, a second charge generation unit, a third emitting unit, a third charge generation unit, and a fourth emitting unit may be sequentially arranged. The first emitting unit may emit first-color light, the second emitting unit may emit second-color light, the third emitting unit may emit third-color light, the fourth emitting unit may emit fourth-color light, and the maximum emission wavelength of first-color light, the maximum emission wavelength of second-color light, the maximum emission wavelength of third-color light, and the maximum emission wavelength of fourth color light may be identical to or different from each other.

According to an embodiment, the maximum emission wavelength emitted from at least one emitting unit of the m emitting units may be different from the maximum emission wavelength of light emitted from at least emitting unit of the remaining emitting unit.

FIG. 3 shows a light-emitting device 30 wherein m is 4 in the light-emitting device 20 of FIG. 2. Referring to FIG. 3, the light-emitting device 30 includes first to third charge generation units 144(1), 144(2), and 144(3) between adjacent ones among the first to fourth emitting units 145(1), 145(2), 145(3), and 145(4).

An electron transport region of the fourth emitting unit 145(4) in the light-emitting device 30 of FIG. 3 may include an electron transport layer between an emission layer and the second electrode 150 and an electron injection layer between the electron transport layer and the second electrode 150. The electron injection layer may be adjacent to the second electrode 150. The electron injection layer of the fourth emitting unit 145(4) is the same as the electron injection layer according to the above-described embodiment, and the second electrode 150 is the same as the cathode according to the above-described embodiment.

In an embodiment, the first emitting unit 145(1) includes a first emission layer, the second emitting unit 145(2) includes a second emission layer, the third emitting unit 145(3) includes may include a third emission layer, and the fourth emitting unit 145(4) includes a fourth emission layer, wherein the first to third emission layers may each emit blue light, and the fourth emission layer may emit green light.

[Description of FIGS. 4 and 5]

FIG. 4 is a schematic cross-sectional view of an electronic apparatus according to an embodiment.

The electronic apparatus of FIG. 4 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be disposed on the substrate 100. The buffer layer 210 may prevent penetration of impurities through the substrate 100 and may provide a flat surface on the substrate 100.

A TFT may be disposed on the buffer layer 210. The TFT may include an active layer 220, a gate electrode 240, a source electrode 260, and a drain electrode 270.

The active layer 220 may include an inorganic semiconductor, such as silicon or polysilicon, an organic semiconductor, or an oxide semiconductor, and may include a source region, a drain region, and a channel region.

A gate insulating film 230 for insulating the active layer 220 from the gate electrode 240 may be disposed on the active layer 220, and the gate electrode 240 may be disposed on the gate insulating film 230.

An interlayer insulating film 250 may be disposed on the gate electrode 240. The interlayer insulating film 250 may be arranged between the gate electrode 240 and the source electrode 260 to insulate the gate electrode 240 from the source electrode 260 and between the gate electrode 240 and the drain electrode 270, to insulate the gate electrode 240 from the drain electrode 270.
The source electrode 260 and the drain electrode 270 may be disposed on the interlayer insulating film 250. The interlayer insulating film 250 and the gate insulating film 230 may be formed to expose the source region and the drain region of the active layer 220, and the source electrode 260 and the drain electrode 270 may respectively contact the exposed portions of the source region and the drain region of the active layer 220.
The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 130, and the second electrode 150.
The first electrode 110 may be disposed on the passivation layer 280. The passivation layer 280 may not completely cover the drain electrode 270 and may expose a region of the drain electrode 270, and the first electrode 110 may be connected (for example, electrically connected) to the exposed region of the drain electrode 270.
A pixel-defining film 290 including an insulating material may be disposed on the first electrode 110. The pixel-defining film 290 may expose a region of the first electrode 110, and the interlayer 130 may be formed on the exposed region of the first electrode 110. The pixel-defining film 290 may be a polyimide-based organic film or a polyacrylic organic film. Although not shown in FIG. 4, at least some layers of the interlayer 130 may extend beyond the upper portion of the pixel defining layer 290 and may thus be provided in the form of a common layer.
The second electrode 150 may be arranged on the interlayer 130, and a capping layer 170 may be further included on the second electrode 150. The capping layer 170 may be formed to cover the second electrode 150.
The encapsulation portion 300 may be located on the capping layer 170. The encapsulation portion 300 may be disposed on a light-emitting device to protect the light-emitting device from moisture and/or oxygen. The encapsulation portion 300 may include: an inorganic film including silicon nitride ($SiN_x$), silicon oxide ($SiO_x$), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, or the like), an epoxy-based resin (for example, aliphatic glycidyl ether (AGE), or the like), or any combination thereof; or a combination of the inorganic film and the organic film.
FIG. 5 is a cross-sectional view of an electronic apparatus according to another embodiment.
The electronic apparatus of FIG. 5 may differ from the electronic apparatus of FIG. 4, at least in that a light-shielding pattern 500 and a functional region 400 are further included on the encapsulation portion 300. The functional region 400 may be a color filter area, a color conversion area, or a combination of the color filter area and the color conversion area. In embodiments, the light-emitting device included in the electronic apparatus of FIG. 5 may be a tandem light-emitting device.

[Description of FIG. 6]

FIG. 6 is a schematic perspective view of an electronic equipment 1 including a light-emitting device according to an embodiment. The electronic equipment 1, which may be an apparatus that displays a moving image or a still image, may be not only portable electronic equipment, such as a mobile phone, a smartphone, a tablet personal computer (PC), a mobile communication terminal, an electronic notebook, an electronic book, a portable multimedia player (PMP), a navigation device, or an ultra-mobile PC (UMPC), but may also be various products, such as a television (TV), a laptop computer, a monitor, an advertisement board, or an Internet of things (IOT). The electronic equipment 1 may be such a product as described above or a part thereof.
In an embodiment, the electronic equipment 1 may be a wearable device, such as a smart watch, a watch phone, a glasses-type display, or a head mounted display (HMD), or a part of the wearable device. However, embodiments are not limited thereto.
For example, the electronic equipment 1 may be a dashboard of a vehicle, a center fascia of a vehicle, a center information display arranged on a dashboard of a vehicle, a room mirror display replacing a side-view mirror of a vehicle, an entertainment display for the rear seat of a vehicle, a display arranged on the back of the front seat, or a head up display (HUD) installed in the front of a vehicle or projected on a front window glass, or a computer generated hologram augmented reality head up display (CGH AR HUD). For convenience of explanation, FIG. 6 illustrates an embodiment in which the electronic equipment 1 is a smartphone.
The electronic equipment 1 may include a display area DA and a non-display area NDA outside the display area DA. A display apparatus may implement an image through a two-dimensional array of pixels that are arranged in the display area DA.
The non-display area NDA is an area that does not display an image, and may surround (for example, entirely

surround) the display area DA. A driver for providing electrical signals or power to display devices disposed in the display area DA may be arranged in the non-display area NDA. A pad, which is an area to which an electronic element or a printed circuit board may be electrically connected, may be arranged in the non-display area NDA.

In the electronic equipment 1, a length in an x-axis direction and a length in a y-axis direction may be different from each other. In an embodiment, as shown in FIG. 6, the length in the x-axis direction may be shorter than the length in the y-axis direction. In an embodiment, the length in the x-axis direction may be the same as the length in the y-axis direction. In an embodiment, the length in the x-axis direction may be longer than the length in the y-axis direction.

[Descriptions of FIGS. 7 and 8A to 8C]

FIG. 7 is a schematic view of an exterior of a vehicle 1000 as an electronic equipment including a light-emitting device according to an embodiment. FIGS. 8A, 8B, and 8C are each a schematic diagram of an interior of a vehicle 1000 according to an embodiment.

Referring to FIGS. 7, 8A, 8B, and 8C, the vehicle 1000 may refer to various apparatuses for moving a subject to be transported, such as a person, an object, or an animal, from a departure point to a destination point. Examples of the vehicle 1000 may include a vehicle traveling on a road or track, a vessel moving over a sea or river, an airplane flying in the sky using the action of air, and the like.

The vehicle 1000 may travel on a road or a track. The vehicle 1000 may move in a given direction according to the rotation of at least one wheel. Examples of the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis that is a portion excluding the body in which mechanical apparatuses necessary for driving are installed. The exterior of the body may include a front panel, a bonnet, a roof panel, a rear panel, a trunk, a pillar provided at a boundary between doors, and the like. The chassis of the vehicle 1000 may include a power generating device, a power transmitting device, a driving device, a steering device, a braking device, a suspension device, a transmission device, a fuel device, front, rear, left, and right wheels, and the like.

The vehicle 1000 may include a side window glass 1100, a front window glass 1200, a side-view mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on the side of the vehicle 1000. In an embodiment, the side window glass 1100 may be installed in a door of the vehicle 1000. Multiple side window glasses 1100 may be provided and may face each other. In an embodiment, the side window glass 1100 may include a first side window glass 1110 and a second side window glass 1120. In an embodiment, the first side window glass 1110 may be arranged adjacent to the cluster 1400, and the second side window glass 1120 may be arranged adjacent to the passenger seat dashboard 1600.

In an embodiment, the side window glasses 1100 may be spaced apart from each other in an x direction or in a -x direction. In an embodiment, the first side window glass 1110 and the second side window glass 1120 may be spaced apart from each other in the x direction or in the -x direction. For example, an imaginary straight line L connecting the side window glasses 1100 may extend in the x direction or in the -x direction. In an embodiment, an imaginary straight line L connecting the first side window glass 1110 and the second side window glass 1120 to each other may extend in the x direction or in the -x direction.

The front window glass 1200 may be installed on the front of the vehicle 1000. The front window glass 1200 may be arranged between the side window glasses 1100 facing each other.

The side-view mirror 1300 may provide a rear view of the vehicle 1000. The side-view mirror 1300 may be installed on the exterior of the vehicle body. In an embodiment, multiple side-view mirrors 1300 may be provided. Any one of the side-view mirrors 1300 may be arranged outside the first side window glass 1110. Another one of the side-view mirrors 1300 may be arranged outside the second side window glass 1120.

The cluster 1400 may be arranged in front of a steering wheel. The cluster 1400 may include a tachometer, a speedometer, a coolant thermometer, a fuel gauge, a turn signal indicator, a high beam indicator, a warning light, a seat belt warning light, an odometer, a driving record system, an automatic shift selector indicator light, a door open warning light, an engine oil warning light, and/or a low fuel warning light.

The center fascia 1500 may include a control panel on which buttons for adjusting an audio device, an air conditioning device, and a seat heater are disposed. The center fascia 1500 may be arranged on a side of the cluster 1400.

The passenger seat dashboard 1600 may be spaced apart from the cluster 1400 with the center fascia 1500 arranged therebetween. In an embodiment, the cluster 1400 may be arranged to correspond to a driver seat (not shown), and the passenger seat dashboard 1600 may be arranged to correspond to a passenger seat (not shown). In an embodiment, the cluster 1400 may be adjacent to the first side window glass 1110, and the passenger seat dashboard 1600 may be adjacent to the second side window glass 1120.

In an embodiment, the display apparatus 2 may include a display panel 3, and the display panel 3 may display an image. The display apparatus 2 may be arranged inside the vehicle 1000. In an embodiment, the display apparatus 2 may be arranged between the side window glasses 1100 facing each other. The display apparatus 2 may be arranged in at least one of the cluster 1400, the center fascia 1500, and the passenger seat dashboard 1600.

The display apparatus 2 may include an organic light-emitting display, an inorganic electroluminescent display, a quantum dot display, and the like. Hereinafter, an organic light-emitting display apparatus including the light-emitting device according to the disclosure will be described as an example of the display apparatus 2, but various types of display apparatuses as described herein may be used as embodiments.

Referring to FIG. 8A, the display apparatus 2 may be arranged in the center fascia 1500. In an embodiment, the display apparatus 2 may display navigation information. In an embodiment, the display apparatus 2 may display information regarding audio settings, video settings, or vehicle settings.

Referring to FIG. 8B, the display apparatus 2 may be arranged in the cluster 1400. The cluster 1400 may display driving information and the like through the display apparatus 2. For example, the cluster 1400 may digitally implement driving information. The cluster 1400 may digitally display vehicle information and driving information as images. For example, a needle and a gauge of a tachometer and various warning lights or icons may be displayed by a digital signal.

Referring to FIG. 8C, the display apparatus 2 may be arranged in the passenger seat dashboard 1600. The display apparatus 2 may be embedded in the passenger seat dashboard 1600 or arranged on the passenger seat dashboard 1600. In an embodiment, the display apparatus 2 arranged on the passenger seat dashboard 1600 may display an image related to information displayed on the cluster 1400 and/or information displayed on the center fascia 1500. In an embodiment, the display apparatus 2 arranged on the passenger seat dashboard 1600 may display information that is different from information displayed on the cluster 1400 and/or different from information displayed on the center fascia 1500.

[Manufacturing method]

The layers constituting the hole transport region, the emission layer, and the layers constituting the electron transport region may be formed in a selected region by using various methods such as vacuum deposition, spin coating, casting, Langmuir-Blodgett (LB) deposition, ink-jet printing, laser-printing, laser-induced thermal imaging, or the like.

When the layers constituting the hole transport region, the emission layer, and the layers constituting the electron transport region are formed by vacuum deposition, the deposition may be performed at a deposition temperature in a range of about 100 °C to about 500 °C, at a vacuum degree in a range of about $10^{-8}$ torr to about $10^{-3}$ torr, and at a deposition speed in a range of about 0.01 Å/sec to about 100 Å/sec, depending on a material to be included in a layer to be formed and the structure of a layer to be formed.

[Definitions of terms]

The term "$C_3$-$C_{60}$ carbocyclic group" as used herein may be a cyclic group consisting of carbon atoms as the only ring-forming atoms and having three to sixty carbon atoms, and the term "$C_1$-$C_{60}$ heterocyclic group" as used herein may be a cyclic group that has one to sixty carbon atoms and further includes, in addition to a carbon atom, at least one heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings are condensed with each other. For example, a $C_1$-$C_{60}$ heterocyclic group may have 3 to 61 ring-forming atoms.

The term "cyclic group" as used herein may be a $C_3$-$C_{60}$ carbocyclic group or a $C_1$-$C_{60}$ heterocyclic group.

The term "$\pi$ electron-rich $C_3$-$C_{60}$ cyclic group" as used herein may be a cyclic group that has 3 to 60 carbon atoms and may not include *-N=*' as a ring-forming moiety. The term "$\pi$ electron-deficient nitrogen-containing $C_1$-$C_{60}$ cyclic group" as used herein may be a heterocyclic group that has 1 to 60 carbon atoms and may include *-N=*' as a ring-forming moiety.

In embodiments,

a $C_3$-$C_{60}$ carbocyclic group may be a T1 group or a group in which two or more of T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

a $C_1$-$C_{60}$ heterocyclic group may be a T2 group, a group in which two or more of T2 group are condensed with

each other, or a group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

a $\pi$ electron-rich $C_3$-$C_{60}$ cyclic group may be a T1 group, a group in which two or more T1 groups are condensed with each other, a T3 group, a group in which two or more T3 groups are condensed with each other, or a group in which at least one T3 group and at least one T1 group are condensed with each other (for example, a $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),

a $\pi$ electron-deficient nitrogen-containing $C_1$-$C_{60}$ cyclic group may be a T4 group, a group in which at least two T4 groups are condensed with each other, a group in which at least one T4 group and at least one T1 group are condensed with each other, a group in which at least one T4 group and at least one T3 group are condensed with each other, or a group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like), wherein

the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo [2.2.1]heptane) group, a norbornene group, a bicyclo[1.1.1]pentane group, a bicyclo[2.1.1]hexane group, a bicyclo[2.2.2] octane group, or a benzene group,

the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

the T3 group may be a furan group, a thiophene group, a 1H-pyrrole group, a silole group, or a borole group, and

the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "$C_3$-$C_{60}$ carbocyclic group", "$C_1$-$C_{60}$ heterocyclic group", "$\pi$ electron-rich $C_3$-$C_{60}$ cyclic group", or "$\pi$ electron-deficient nitrogen-containing $C_1$-$C_{60}$ cyclic group" as used herein may each be a group condensed to any cyclic group, a monovalent group, or a polyvalent group (for example, a divalent group, a trivalent group, a tetravalent group, and the like) according to the structure of a formula for which the corresponding term is used. For example, a "benzene group" may be a benzo group, a phenyl group, a phenylene group, or the like, which may be readily understood by those of ordinary skill in the art according to the structure of a formula including the "benzene group."

Examples of a monovalent $C_3$-$C_{60}$ carbocyclic group or a monovalent $C_1$-$C_{60}$ heterocyclic group may include a $C_3$-$C_{40}$ cycloalkyl group, a $C_1$-$C_{10}$ heterocycloalkyl group, a $C_3$-$C_{40}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of a divalent $C_3$-$C_{60}$ carbocyclic group or a divalent $C_1$-$C_{60}$ heterocyclic group may include a $C_3$-$C_{10}$ cycloalkylene group, a $C_1$-$C_{10}$ heterocycloalkylene group, a $C_3$-$C_{10}$ cycloalkenylene group, a $C_4$-$C_{10}$ heterocycloalkenylene group, a $C_6$-$C_{60}$ arylene group, a $C_1$-$C_{60}$ heteroarylene group, a divalent non-aromatic condensed polycyclic group, and a divalent non-aromatic condensed heteropolycyclic group.

The term "$C_1$-$C_{60}$ alkyl group" as used herein may be a linear or branched aliphatic hydrocarbon monovalent group that has one to sixty carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group" as used herein may be a divalent group having a same structure as the $C_1$-$C_{60}$ alkyl group.

The term "$C_2$-$C_{60}$ alkenyl group" as used herein may be a monovalent hydrocarbon group having at least one carbon-carbon double bond in the middle or at a terminus of a $C_2$-$C_{60}$ alkyl group, and examples thereof may include an ethenyl group, a propenyl group, and a butenyl group. The term "$C_2$-$C_{60}$ alkenylene group" as used herein may be a divalent group having a same structure as the $C_2$-$C_{60}$ alkenyl group.

The term "$C_2$-$C_{60}$ alkynyl group" as used herein may be a monovalent hydrocarbon group having at least one carbon-carbon triple bond in the middle or at a terminus of a $C_2$-$C_{60}$ alkyl group, and examples thereof may include an ethynyl group and a propynyl group. The term "$C_2$-$C_{60}$ alkynylene group" as used herein may be a divalent group having a same structure as the $C_2$-$C_{60}$ alkynyl group.

The term "$C_1$-$C_{60}$ alkoxy group" as used herein may be a monovalent group represented by -O($A_{101}$) (wherein $A_{101}$ may be a $C_1$-$C_{60}$ alkyl group), and examples thereof may include a methoxy group, an ethoxy group, and an isopropyloxy group.

The term "$C_3$-$C_{10}$ cycloalkyl group" as used herein may be a monovalent saturated hydrocarbon cyclic group having three to ten carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "$C_3$-$C_{10}$ cycloalkylene group" as used herein may be a divalent group having a same structure as the $C_3$-$C_{10}$ cycloalkyl group.

The term "$C_1$-$C_{10}$ heterocycloalkyl group" as used herein may be a monovalent cyclic group that has one to ten carbon atoms and further includes, in addition to the carbon atoms, at least one heteroatom as a ring-forming atom, and examples thereof may include a 1,2,3,4-oxatriazolidinyl group, a tetrahydrofuranyl group, and a tetrahydrothiophenyl group. The term "$C_1$-$C_{10}$ heterocycloalkylene group" as used herein may be a divalent group having a same structure as the $C_1$-$C_{10}$ heterocycloalkyl group.

The term "$C_3$-$C_{10}$ cycloalkenyl group" as used herein may be a monovalent cyclic group that has three to ten carbon atoms and at least one carbon-carbon double bond in the ring thereof and no aromaticity, and examples thereof may include a cyclopentenyl group, a cyclohexenyl group, and a cycloheptenyl group. The term "$C_3$-$C_{10}$ cycloalkenylene group" as used herein may be a divalent group having a same structure as the $C_3$-$C_4$, cycloalkenyl group.

The term "$C_1$-$C_{10}$ heterocycloalkenyl group" as used herein may be a monovalent cyclic group that has one to ten carbon atoms, and further includes, in addition to the carbon atoms, at least one heteroatom as a ring-forming atom, and has at least one double bond in the ring thereof. Examples of a $C_1$-$C_{10}$ heterocycloalkenyl group may include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as used herein may be a divalent group having a same structure as the $C_1$-$C_{10}$ heterocycloalkenyl group.

The term "$C_6$-$C_{60}$ aryl group" as used herein may be a monovalent group having a carbocyclic aromatic system of six to sixty carbon atoms, and the term "$C_6$-$C_{60}$ arylene group" as used herein may be a divalent group having a carbocyclic aromatic system of six to sixty carbon atoms. Examples of a $C_6$-$C_{60}$ aryl group may include a phenyl group, a pentalenyl

group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each include two or more rings, the respective rings may be condensed with each other.

The term "$C_1$-$C_{60}$ heteroaryl group" as used herein may be a monovalent group having a heterocyclic aromatic system that has one to sixty carbon atoms and further includes, in addition to the carbon atoms, at least one heteroatom as a ring-forming atom. The term "$C_1$-$C_{60}$ heteroarylene group" as used herein may be a divalent group having a heterocyclic aromatic system that has one to sixty carbon atoms and further includes, in addition to the carbon atoms, at least one heteroatom as a ring-forming atom. Examples of a $C_1$-$C_{60}$ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the respective rings may be condensed with each other.

The term "monovalent non-aromatic condensed polycyclic group" as used herein may be a monovalent group having two or more rings condensed with each other, only carbon atoms (for example, eight to sixty carbon atoms) as ring-forming atoms, and no aromaticity in its molecular structure when considered as a whole. Examples of a monovalent non-aromatic condensed polycyclic group may include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group that has two or more rings condensed with each other, and further includes, in addition to carbon atoms (for example, one to sixty carbon atoms), at least one heteroatom as a ring-forming atom, and has no aromaticity in its molecular structure when considered as a whole. Examples of a monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein may be a divalent group having a same structure as the monovalent non-aromatic condensed heteropolycyclic group.

The term "$C_6$-$C_{60}$ aryloxy group" as used herein may be a group represented by $-O(A_{102})$ (wherein $A_{102}$ may be a $C_6$-$C_{60}$ aryl group), and the term "$C_6$-$C_{60}$ arylthio group" as used herein may be a group represented by $-S(A_{103})$ (wherein $A_{103}$ may be a $C_6$-$C_{60}$ aryl group).

The term "$C_7$-$C_{60}$ arylalkyl group" as used herein may be a group represented by $-(A_{104})(A_{105})$ (wherein $A_{104}$ may be a $C_1$-$C_{54}$ alkylene group, and $A_{105}$ may be a $C_6$-$C_{59}$ aryl group), and the term "$C_2$-$C_{60}$ heteroarylalkyl group" as used herein may be a group represented by $-(A_{106})(A_{107)}$ (wherein $A_{106}$ may be a $C_1$-$C_{59}$ alkylene group, and $A_{107}$ may be a $C_1$-$C_{59}$ heteroaryl group).

In the specification, the group $R_{10a}$ may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a

$C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{21}$)($Q_{22}$)($Q_{23}$), -N($Q_{21}$)($Q_{22}$), -B($Q_{21}$)($Q_{22}$), -C(=O)($Q_{21}$), - S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or
-P(=O)($Q_{31}$)($Q_{32}$).

In the specification, $Q_1$ to $Q_3$, $Q_{11}$ to $Q_{13}$, $Q_{21}$ to $Q_{23}$, and $Q_{31}$ to $Q_{33}$ as used herein may each independently be: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_7$-$C_{60}$ arylalkyl group, a $C_2$-$C_{60}$ heteroarylalkyl group, a $C_7$-$C_{60}$ arylalkyl group, or a $C_2$-$C_{60}$ heteroarylalkyl group, each unsubstituted or substituted with deuterium, - F, a cyano group, a $C_1$-$C_{60}$ alkyl group, a $C_1$-$C_{60}$ alkoxy group, a phenyl group, a biphenyl group, or any combination thereof.

The term "heteroatom" as used herein may be any atom other than a carbon atom or a hydrogen atom. Examples of a heteroatom may include O, S, N, P, Si, B, Ge, Se, or any combination thereof.

The term "third-row transition metal" as used herein may be hafnium (Hf), tantalum (Ta), tungsten (W), rhenium (Re), osmium (Os), iridium (Ir), platinum (Pt), or gold (Au).

In the specification, the term "Ph" refers to a phenyl group, the term "Me" refers to a methyl group, the term "Et" refers to an ethyl group, the terms "ter-Bu" and "$Bu^t$" each refers to a tert-butyl group, and the term "OMe" refers to a methoxy group.

The term "biphenyl group" as used herein may be a "phenyl group that is substituted with a phenyl group." For example, the "biphenyl group" may be a substituted phenyl group having a $C_6$-$C_{60}$ aryl group as a substituent.

The term "terphenyl group" as used herein may be a "phenyl group that is substituted with a biphenyl group". For example, the "terphenyl group" may be a substituted phenyl group having, as a substituent, a $C_6$-$C_{60}$ aryl group that is substituted with a $C_6$-$C_{60}$ aryl group.

The symbols * and *' as used herein, unless defined otherwise, each refer to a binding site to a neighboring atom in a corresponding formula or moiety.

In the specification, the terms "x-axis", "y-axis", and "z-axis" are not limited to three axes in an orthogonal coordinate system (e.g., a Cartesian coordinate system, and may be interpreted in a broader sense than the aforementioned three axes in an orthogonal coordinate system. For example, the x-axis, y-axis, and z-axis may describe axes that are orthogonal to each other or may describe axes that are in different directions that are not orthogonal to each other.

Hereinafter, a light-emitting device according to an embodiment will be described in detail with reference to the following Examples and Comparative Examples.

[Measurement of light absorption ratio]

[Examples 1 to 5]

Compound BCP doped with Yb and Li at the concentrations shown in Table 1 was deposited on a glass substrate to form a film having a thickness of 500 nm to prepare thin-films of Examples 1 to 5. The spectra of the light absorption ratio of the thin-films were obtained with respect to incident light in a wavelength range of 380 nm to 700 nm and are shown in FIG. 9. The light absorption ratio for a specific wavelength is calculated from the following equation.

[Equation 1]

$$\text{LIGHT ABSORPTION RATIO} = \left[1 - \frac{\mathit{INTENSITY\ OF\ TRANSMITTED\ LIGHT} + \mathit{INTENSITY\ OF\ REFLECTED\ LIGHT}}{\mathit{INTENSITY\ OF\ INCIDENT\ LIGHT}}\right] \times 100$$

Referring to FIG. 9, the light absorption ratio of a film including only Compound BCP is almost 0 at all wavelengths. A red light absorption ratio was derived by integrating a light absorption ratio spectrum of 560-700 nm, a green light absorption ratio was derived by integrating a light absorption ratio spectrum of 460-600 nm, and a blue light absorption ratio was derived by integrating a light absorption ratio spectrum of 440-500 nm, which are shown in Table 1.

[Table 1]

| | Example 1 | Example 2 | Example 3 | Example 4 | Example 5 |
|---|---|---|---|---|---|
| Doping concentration | No doping | Yb (3 %) | Yb (5 %) | Li (3 %) | Li (5 %) |
| Red light absorption ratio (%) | 0.00 | 0.28 | 0.61 | 0.32 | 0.51 |
| Green light absorption ratio (%) | 0.01 | 0.63 | 0.80 | 0.28 | 0.65 |
| Blue light absorption ratio (%) | 0.02 | 0.80 | 1.13 | 0.66 | 0.99 |

Referring to Table 1, the light absorption ratio of the Li solution appears to be less than that of the Yb solution of the same concentration, except for the red light absorption ratio of the 3% concentration solution.

[Examples 6 and 7]

An AgMg (Mg 5 %) film was formed on a glass substrate to a thickness of 100 Å; and as a protective film, Compound PBD (2-(4-biphenyl)-5-(4-tert-butylphenyl)-134-oxadiazole) was formed thereon to a thickness of 100 Å, to prepare a thin-film of Example 6. An Ag film was formed on a glass substrate to a thickness of 100 Å; and as a protective film, Compound PBD was formed thereon to a thickness of 100 Å, to prepare a thin-film of Example 7. The protective film is to prevent oxidation of a metal film.

The light absorption ratios of the thin-films of Examples 6 and 7 for red light, green light, and blue light were measured and are shown in Table 2.

[Table 2]

| | Wavelength of incident light | Example 6 | Example 7 | Difference |
|---|---|---|---|---|
| | | AgMg (Mg 5 %) | Ag | |
| Transmittance (%) | Blue 450 nm | 62.6 | 63.1 | 0.5 |
| | Green 540 nm | 76.5 | 78.0 | 1.5 |
| | Red 640 nm | 79.1 | 80.1 | 0.9 |
| Reflectance (%) | Blue 450 nm | 28.6 | 29.3 | 0.8 |
| | Green 540 nm | 13.2 | 13.8 | 0.5 |
| | Red 640 nm | 8.2 | 10.2 | 2.1 |
| Light absorption ratio (%) | Blue 450 nm | 8.8 | 7.6 | -1.2 |
| | Green 540 nm | 10.3 | 8.2 | -2.1 |
| | Red 640 nm | 12.7 | 9.7 | -3.0 |

Referring to Table 2, it could be found that with respect to blue light, green light, and red light, the thin-film of Example 7, including Ag, had increased transmittance and reduced light absorption ratio, compared to the thin-film of Example 6, including AgMg.

[Measurement of sheet resistance]

[Examples 8 to 11]

Yb or Li was deposited on a glass substrate to a thickness of 10 Å; AgMg (Mg 5 wt%) or Ag were deposited thereon to a thickness of 100 Å; and as a protective film, Compound PBD was deposited thereon to a thickness of 100 Å, to prepare thin-films of Examples 8 to 11 as shown in Table 3, which were subjected to heat treatment at 200 °C for 30 minutes. The sheet resistances of the thin-films of Example 8 to 11 before and after the heat treatment were measured and are shown in Table 3. In Table 3, the sheet resistance rate after heat treatment refers to a ratio of sheet resistance of the thin-films of Examples 9 to 11 after the heat treatment to the sheet resistance of the thin-film of Example 8 after the heat treatment.

[Table 3]

| | Thin-film | Sheet resistance before heat treatment (Ω/$cm^2$) | Sheet resistance after heat treatment (Ω/$cm^2$) | Sheet resistance rate after heat treatment |
|---|---|---|---|---|
| Example 8 | Yb/AgMg | 9.7 | 13.9 | 100 % |
| Example 9 | Yb/Ag | 10.4 | 16.5 | 119 % |
| Example 10 | Li/AgMg | 13.2 | 14 | 101 % |
| Example 11 | Li/Ag | 7.5 | 11.7 | 84 % |

Referring to Table 3, compared to the sheet resistance of the Yb/AgMg thin film of Test Example 8, the sheet resistance of the Yb/Ag thin-film of Example 9 after the treatment and the Li/AgMg thin-film of Example 10 after the heat treatment was increased, whereas the sheet resistance of the Li/Ag thin-film of Example 11 after the treatment was decreased to 84 %.

[Ag thickness test]

[Comparative Example 1]

As an anode, an ITO/Ag/ITO glass substrate with 15 Ω/$cm^2$ (800 Å) (a product of Corning Inc.) was cut to a size of 50 mm x 50 mm x 0.7 mm, sonicated with isopropyl alcohol and pure water each for 5 minutes, cleaned by irradiation of ultraviolet rays and exposure of ozone for 15 minutes. The glass substrate was loaded onto a vacuum deposition apparatus.

HATCN was deposited on the ITO/Ag/ITO glass substrate to form a hole injection layer having a thickness of 50 Å, NPB was deposited on the hole injection layer to form a hole transport layer having a thickness of 200 Å, and TCTA was deposited on the hole transport layer to form an electron blocking layer having a thickness of 75 Å. BH1:BH2:BD1 were co-deposited on the electron blocking layer at a volume ratio of 1:1:0.02 to form an emission layer having a thickness of 170 Å, and T2T was deposited on the emission layer to form a hole blocking layer having a thickness of 75 Å. TPM-TAZ and LiQ were co-deposited on the hole blocking layer at a volume ratio of 1:1 to form an electron transport layer having a thickness of 100 Å, thereby forming a first emitting unit.

BCP and Li were co-deposited on the first emitting unit at a volume ratio of 99:1 to form an n-type charge generation layer having a thickness of 40 Å, and HATCN was deposited on the n-type charge generation layer to form a p-type charge generation layer having a thickness of 40 Å, thereby forming a first charge generation unit.

NPB was deposited on the first charge generation unit to form a hole transport layer having a thickness of 700 Å, and TCTA was deposited on the hole transport layer to form an electron blocking layer having a thickness of 75 Å. BH1:BH2:BD1 (at a volume ratio of 1:1:0.02) were co-deposited on the electron blocking layer to form an emission layer having a thickness of 170 Å, and T2T was deposited on the emission layer to form a hole blocking layer having a thickness of 75 Å. TPM-TAZ and LiQ were co-deposited on the hole blocking layer at a volume ratio of 1:1 to form an electron transport layer having a thickness of 100 Å, thereby forming a second emitting unit.

BCP and Li were co-deposited on the second emitting unit at a volume ratio of 99:1 to form an n-type charge generation layer having a thickness of 40 Å, and HATCN was deposited on the n-type charge generation layer to form a p-type charge generation layer having a thickness of 80 Å, thereby forming a second charge generation unit.

NPB was deposited on the second charge generation unit to form a hole transport layer having a thickness of 700 Å, and TCTA was deposited on the hole transport layer to form an electron blocking layer having a thickness of 75 Å. BH1:BH2:BD1 (at a volume ratio of 1:1:0.02) were co-deposited on the electron blocking layer to form an emission layer having a thickness of 170 Å, and T2T was deposited on the emission layer to form a hole blocking layer having a thickness of 75 Å. TPM-TAZ and LiQ were co-deposited on the hole blocking layer at a volume ratio of 1:1 to form an electron transport layer having a thickness of 100 Å, thereby forming a third emitting unit.

BCP and Li were co-deposited on the third emitting unit at a volume ratio of 99:1 to form an n-type charge generation layer having a thickness of 40 Å, and HATCN was deposited on the n-type charge generation layer to form a p-type charge generation layer having a thickness of 80 Å, thereby forming a third charge generation unit.

NPB was deposited on the third charge generation unit to form a hole transport layer having a thickness of 700 Å, and TCTA was deposited on the hole transport layer to form an electron blocking layer having a thickness of 75 Å. GH1:GH2:GD1 (at a volume ratio of 1:1:0.1) were co-deposited on the electron blocking layer to form an emission layer having a thickness of 250 Å, and T2T was deposited on the emission layer to form a hole blocking layer having a thickness of 50 Å. TPM-TAZ and LiQ were co-deposited on the hole blocking layer at a volume ratio of 1:1 to form an electron transport layer having a thickness of 100 Å, thereby forming a fourth emitting unit.

Yb was deposited on the fourth emitting unit to form an electron injection layer having a thickness of 10 Å, and Ag and Mg were co-deposited thereon at a weight ratio of 9:1 to form a cathode having a thickness of 100 Å. Compound HT-28 was deposited on the cathode to form a capping layer having a thickness of 500 Å, thereby completing manufacture of a light-emitting device.

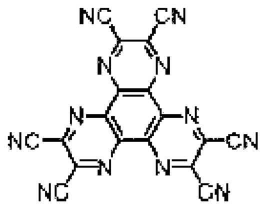

HAT-CN

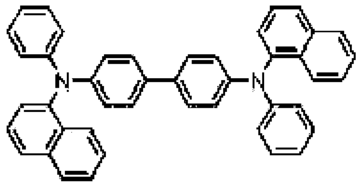

NPB

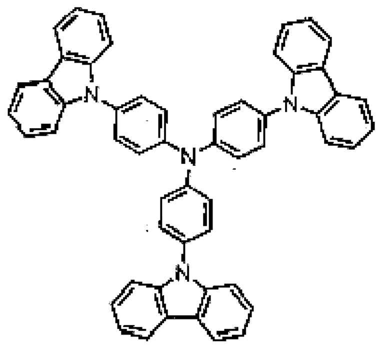

TCTA

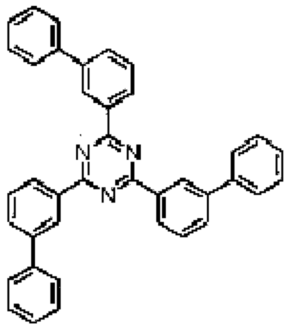

T2T

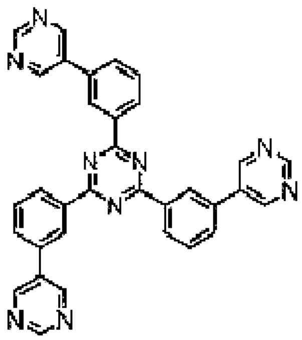

TPM-TAZ

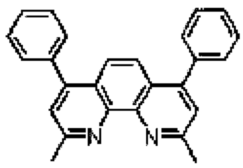

BCP

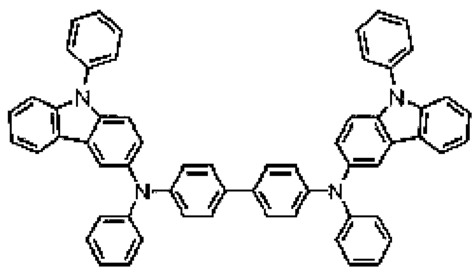

CAP

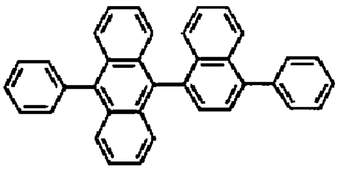

BH1

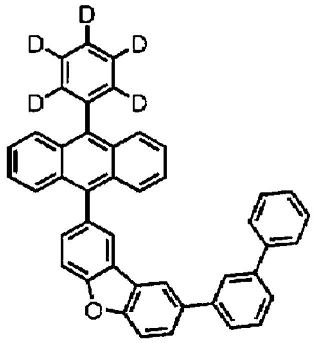

BH2

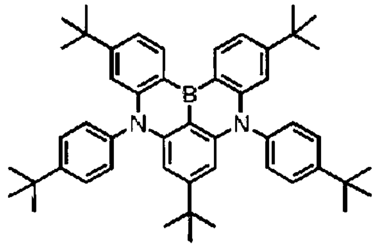

BD1

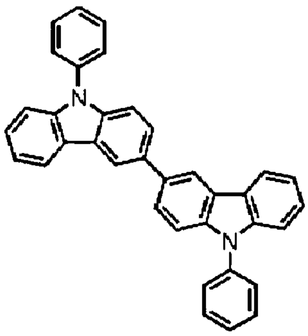

GH1

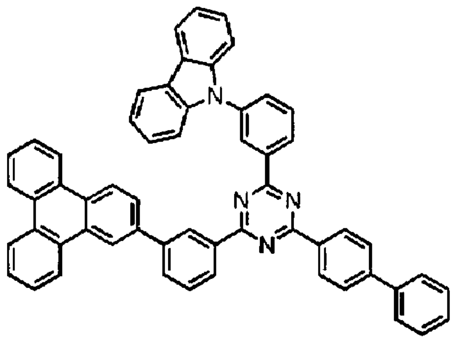

GH2

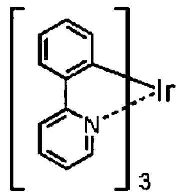

GD1

[Example 12]

A light-emitting device was manufactured in the same manner as in Comparative Example 1, except that Li was deposited to a thickness of 10 Å and Ag was deposited to a thickness of 80 Å to form a cathode.

[Example 13]

A light-emitting device was manufactured in the same manner as in Comparative Example 1, except that Li was deposited to a thickness of 10 Å and Ag was deposited to a thickness of 100 Å to form a cathode.

[Example 14]

A light-emitting device was manufactured in the same manner as in Comparative Example 1, except that Li was deposited to a thickness of 10 Å and Ag was deposited to a thickness of 120 Å to form a cathode.

[Li thickness test]

[Comparative Example 2]

A light-emitting device was manufactured in the same manner as in Comparative Example 1.

[Example 15]

A light-emitting device was manufactured in the same manner as in Comparative Example 2, except that Li was deposited to a thickness of 5 Å and Ag was deposited to a thickness of 100 Å to form a cathode.

[Example 16]

A light-emitting device was manufactured in the same manner as in Comparative Example 2, except that Li was deposited to a thickness of 10 Å and Ag was deposited to a thickness of 100 Å to form a cathode.

[Example 17]

A light-emitting device was manufactured in the same manner as in Comparative Example 2, except that Li was deposited to a thickness of 15 Å and Ag was deposited to a thickness of 100 Å to form a cathode.

[Measurement of light-emitting device characteristics]

The driving voltage (V), color coordinate (CIEy), current efficiency (cd/A), and lifespan of the light-emitting devices manufactured in Comparative Examples 1 and 2 and Examples 12 to 17 were measured by using Keithley SMU 236 and luminance meter PR650. The lifespan is obtained by measuring the time at which the luminance is reduced to 95 % of its initial luminance (measured as 100%) under conditions of a constant current density of 800 $cd/m^2$ at 40 °C.

Table 4 shows the driving voltage (V), color coordinate (CIEy), and current efficiency (cd/A) of the light-emitting devices in Comparative Example 1 and Examples 12 to 14. The relative current efficiency (%) in Table 4 is calculated as the current efficiency of each Example divided by the current efficiency of Comparative Example 1. FIG. 10 shows the luminance over time (lifespan) as relative values to Comparative Example 1.

Table 5 shows the driving voltage (V), color coordinate (CIEy), and current efficiency (cd/A) of the light-emitting devices in Comparative Example 2 and Examples 15 to 17. The relative current efficiency (%) in Table 5 is calculated as the current efficiency of each Examples 15 to 17 divided by the current efficiency of Comparative Example 2. FIG. 11 shows the luminance over time (lifespan) as relative values to Comparative Example 2.

[Table 4]

| | Driving voltage (V) | Color coordinate, CIEy | Current efficiency (cd/A) | Relative current efficiency (%) |
|---|---|---|---|---|
| Comparative Example 1 | 15.2 | 0.202 | 9.6 | 100 % |
| Example 12 | 16.8 | 0.211 | 10.0 | 104 % |
| Example 13 | 15.1 | 0.203 | 9.8 | 102 % |
| Example 14 | 15.1 | 0.194 | 9.7 | 101 % |

[Table 5]

| | Driving voltage (V) | Color coordinate, CIEy | Current efficiency (cd/A) | Relative current efficiency (%) |
|---|---|---|---|---|
| Comparative Example 2 | 15.5 | 0.205 | 9.37 | 100 % |
| Example 15 | 16.1 | 0.200 | 8.52 | 91 % |
| Example 16 | 15.4 | 0.199 | 9.55 | 102 % |
| Example 17 | 15.4 | 0.200 | 9.63 | 103 |

Referring to Table 4 and FIG. 10, Example 12, in which Ag in the cathode was formed to have a thickness of 80 Å, have the highest current efficiency, the highest driving voltage, and the shortest lifespan. Examples 13 and 14, in which Ag in the cathodes was formed to have a thickness of 100 Å and 120 Å respectively, have the current efficiency lower than Example 12 but higher than Comparative Example 1, driving voltage lower than both Comparative Example 1 and Example 12, and a lifespan longer than Comparative Example 1. For example, the light-emitting device of Example 13 in which Ag was formed to have a thickness of 100 Å had the best current efficiency and the best lifespan. Referring to Table 5 and FIG. 11, Example 15, in which Li in the cathode was formed to have a thickness of 5 Å, have the highest driving voltage, and the current efficiency and lifespan thereof were the lowest. Examples 13 and 14, in which Li in the cathodes was formed to have a thickness of 10 Å and 15 Å respectively, have the driving voltage lower than Comparative Example 2 and Example 15, and their current efficiency and lifespan were higher than Comparative Example 2 and Example 15. For example, the light-emitting device of Example 16, in which Li was formed to have a thickness of 15 Å, had the best current efficiency and the longest lifespan.

[Pixel shrinkage test]

FIGS. 12 and 13 are each a photo of pixels (1 cm x 1 cm), immediately after operation (0 HR) and after 200 hours (200 HR) of operation, of the light-emitting devices in Example 13 and Comparative Example 1, respectively. The initial luminance was 800 nits.

Referring to FIGS. 12 and 13, the sizes of the emission areas of the pixels of Example 13 and Comparative Example 1 were the same immediately after operation, but after 200 hours of operation, the size of the emission area of the pixel of Example 13 was greater than the size of the emission area of the pixel of Comparative Example 1. This is because a pixel shrinkage phenomenon, in which a device dies from the outside of a pixel due to outgas or external air of the device, appeared to be greater in the light-emitting device of Comparative Example 1 including the Yb/AgMg cathode. Because outgas or external air is better absorbed by Li compared to Yb, the pixel shrinkage phenomenon is relatively reduced in the light-emitting device of Example 13 including the Li/Ag cathode.

## Claims

**1.** A light-emitting device comprising:

an anode;
a cathode facing the anode; and
an interlayer between the anode and the cathode, wherein
the interlayer comprises:

an emission layer; and
an electron transport region between the emission layer and the cathode,

the electron transport region comprises an electron injection layer adjacent to the cathode,
the electron injection layer comprises an alkali metal, and
the cathode comprises silver (Ag).

**2.** The light-emitting device of claim 1, wherein

a light absorption ratio of the electron injection layer for blue light is in a range of about 8 % to about 10 %,
a light absorption ratio of the electron injection layer for green light is in a range of about 10 % to about 12 %, and
a light absorption ratio of the electron injection layer for red light is in a range of about 12 % to about 14 %.

**3.** The light-emitting device of claim 1, wherein

a light absorption ratio of the cathode for blue light is in a range of about 7 % to about 8 %,
a light absorption ratio of the cathode for green light is in a range of about 8 % to about 9 %, and
a light absorption ratio of the cathode for red light is in a range of about 9 % to about 11 %.

**4.** The light-emitting device of claim 1, wherein the alkali metal is lithium (Li).

**5.** The light-emitting device of claim 1, wherein a thickness of the electron injection layer is in a range of about 5 Å to about 20 Å.

**6.** The light-emitting device of claim 1, wherein a thickness of the cathode is in a range of about 80 Å to about 150 Å.

**7.** The light-emitting device of claim 1, wherein a sheet resistance of a structure of the electron injection layer and the cathode is in a range of about 10 $\Omega/cm^2$ to about 13 $\Omega/cm^2$.

**8.** The light-emitting device of claim 1, wherein the emission layer comprises a host and a dopant.

**9.** The light-emitting device of claim 8, wherein the dopant is a phosphorescent dopant or a delayed fluorescence dopant.

**10.** The light-emitting device of claim 1, wherein the emission layer comprises quantum dots.

**11.** The light-emitting device of claim 1, wherein the interlayer further comprises a hole transport region between the anode and the emission layer.

**12.** The light-emitting device of claim 11, wherein the hole transport region comprises at least one of a hole injection layer, a hole transport layer, a buffer layer, an auxiliary layer, and an electron blocking layer.

**13.** The light-emitting device of claim 1, wherein the electron transport region further comprises at least one of a hole blocking layer and an electron transport layer.

**14.** The light-emitting device of claim 1, further comprising:
a capping layer disposed outside the anode or outside the cathode.

**15.** The light-emitting device of claim 1, wherein the interlayer further comprises:

a plurality of emitting units, and
one or more charge generation units, each between adjacent ones among the plurality of emitting units.

**16.** The light-emitting device of claim 15, wherein at least one of the emitting units emits light having a maximum emission wavelength in a range of about 410 nm to about 490 nm.

**17.** The light-emitting device of claim 15, wherein at least one of the emitting units emits light having a maximum emission wavelength in a range of about 490 nm to about 580 nm.

**18.** An electronic apparatus comprising the light-emitting device of claim 1.

**19.** The electronic apparatus of claim 18, further comprising:

a thin-film transistor, wherein
the thin-film transistor comprises a source electrode and a drain electrode, and
the anode of the light-emitting device is electrically connected to at least one of the source electrode and the drain electrode.

**20.** An electronic equipment comprising the light-emitting device of claim 1, wherein the electronic equipment is a flat panel display, a curved display, a computer monitor, a medical monitor, a television (TV), an advertisement board, an indoor light, an outdoor light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall including multiple displays tiled together, a theater screen, a stadium screen, a phototherapy device, or a sign.

FIG. 1

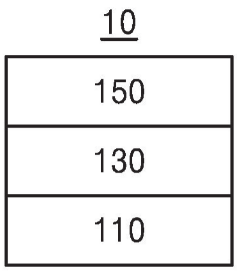

FIG. 2

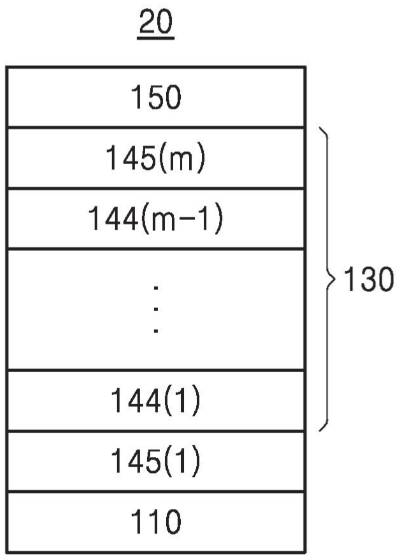
20
150
145(m)
144(m-1)
144(1)
145(1)
110
130

FIG. 3

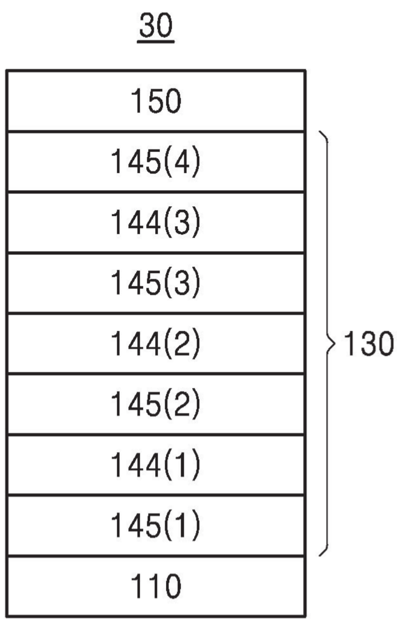
30
150
145(4)
144(3)
145(3)
144(2)
145(2)
144(1)
145(1)
110
130

FIG. 4

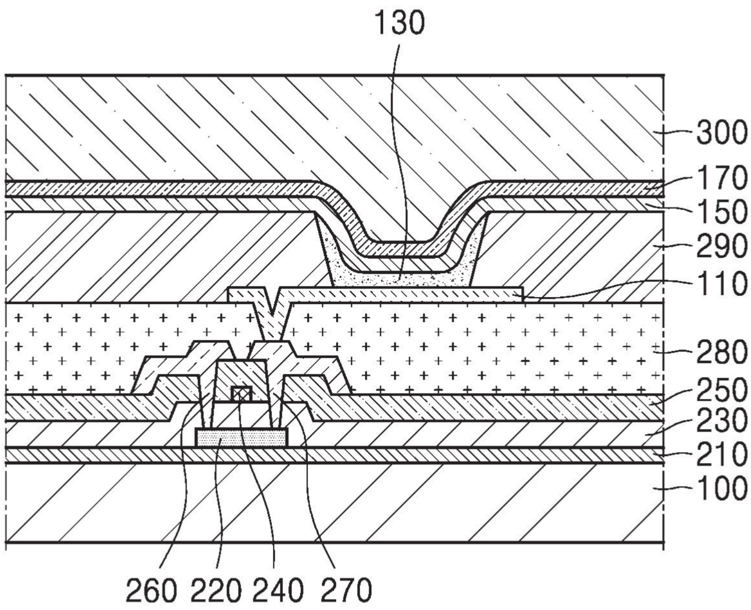
130
300
170
150
290
110
280
250
230
210
100
260 220 240 270

FIG. 5

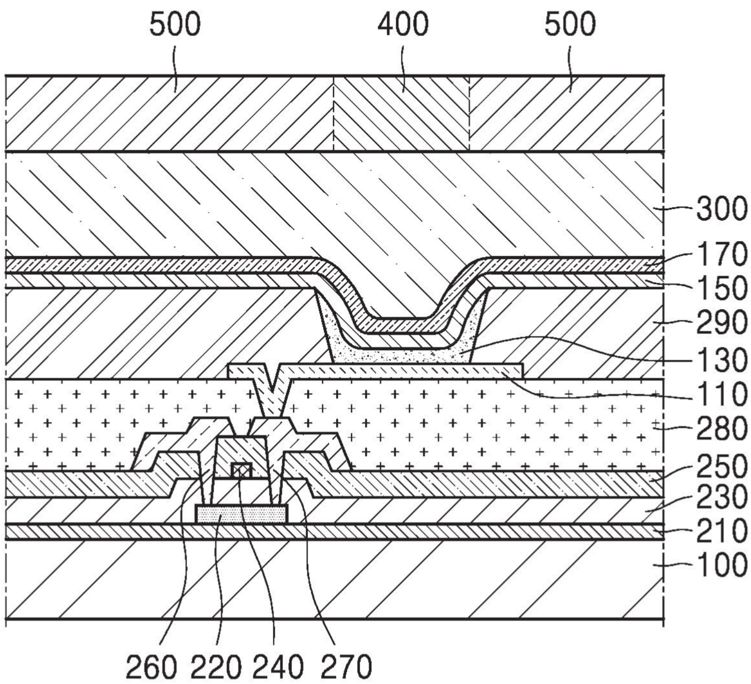
500
400
500
300
170
150
290
130
110
280
250
230
210
100
260 220 240 270

FIG. 6

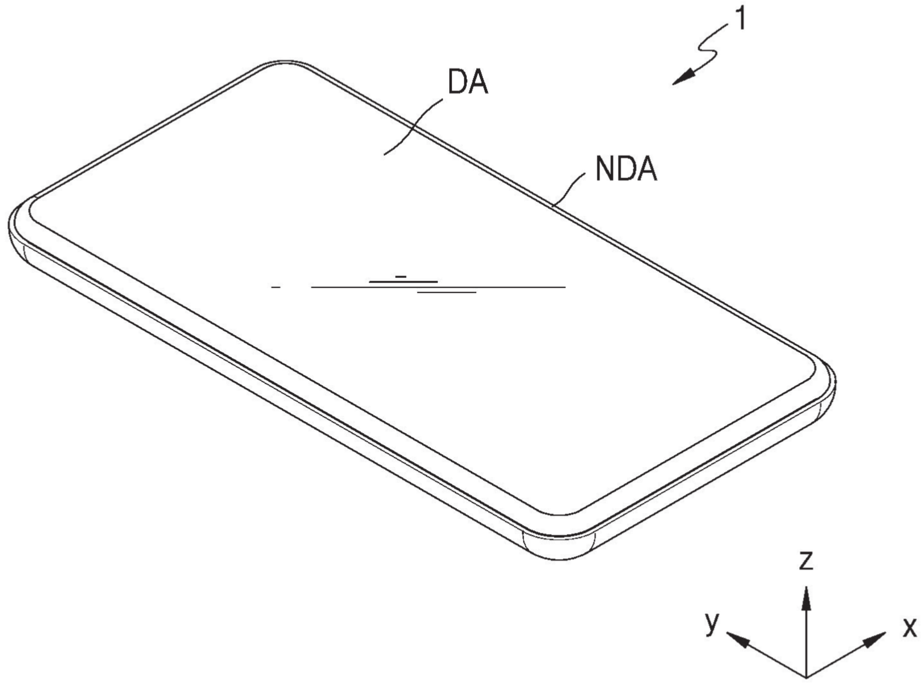


FIG. 7

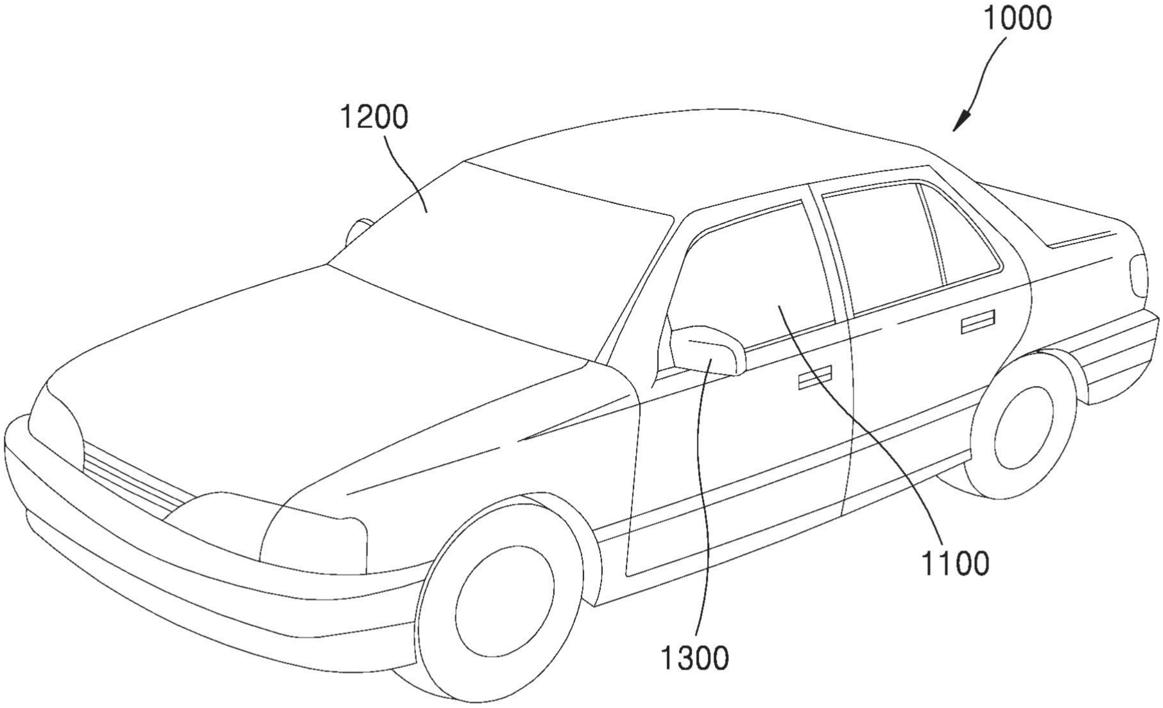

FIG. 8A

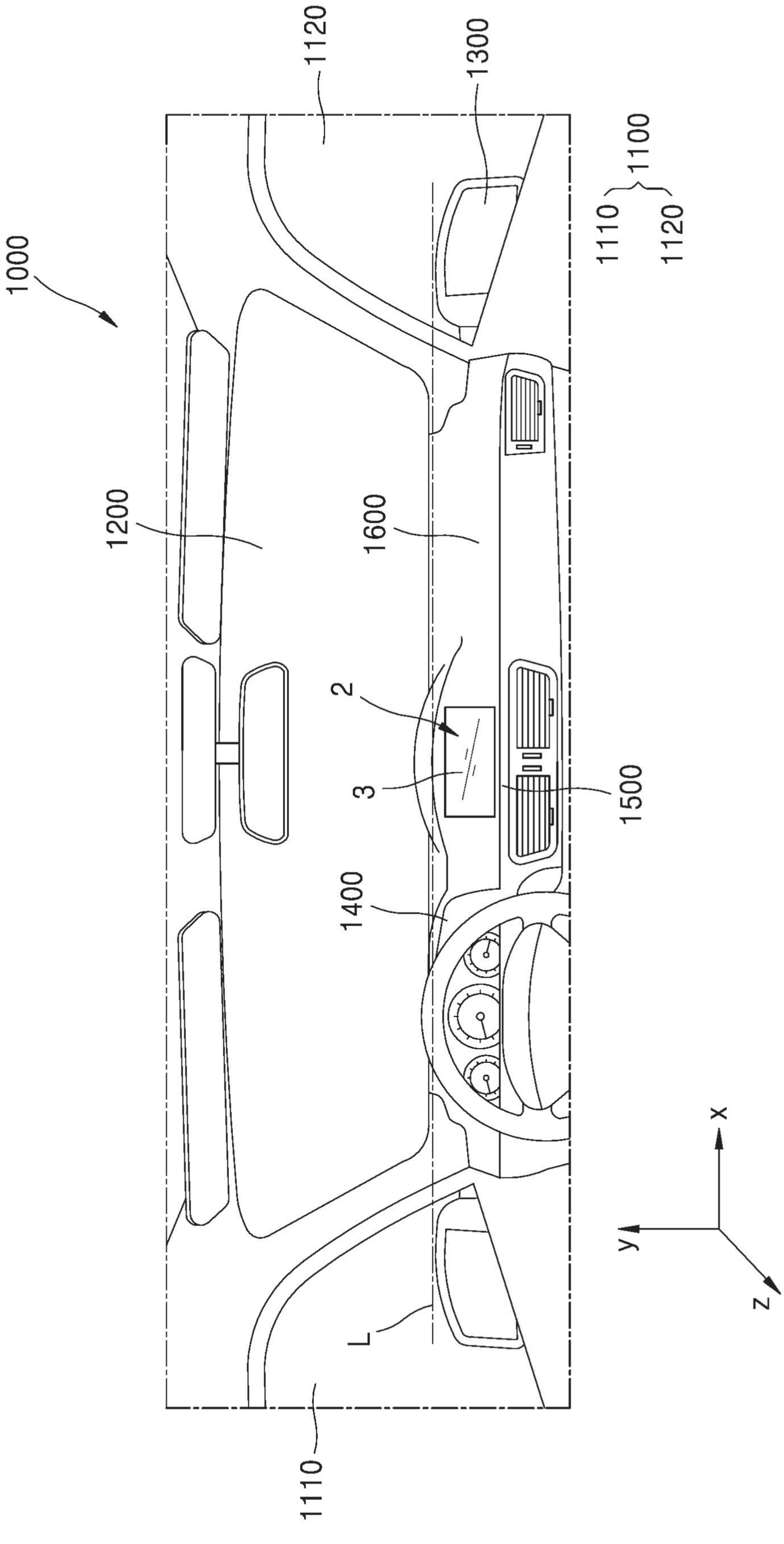
1000
1120
1300
1110
1100
1120
1200
1600
2
3
1500
1400
x
y
z
L
1110

FIG. 8B

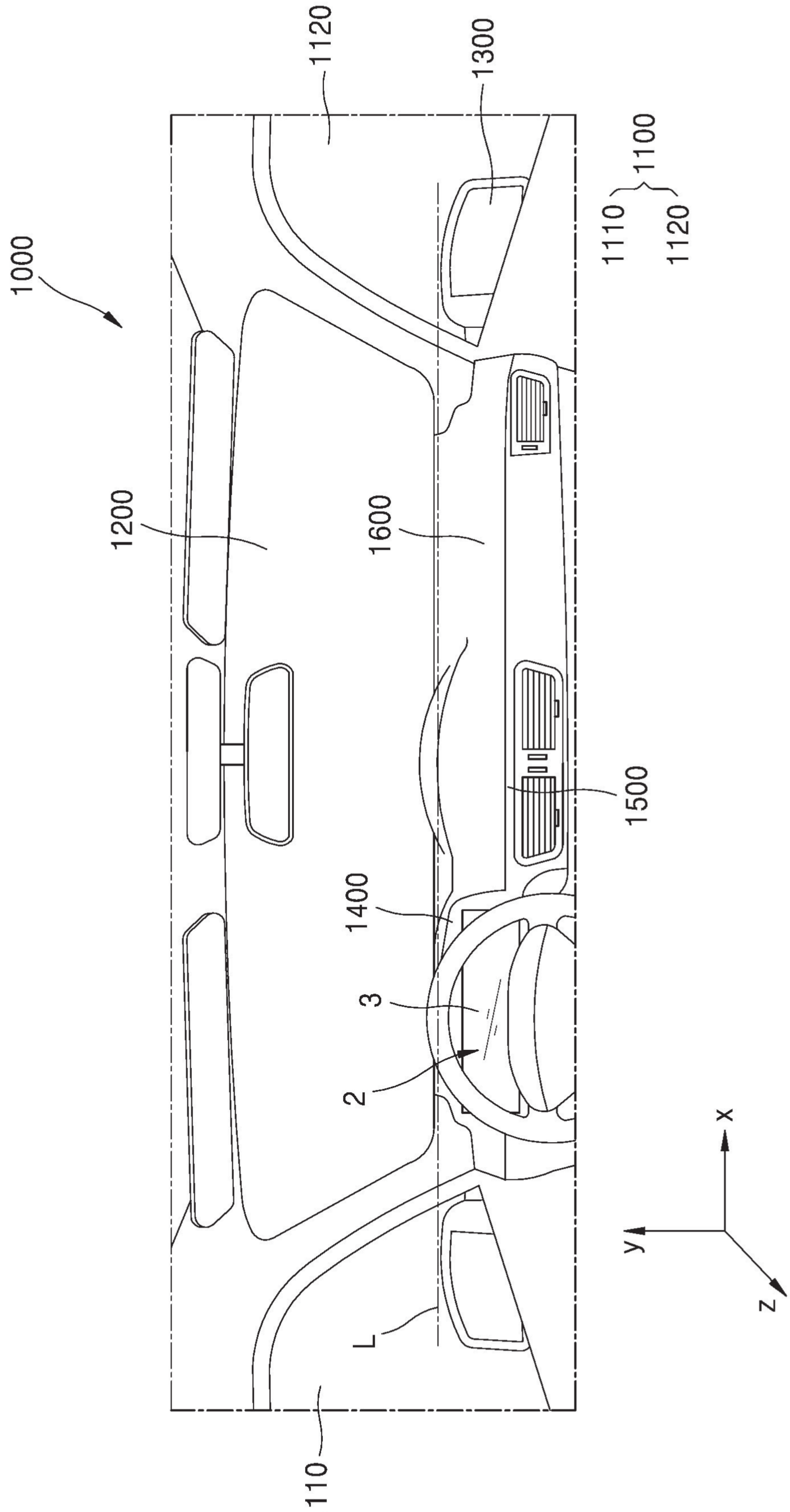
1000
1120
1300
1110
1100
1120
1200
1600
1500
1400
3
2
L
1110
x
y
z

FIG. 8C

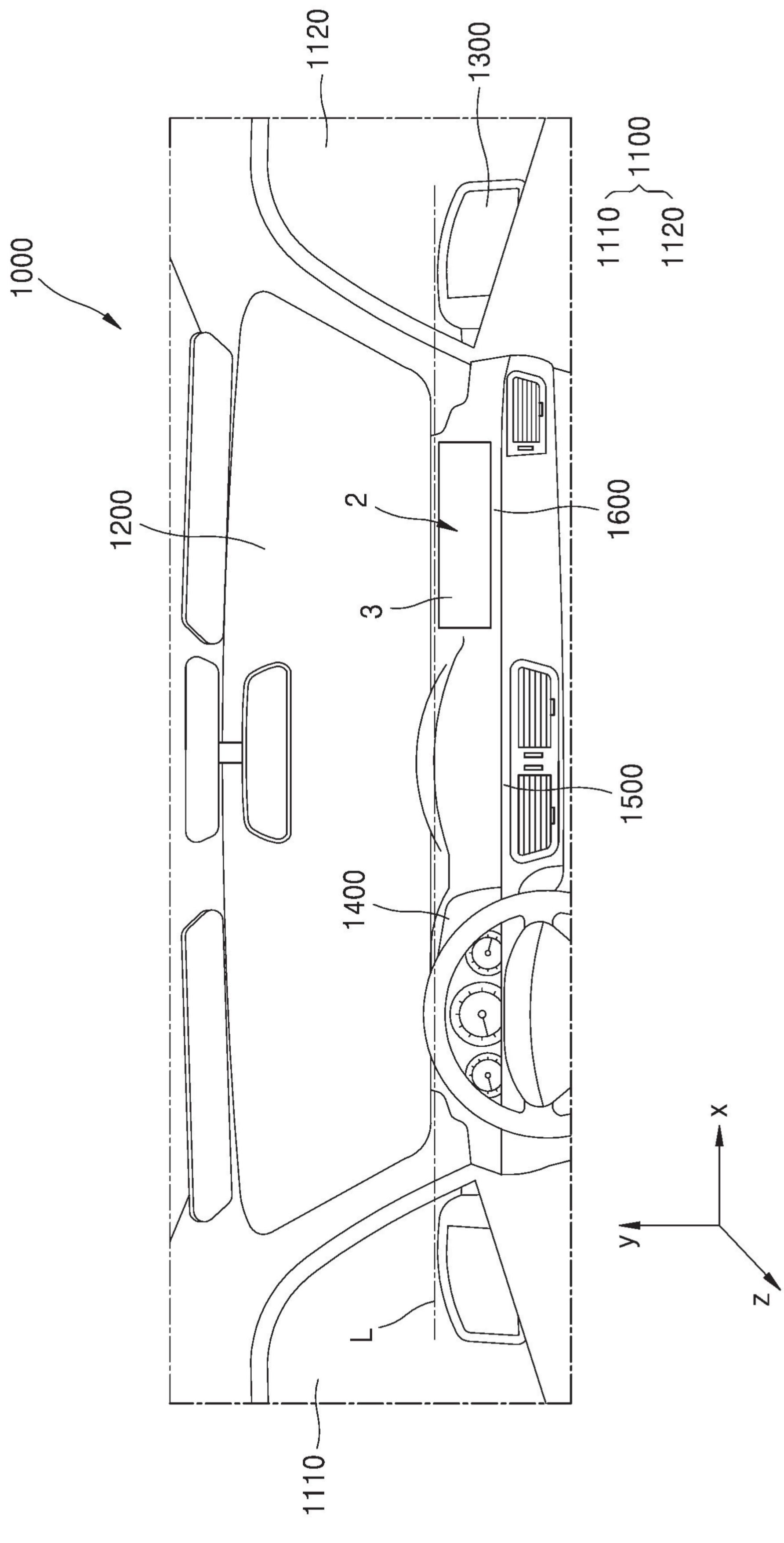
1000
1120
1300
1110
1120
1100
1200
2
3
1600
1500
1400
L
1110
x
y
z

FIG. 9

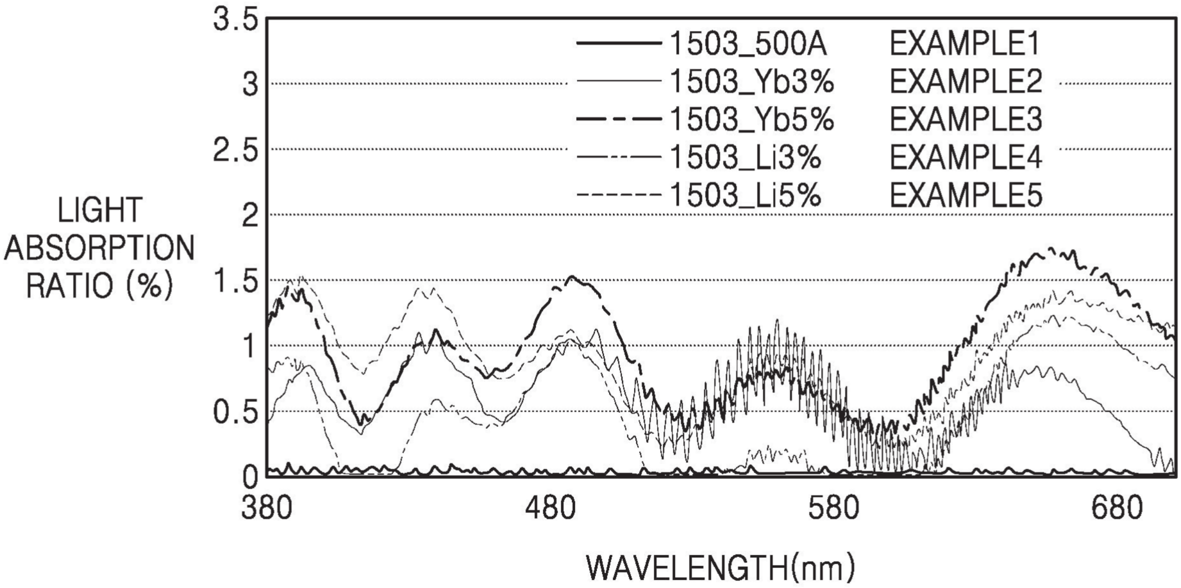
3.5
3
2.5
2
1.5
1
0.5
0
LIGHT ABSORPTION RATIO (%)
1503_500A EXAMPLE1
1503_Yb3% EXAMPLE2
1503_Yb5% EXAMPLE3
1503_Li3% EXAMPLE4
1503_Li5% EXAMPLE5
380
480
580
680
WAVELENGTH(nm)

FIG. 10

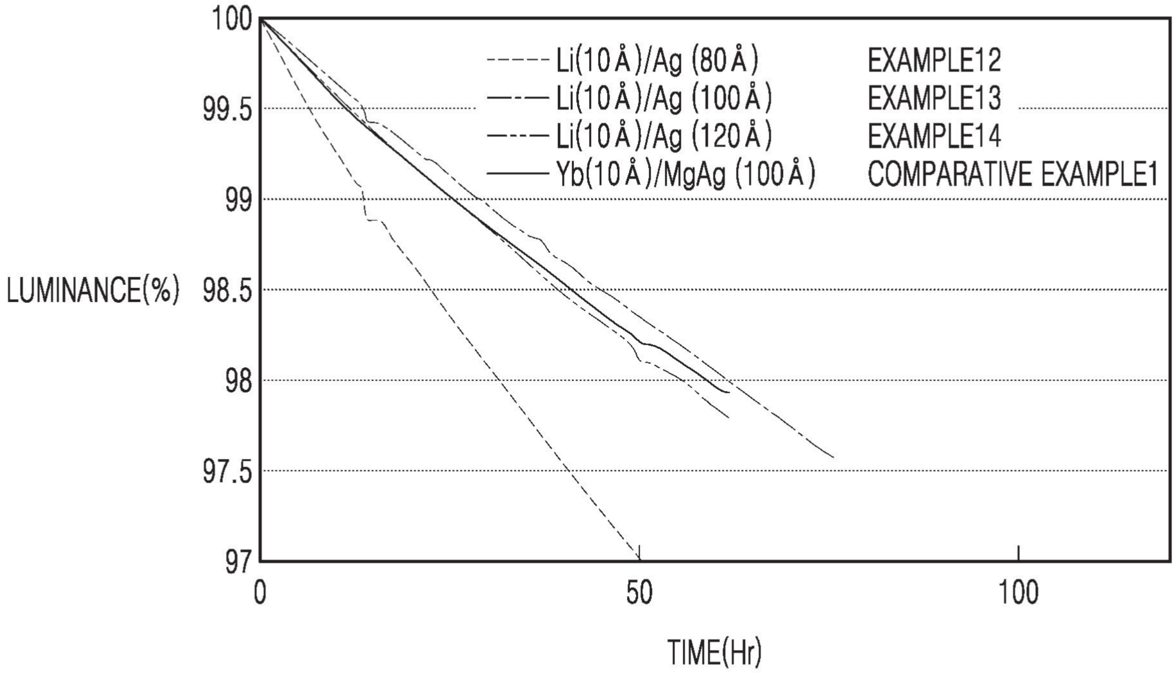
Li(10Å)/Ag (80Å) EXAMPLE12
Li(10Å)/Ag (100Å) EXAMPLE13
Li(10Å)/Ag (120Å) EXAMPLE14
Yb(10Å)/MgAg (100Å) COMPARATIVE EXAMPLE1
LUMINANCE(%)
100
99.5
99
98.5
98
97.5
97
0
50
100
TIME(Hr)

FIG. 11

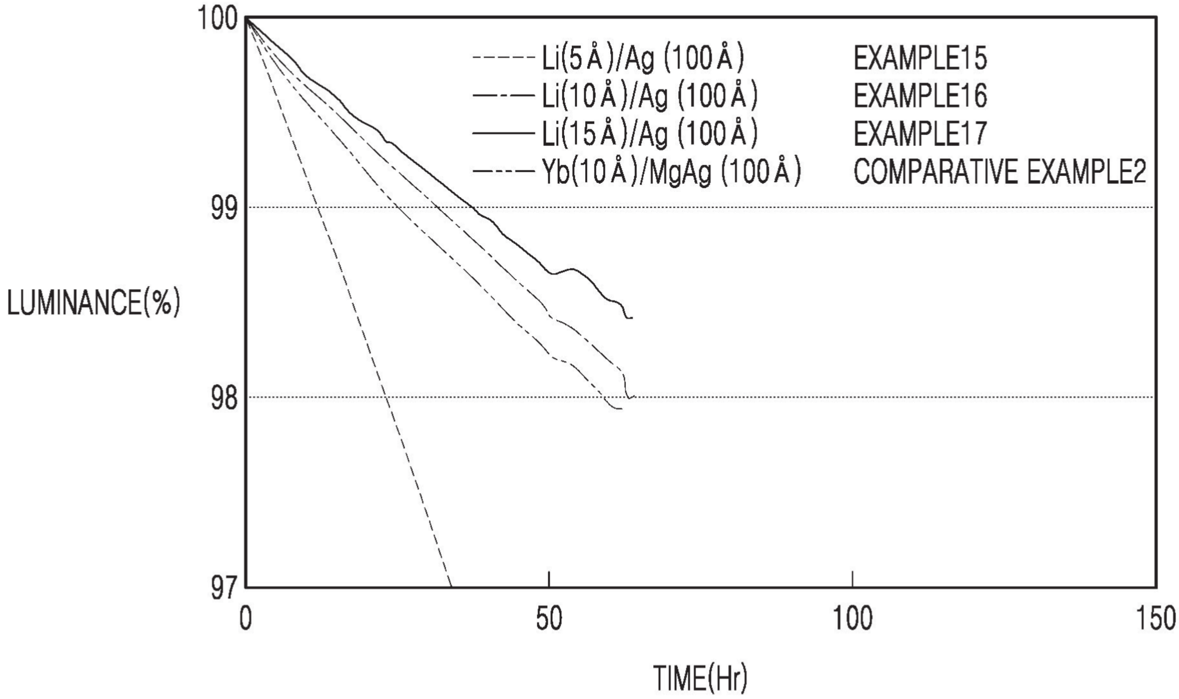
Li(5Å)/Ag (100Å) EXAMPLE15
Li(10Å)/Ag (100Å) EXAMPLE16
Li(15Å)/Ag (100Å) EXAMPLE17
Yb(10Å)/MgAg (100Å) COMPARATIVE EXAMPLE2
LUMINANCE(%)
100
99
98
97
0
50
100
150
TIME(Hr)

FIG. 12

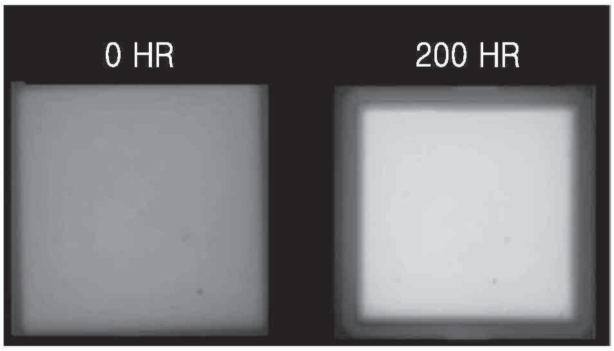


FIG. 13

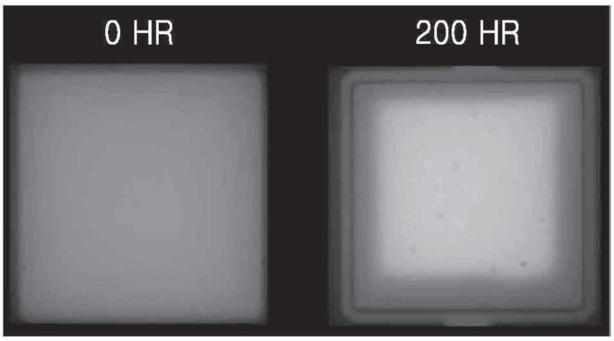

## INTERNATIONAL SEARCH REPORT

International application No. **PCT/KR2024/003384**

**A. CLASSIFICATION OF SUBJECT MATTER**

**H10K 50/17**(2023.01)i; **H10K 50/18**(2023.01)i; **H10K 50/81**(2023.01)i; **H10K 50/82**(2023.01)i; **H10K 50/16**(2023.01)i; **H10K 50/12**(2023.01)i; **H10K 50/115**(2023.01)i; **H10K 50/15**(2023.01)i; **H10K 50/844**(2023.01)i; **H10K 50/13**(2023.01)i

According to International Patent Classification (IPC) or to both national classification and IPC

**B. FIELDS SEARCHED**

Minimum documentation searched (classification system followed by classification symbols)

H10K 50/17(2023.01); C07F 5/02(2006.01); H01L 51/00(2006.01); H01L 51/50(2006.01); H01L 51/52(2006.01); H01L 51/54(2006.01); H05B 33/04(2006.01); H05B 33/14(2006.01); H05B 33/26(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 발광소자 (luminous element), 전자수송영역 (electron transport region), 전자주입층 (electron injection layer), 캐소드 (cathode), 은 (silver, Ag), 알칼리 금속 (alkali metal)

**C. DOCUMENTS CONSIDERED TO BE RELEVANT**

| Category* | Citation of document, with indication, where appropriate, of the relevant passages | Relevant to claim No. |
|---|---|---|
| X | KR 10-2021-0124572 A (SAMSUNG DISPLAY CO., LTD.) 15 October 2021 (2021-10-15)<br>See abstract; paragraphs [0216]-[0217], [0219], [0222], [0230]-[0232], [0235], [0321], [0340]-[0341], [0343], [0488]-[0489], [0558]-[0559], [0567]-[0568] and [0571]; claims 1-2; and figure 1. | 1-20 |
| A | KR 10-2010-0065174 A (ULVAC, INC.) 15 June 2010 (2010-06-15)<br>See entire document. | 1-20 |
| A | KR 10-2008-0098411 A (CDT OXFORD LIMITED) 07 November 2008 (2008-11-07)<br>See entire document. | 1-20 |
| A | KR 10-2015-0077178 A (LG DISPLAY CO., LTD.) 07 July 2015 (2015-07-07)<br>See entire document. | 1-20 |
| A | JP 2000-113976 A (TDK CORP.) 21 April 2000 (2000-04-21)<br>See entire document. | 1-20 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 June 2024** | **24 June 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/003384**

| Patent document cited in search report | Publication date (day/month/year) | Patent family member(s) | Publication date (day/month/year) |
|---|---|---|---|
| KR 10-2021-0124572 A | 15 October 2021 | CN 113493474 A | 12 October 2021 |
| | | US 2021-0320254 A1 | 14 October 2021 |
| KR 10-2010-0065174 A | 15 June 2010 | CN 101816081 A | 25 August 2010 |
| | | EP 2197059 A1 | 16 June 2010 |
| | | EP 2197059 A4 | 08 August 2012 |
| | | TW 200948189 A | 16 November 2009 |
| | | US 2010-0176391 A1 | 15 July 2010 |
| | | US 8147287 B2 | 03 April 2012 |
| | | WO 2009-044675 A1 | 09 April 2009 |
| KR 10-2008-0098411 A | 07 November 2008 | CN 101405892 A | 08 April 2009 |
| | | EP 1979958 A1 | 15 October 2008 |
| | | EP 2400577 A1 | 28 December 2011 |
| | | GB 2434915 A | 08 August 2007 |
| | | JP 2009-525605 A | 09 July 2009 |
| | | US 2009-0045740 A1 | 19 February 2009 |
| | | WO 2007-088377 A1 | 09 August 2007 |
| KR 10-2015-0077178 A | 07 July 2015 | KR 10-2127238 B1 | 26 June 2020 |
| JP 2000-113976 A | 21 April 2000 | None | |

Form PCT/ISA/210 (patent family annex) (July 2022)